(19) Europäisches Patentamt / European Patent Office / Office européen des brevets

(11) **EP 2 541 916 B1**

(12) **EUROPEAN PATENT SPECIFICATION**

(45) Date of publication and mention
of the grant of the patent:
**14.06.2017 Bulletin 2017/24**

(21) Application number: **11747649.9**

(22) Date of filing: **23.02.2011**

(51) Int Cl.:
*H04N 7/015* ^(2006.01)   *H04L 27/26* ^(2006.01)
*H04B 7/04* ^(2017.01)   *H03M 13/00* ^(2006.01)
*H03M 13/09* ^(2006.01)   *H03M 13/15* ^(2006.01)
*H03M 13/25* ^(2006.01)   *H03M 13/27* ^(2006.01)
*H03M 13/29* ^(2006.01)   *H03M 13/31* ^(2006.01)
*H03M 13/35* ^(2006.01)   *H04H 20/28* ^(2008.01)
*H04H 20/42* ^(2008.01)   *H04L 25/03* ^(2006.01)
*H03M 13/11* ^(2006.01)

(86) International application number:
**PCT/KR2011/001197**

(87) International publication number:
**WO 2011/105759 (01.09.2011 Gazette 2011/35)**

(54) **BROADCASTING SIGNAL TRANSMITTER/RECEIVER AND BROADCASTING SIGNAL TRANSMISSION/RECEPTION METHOD**

RUNDFUNKSIGNAL-SENDER UND -EMPFÄNGER SOWIE RUNDFUNKSIGNAL-SENDE- UND EMPFANGSVERFAHREN

ÉMETTEUR-RÉCEPTEUR DE SIGNAL DE RADIODIFFUSION ET PROCÉDÉ D'ÉMISSION-RÉCEPTION DE SIGNAL DE RADIODIFFUSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.02.2010 US 307329 P**

(43) Date of publication of application:
**02.01.2013 Bulletin 2013/01**

(73) Proprietor: **LG Electronics Inc.**
**Seoul 150-721 (KR)**

(72) Inventors:
• **KO, Woo Suk**
  **Seoul 137-724 (KR)**
• **MOON, Sang Chul**
  **Seoul 137-724 (KR)**
• **HONG, Ho Taek**
  **Seoul 137-724 (KR)**

(74) Representative: **Cabinet Plasseraud**
**66 rue de la Chaussée d'Antin**
**75440 Paris Cedex 09 (FR)**

(56) References cited:
**EP-A2- 1 821 481       WO-A2-2009/093809**
**US-A1- 2007 071 121**

**Description**

[Technical Field]

The present invention relates to a method for transceiving broadcast signals and an apparatus for transceiving broadcast signals, and more particularly, to a method for transceiving broadcast signals, which can enhance data transmission efficiency and is compatible with conventional methods for transceiving broadcast signals, and a transceiving apparatus thereof.

[Background Art]

As analog broadcasting will soon end, a variety of technologies for transmitting and receiving digital broadcast signals has been developed. Digital broadcast signals can transmit a greater capacity of video/audio data than analog broadcast signals, and can include a variety of optional data in addition to video/audio data.

A digital broadcast system can provide High Definition (HD) images, multi-channel sound, and a variety of optional services. However, data transmission efficiency for high capacity data transmission, robustness of transmitting and receiving networks, and flexibility of networks in consideration of mobile receiving equipment are problems that should still be improved. WO2009/093809 discloses a digital broadcast system employing both MIMO and MISO encoding for transmission of data.

[Disclosure]

[Technical Problem]

A technical object of one embodiment of the present invention is to provide a method and apparatus for receiving broadcast signals, which can enhance data transmission efficiency in a digital broadcast system.

A further technical object of the present invention is to provide a method and apparatus for receiving broadcast signals, which can maintain compatibility with a conventional broadcast system in addition to achieving the above described objects.

[Technical Solution]

In order to solve the problems above, a broadcast signal receiver ("BSR") according to claim 5 is provided in a first aspect. In a second aspect, there is provided a method of receiving according to claim 1.

[Advantageous Effects]

According to the present invention, in a digital broadcast system, it is possible to enhance data transmission efficiency and increase robustness in terms of transmission and reception of broadcast signals, by virtue of provision of a MIMO system.

Further, according to the present invention, in a digital broadcast system, it is possible to decode MIMO receiving signals efficiently using MIMO processing of the present invention even under a diverse broadcast environment.

In addition, according to the present invention, a broadcast system using MIMO of the present invention can achieve the above described advantages while maintaining compatibility with a conventional broadcast system not using MIMO.

Further, according to the present invention, it is possible to provide a method and apparatus for receiving broadcast signals, which can receive digital broadcast signals without error even under an indoor environment or using mobile reception equipment.

[Description of Drawings]

Fig. 1 shows a broadcast signal transmitter using MIMO according to an embodiment of the present invention;
Fig. 2 shows a broadcast signal receiver according to an embodiment of the present invention;
Fig. 3 shows an additional frame structure based on PLP according to an embodiment of the present invention;
Fig. 4 shows an additional frame structure based on FEF according to an embodiment of the present invention;
Fig. 5A and B show a process of generating a P1 symbol in order to perceive an additional frame according to an embodiment of the present invention;

Fig. 6 shows L1-free signaling information according to an embodiment of the present invention;

Fig. 7 shows L1-post signaling information according to an embodiment of the present invention.

Fig. 8 shows L1-post signaling information according to another embodiment of the present invention.

Fig. 9 shows a conceptual diagram of a broadcast signal transmitting method according to an embodiment of the present invention.

Fig. 10 shows a conceptual diagram of a broadcast signal transmitting method according to another embodiment of the present invention.

Fig. 11 shows a broadcast signal transmitted by a national broadcast system with a MIMO system applied using SVC.

Fig. 12 shows a MIMO transmitting/receiving system according to an embodiment of the present system.

Fig. 13 shows a data transmitting/receiving method using MIMO by SM in channel conditions according to an embodiment of the present system.

Fig. 14 shows a transmitting/receiving signal and MIMO-encoded signal according to an embodiment of the present system.

Fig. 15 shows a constellation map using a GC of a sub-set as MIMO encoding matrix according to a first embodiment of the present system.

Fig. 16 shows a relationship between an Euclidean distance and a Hamming distance in the constellation map using the GC of the sub-set as MIMO encoding matrix according to the first embodiment of the present system.

Fig. 17 shows a transmitting/receiving signal and MIMO-encoded signal according to a second embodiment of the present invention.

Fig. 18 shows a MIMO encoding method according to a third embodiment of the present invention.

Fig. 19 shows a transmitting/receiving signal and MIMO-encoded signal according to a third embodiment of the present system.

Fig. 20 shows a transmitting/receiving signal and MIMO-encoded signal according to a fourth embodiment of the present system.

Fig. 21 shows a transmitting/receiving signal and MIMO-encoded signal according to a sixth embodiment of the present system.

Fig. 22 shows a structure of a P1 symbol and AP1 symbol according to an embodiment of the present invention.

Fig. 23 shows a P1 symbol detection module according to an embodiment of the present invention.

Fig. 24 shows an AP1 symbol detection module according to an embodiment of the present invention.

Fig. 25A and B shows P1 signaling information and AP1 signaling information according to an embodiment of the present invention.

Fig. 26 shows L1-free signaling information according to another embodiment of the present invention.

Fig. 27 shows L1-post signaling information according to another embodiment of the present invention.

Fig. 28 shows L1-post dynamic signaling information according to another embodiment of the present invention.

Fig. 29 shows an input processor of a broadcast signal transmitter/receiver according to an embodiment of the present invention.

Fig. 30 shows a mode adaption module implementing a plurality of PLP as an input processor according to an embodiment of the present invention.

Fig. 31 shows a stream adaption module implementing a plurality of PLP as an input processor according to an embodiment of the present invention.

Fig. 32 shows a BICM encoder according to the first embodiment of the present invention.

Fig. 33 shows a frame builder encoder according to the first embodiment of the present invention.

Fig. 34 shows an OFDM generator according to the first embodiment of the present invention.

Fig. 35 shows a BICM encoder according to the second embodiment of the present invention.

Fig. 36 shows an OFDM demodulator according to the first embodiment of the present invention.

Fig. 37 shows a frame demapper according to the first embodiment of the present invention.

Fig. 38 shows a BICM encoder according to the first embodiment of the present invention.

Fig. 39 shows a BICM encoder according to the second embodiment of the present invention.

Fig. 40 shows an output process of the broadcast signal receiver according to an embodiment of the present invention.

Fig. 41 shows an output process of the broadcast signal receiver according to another embodiment of the present invention.

Fig. 42 shows a BICM encoder according to the third embodiment of the present invention.

Fig. 43 shows a frame builder encoder according to the third embodiment of the present invention.

Fig. 44 shows an OFDM generator according to the third embodiment of the present invention.

Fig. 45 shows a BICM encoder according to the fourth embodiment of the present invention.

Fig. 46 shows another embodiment of the BICM encoder according to the third embodiment of the present invention shown in Fig. 45.

Fig. 47 shows an OFDM generator according to the fourth embodiment of the present invention.

Fig. 48 shows a broadcast signal transmitting/receiving system according to the fourth embodiment of the present invention.

Fig. 49 shows an OFDM demodulator according to the third embodiment of the present invention.

Fig. 50 shows a frame demapper according to the third embodiment of the present invention.

Fig. 51 shows a BICM decoder according to the third embodiment of the present invention.

Fig. 52 shows an OFDM demodulator according to the fourth embodiment of the present invention.

Fig. 53 shows a BICM decoder as an embodiment according to the fourth embodiment of the present invention.

Fig. 54 shows a BICM decoder as another embodiment according to the fourth embodiment of the present invention.

Fig. 55 (a) and (e) show an outputting order of a demultiplexer according to each code rate when a LDPC block length is 16800 and a modulating format for symbol mapping is 256QAM.

Fig. 56 shows a mapping relationship between an input bit of the multiplexer and an output bit of that according to a de-mux type in Fig. 55.

Fig. 57 (a) and (c) show an outputting order of a demultiplexer as another embodiment according to each code rate when a LDPC block length is 16800 and a modulating format for symbol mapping is 256QAM.

Fig. 58 shows a mapping relationship between an input of the demultiplexer and an output of that according to a de-mux type in Fig. 57.

Fig. 59 (a) and (c) show an outputting order of a demultiplexer as another embodiment according to each code rate when a LDPC block length is 16800 and a modulating format for symbol mapping is 256QAM.

Fig. 60 (a) and (c) (a) and (c) show an outputting order of a demultiplexer as an embodiment according to each code rate when a LDPC block length is 16800 and a modulating format for symbol mapping is 64QAM.

Fig. 61 (a), (b) show an outputting order of a demultiplexer as another embodiment according to each code rate when a LDPC block length is 16800 and a modulating format for symbol mapping is 16QAM.

Fig. 62 shows an interleaving process of a pair-wise frequency interleaver according to an embodiment of the present invention.

Fig. 63 shows a deinterleaving process of a pair-wise frequency deinterleaver according to an embodiment of the present invention.

Fig. 64 shows a cell mapping structure as an embodiment according to the first and second embodiment of the present invention.

Fig. 65 shows a cell mapping structure as an embodiment according to the third and fourth embodiment of the present invention.

Fig. 66 shows a method of receiving broadcast signals according to an embodiment of the present invention.

[Best Mode]

Hereinafter, although the preferred embodiments of the present invention will be described in detail with reference to the accompanying drawings and contents as described with relation to the accompanying drawings, it is to be understood that the present invention is not limited to the embodiments.

Various technologies have been introduced to increase transmission efficiency and to perform robust communication in a digital broadcast system. One of such technologies is a method of using a plurality of antennas at a transmitting side or a receiving side. This method may be classified into a Single-Input Single-Output (SISO) scheme in which transmission is performed through a single antenna and reception is performed through a single antenna, a Single-Input Multi-Output (SIMO) scheme in which transmission is performed through a single antenna and reception is performed through multiple antennas, a Multi-Input Single-Output (MISO) scheme in which transmission is performed through multiple antennas and reception is performed through a single antenna, and a Multi-Input Multi-Output (MIMO) scheme in which transmission is performed through multiple antennas and reception is performed through multiple antennas. Although the multiple antennas may be exemplified by 2 antennas for ease of explanation in the following description, the description of the present invention may be applied to systems that use 2 or more antennas.

The SISO scheme corresponds to a general broadcast system that uses 1 transmission antenna and 1 reception antenna. The SIMO scheme corresponds to a broadcast system that uses 1 transmission antenna and a plurality of reception antennas.

The MISO scheme corresponds to a broadcast system that uses a plurality of transmission antennas and 1 reception antenna to provide transmit diversity. An example of the MISO scheme is an Alamouti scheme. In the MISO scheme, it is possible to receive data through 1 antenna without performance loss. Although a reception system can receive the same data through a plurality of reception antennas in order to improve performance, this case will be described as belonging to MISO cases in this specification.

The performance of a system that employs the MIMO technology depends on characteristics of a transmission channel. The efficiency of such a system is high, especially, when the system has independent channel environments.

That is, the performance of the system that employs the MIMO technology may improve when channels of all antennas ranging from antennas of the transmitting side and antennas of the receiving side are independent channels that have no correlation to each other. However, in a channel environment in which the correlations between channels of transmission and reception antennas are very high as in a line-of-sight (LOS) environment, the performance of the system that employs the MIMO technology may be significantly reduced or the system may not be able to operate.

In addition, if the MIMO scheme is applied to a broadcast system that uses the SISO and MISO schemes, it is possible to increase data transmission efficiency. However, in addition to the above problems, there is a need to maintain compatibility to allow a receiver having a single antenna to receive services. Accordingly, the present invention suggests a method for solving such existing problems.

In addition, the present invention can provide a broadcast signal transmitter/receiver and a broadcast transmission and reception method for a conventional terrestrial broadcast system and a system that can transmit and receive additional broadcast signals (or enhanced broadcast signals), for example, mobile broadcast signals, while sharing an RF frequency band with a terrestrial broadcast system such as DVB-T2.

To accomplish this, in the present invention, it is possible to use a video coding method having scalability in which a basic video component which has low image quality although it is robust to a communication environment and an extended video component which is slightly weak to a communication environment although it can provide a high-quality image can be distinguishably transmitted. Although the present invention will be described with reference to SVC as a video coding method having scalability, the present invention may be applied to any other video coding methods. Embodiment of the present invention will be described in more detail with reference to the drawings.

A broadcast signal transmitter and receiver of the present invention can perform MISO processing and MIMO processing on a plurality of signals that are transmitted and received through a plurality of antennas. The following is a description of a broadcast signal transmitter and receiver that performs signal processing on 2 signals that are transmitted and received through 2 antennas.

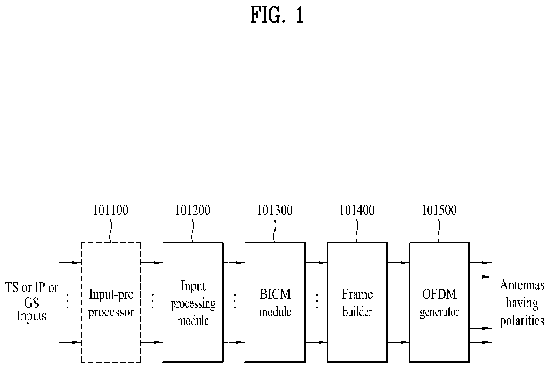

FIG. 1 illustrates a broadcast signal transmitter using the MIMO scheme according to an embodiment of the present invention.

As shown in FIG. 1, the broadcast signal transmitter according to the present invention may include an input processor 101100, an input processing module 101200, a Bit Interleaved Coded Modulation (BICM) encoder 101300, a frame builder 101400, and an Orthogonal Frequency-Division Multiplexing (OFDM) generator (or transmitter) 101500. The broadcast signal transmitter according to the present invention may receive a plurality of MPEG-TS streams or a General Stream Encapsulation (GSE) stream (or GS stream).

The input processor 101100 may generate a plurality of PLPs (physical layer pipes) on a service basis in order to give robustness to a plurality of input streams, i.e., a plurality of MPEG-TS streams or GSE streams.

PLPs are data units that are identified in the physical layer. Specifically, a PLP is data having the same physical layer attribute which is processed in the transmission path and may be mapped on a cell by cell basis in a frame. In addition, a PLP may be considered a physical layer Time Division Multiplexing (TDM) channel that carries one or a plurality of services. Specifically, a path through which such a service is transmitted is transmitted or a stream identifiable in the physical layer which is transmitted through the path is referred to as a PLP.

Thereafter, the input processing module 101200 may generate a Base Band (BB) frame including a plurality of generated PLPs. The BICM module 101300 may add redundancy to the BB frame to correct an error in a transmission channel and may interleave PLP data included in the BB frame.

The frame builder 101400 may accomplish a transmission frame structure by mapping the plurality of PLPs to a transmission frame and adding signaling information thereto. The OFDM generator 101500 may demodulate input data from the frame builder according to OFDM to divide the input data into a plurality of paths such that the input data is transmitted through a plurality of antennas.

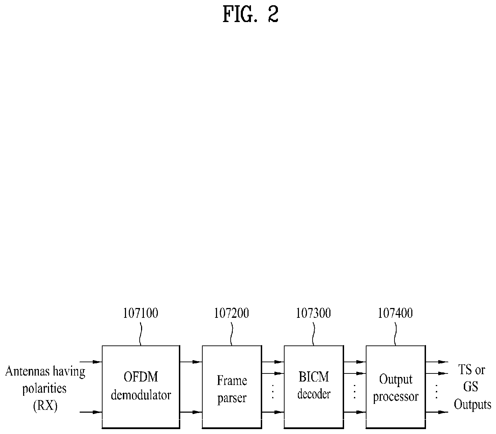

FIG. 2 illustrates a broadcast signal receiver according to an embodiment of the present invention.

As shown in FIG. 2, the broadcast signal receiver may include an OFDM demodulator 107100, a frame parser 107200, a BICM decoder 107300, and an output processor 107400. The OFDM demodulator 107100 may convert signals received through a plurality of receive antennas into signals in the frequency domain. The frame parser 107200 may output PLPs for a necessary service from among the converted signals. The BICM decoder 107300 may correct an error generated according to a transmission channel. The output processor 107400 may perform procedures necessary to generate output TSs or GSs. Here, dual polarity signals may be input as input antenna signals and one or more streams may be output as the TXs or GSs.

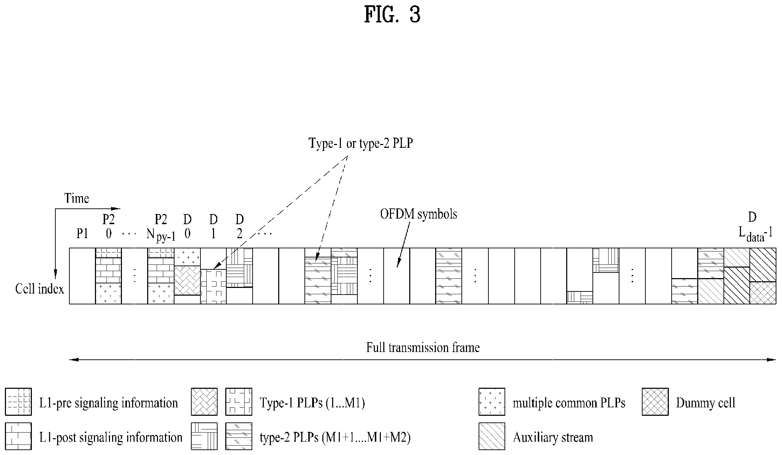

FIG. 3 illustrates an additional frame structure based on PLP according to an embodiment of the present invention.

As shown in FIG. 3, a frame according to an embodiment of the present invention may include a preamble area and a data area. The preamble area may include a P1 symbol and a P2 symbol and the data area may include a plurality of data symbols. The P1 symbol may transmit P1 signaling information and P2 symbol may transmit L1-signaling information..

In this case, a preamble symbol may be additionally allocated to the preamble. This additional preamble symbol is referred to as an Additional Preamble 1 (API). In an embodiment of the present invention, one or more AP1 symbols may be added to a frame in order to improve detection performance of a mobile broadcast signal under very low SNR or time-selective fading conditions. AP1 signaling information transmitted through the AP1 symbol may include an additional transmission parameter.

AP1 signaling information according to an embodiment of the present invention includes pilot pattern information in a frame. Thus, according to an embodiment of the present invention the broadcast signal receiver does not transmit P2 symbol, if L1 signaling information is spread in data symbols of the data area, pilot pattern information can be discovered by using the AP1 signaling information before L1 signaling information in the data area is decoded.

Also, if the L1-signaling information in the data area of a frame is spread, AP1 signaling information can include information necessary for the broadcast signal receiver to decode signaling information spread in a frame of the data area. According to the present invention, a preamble area of a frame include a P1 symbol, more than one AP1 symbols, and more than one P2 symbols. And the data area comprises a plurality of data symbols, also known as data OFDM symbol. A P2 symbol is optional and whether it is inserted is determined by signaling AP1 signaling information through AP1 symbols according to an embodiment of the present invention.

In an embodiment of the present invention, a P1 insertion module in the OFDM generator OFDM generator 101500 of the broadcast signal transmitter may insert the P1 symbol and the AP1 symbol into every symbol. That is, the P1 insertion module may insert 2 or more preamble symbols into every frame. In another embodiment, an AP1 insertion module may be added downstream of (or next to) the P1 insertion module and the AP1 insertion module may insert the AP1 symbol. If 2 or more preamble symbols are used as in the present invention, there are advantages in that robustness to burst fading that may occur in a mobile fading environment is further increased and signal detection performance is also improved.

The P1 symbol may transmit P1 signaling information associated with a basic transmission parameter and transmission type and a corresponding preamble identifier and the receiver may detect the frame using the P1 symbol. A plurality of P2 symbols may be provided and may carry L1 signaling information and signaling information such as a command PLP. The L1 signaling information may include L1-pre signaling information and L1-post signaling information, common PLP may include network information such as a NIT(Network Information Table) or PLP information and service information such as an SDT(Service Description Table) or an EIT(Event Information Table). The preamble of the present invention may include only the P1 symbol, the L1-pre signaling information, and the L1-post signaling information or may include all of the P1 symbol, the L1-pre signaling information, the L1-post signaling information, and the common PLP according to designer intention. A plurality of data symbols located next to the P1 symbol may include a plurality of PLPs. The plurality of PLPs may include audio, video, and data TS streams and PSI/SI information such as a Program Association Table (PAT) and a Program Map Table (PMT). In the present invention, a PLP that transmits PSI/SI information may be referred to as a base PLP or a signaling PLP. The PLPs may include a type-1 PLP that is transmitted through one sub-slice per frame and a type-2 PLP that is transmitted through two sub-slices per frame. The plurality of PLPs may transmit one service and may also transmit service components included in one service. When the PLPs transmit service components, the transmitting side may transmit signaling information which indicates that the PLPs transmit service components.

In addition, additional data (or an enhanced broadcast signal) in addition to basic data may be transmitted through a specific PLP while sharing an RF frequency band with the conventional terrestrial broadcast system according to an embodiment of the present invention. In this case, the transmitting side may define a system or a signal that is currently transmitted through signaling information of the P1 symbol described above. The following description is given with reference to the case in which the additional data is video data. That is, as shown in FIG. 3, PLP M1 112100 and PLP (M1+M2) 112200 which are type 2 PLPs may be transmitted while including additional video data. In addition, in the present invention, a frame that transmits such additional video data may be referred to as an additional frame and a frame that transmits basic data may be referred to as a basic frame (or T2 frame).

In addition, a frame that can transmit not only additional data but also data associated with a new broadcast system different from the conventional terrestrial broadcast system may be referred to as an additional frame. In this case, a frame that transmits a conventional terrestrial broadcast may be referred to as a terrestrial broadcast frame and an additional frame may transmit additional data or basic data associated with the new broadcast system.

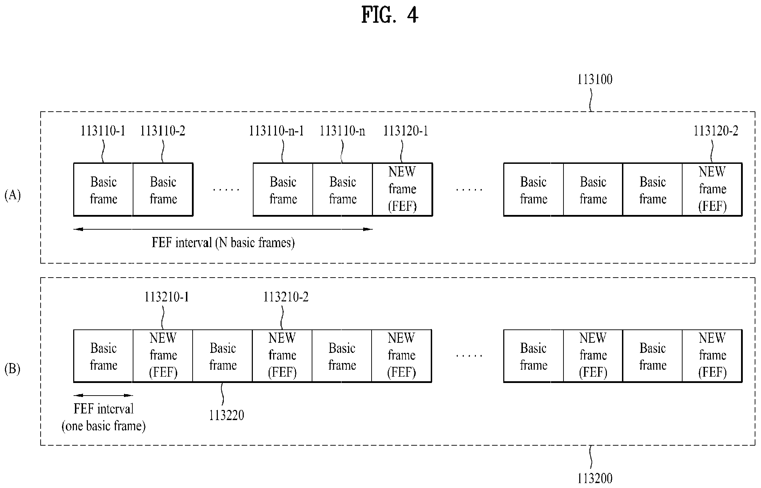

FIG. 4 illustrates a structure of an additional frame based on FEF according to an embodiment of the present invention.

Specifically, FIG. 4 shows the case in which a Future Extension Frame (FEF) is used in order to transmit additional video data. In the present invention, a frame that transmits basic video data may be referred to as a basic frame and an FEF that transmits additional video data may be referred to as an additional frame.

FIG. 4 shows structures of superframes 11100 and 113200 in each of which a basic frame and an additional frame are multiplexed. Frames 113100-1 to 113100-n that are not shaded from among frames included in the superframe 113100 are basic frames and shaded frames 113120-1 and 113120-2 are additional frames.

FIG. 4(A) shows the case in which the ratio of basic frames to additional frames is N:1. In this case, the time required for the receiver to receive a next additional frame 113120-2 after receiving one additional frame 113120-1 may correspond to N basic frames.

FIG. 4(B) shows the case in which the ratio of basic frames to additional frames is 1:1. In this case, the proportion of additional frames in the superframe 113200 may be maximized and therefore the additional frames may have a structure very similar to that of the basic frames in order to maximize the extent of sharing with the basic frames. In addition, in this case, the time required for the receiver to receive a next additional frame 113210-2 after receiving one additional frame 113210-1 corresponds to 1 basic frame 113220 and therefore the superframe period is shorter than that of FIG. 4(A).

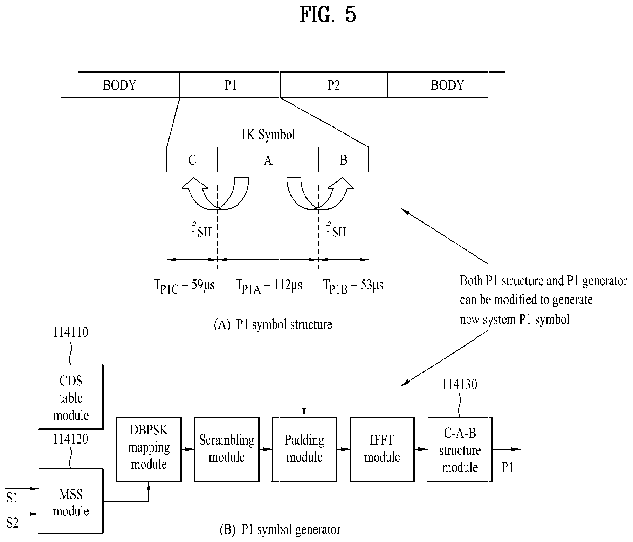

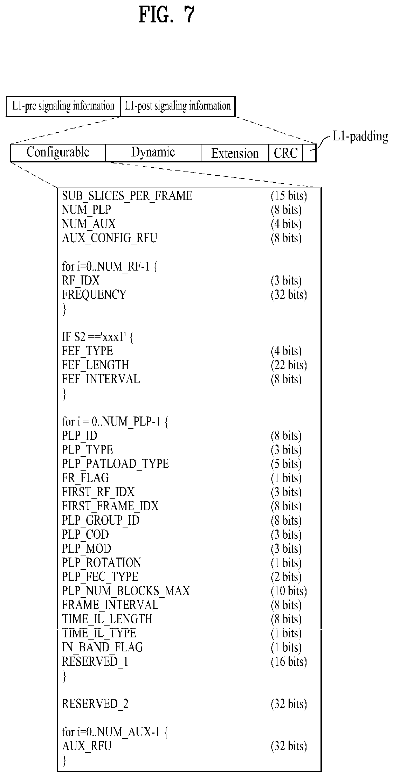

FIGs. 5(A) and 7(B) illustrate a P1 symbol generation procedure for identifying additional frames according to an embodiment of the present invention.

In the case in which additional video data is transmitted through additional frames which are distinguished from basic frames as shown in FIG. 4, there is a need to transmit additional signaling information for enabling the receiver to identify and process an additional frame. An additional frame of the present invention may include a P1 symbol for transmitting such additional signaling information and the P1 symbol may be referred to as a new_system_P1 symbol. This new_system_P1 symbol may be different from a P1 symbol that is used in a conventional frame and a plurality of new_system_P1 symbols may be provided. In an embodiment, the new_system_P1 symbol may be located before a first P2 symbol in a preamble area of the frame.

In the present invention, a P1 symbol of a conventional frame may be modified and used to generate the minimum Hamming distance. The present invention suggests a method in which a minimum Hamming distance is generated by modifying the structure of the P1 symbol of the conventional frame or is generated by changing the symbol generator 114100 that generates symbols.

FIG. 5(A) shows the structure of the P1 symbol of the conventional frame. In the present invention, the structure of the P1 symbol of the conventional frame shown in FIG. 5(A) may be modified to generate a minimum Hamming distance. In this case, the minimum Hamming distance may be generated by changing a frequency displacement f_SH for the prefix and postfix of the conventional P1 symbol or changing the length (specifically, the size of T_P1C or T_P1B) of the P1 symbol. However, in the case in which the minimum Hamming distance is generated by modifying the structure of the P1 symbol, there is a need to appropriately modify parameters (the sizes of T_P1C and T_P1B and f_SH) used in the P1 symbol structure.

FIG. 5(B) shows the P1 symbol generator that generates P1 symbols. In the present invention, the P1 symbol generator shown in FIG. 5(B) may be modified to generate a minimum Hamming distance. In this case, a minimum Hamming distance may be generated using a method which changes the distribution of active carriers used for a P1 symbol in a CDS table module 114110, an MSS module 114120, and a C-A-B structure module 114130 included in the P1 symbol generator (for example, a method in which the CDS table module 114110 uses a different Complementary Set of Sequence (CSS)) or a method which changes a pattern for information that is transmitted through a P1 symbol (for example, a method in which the MSS module 114120 uses a different Complementary Set of Sequence (CSS)).

In addition, the AP1 symbol of the present invention described above with reference to FIG. 3 may be generated through the procedure described above with reference to FIG. 5.

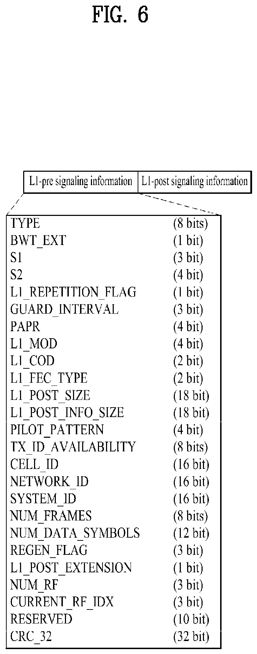

FIG. 6 shows L1-pre signaling information included in a transmitted/received signal according to an embodiment of the present invention.

As described above, L1 signaling information may include P1 signaling information, L1-pre signaling information and L1-post signaling information. The P1 signaling information (not shown) may be located prior to the L1-pre signaling information. The P1 signaling information may include an S1 field and an S2 field. The S1 field may include identifiers for indicating formats of a preamble region and the S2 field may include identifiers for indicating side information.

FIG. 6 shows an embodiment of a table included in the L1-pre signaling information. The L1-pre signaling information may include information necessary to receive and decode the L1-post signaling information. Fields included in the table will now be described. The size of each field and field types that can be included in the table may be changed.

The TYPE field has 8 bits and may indicate whether the type of an input stream is TS or GS.

The BWT_EXT field has 1 bit and may indicate bandwidth extension of an OFDM symbol.

The S1 field has 3 bits and may represent whether a current transmission system is a MISO system or a MIMO system.

The S2 field has 4 bits and may indicate an FFT size.

The L1_REPETITION_FLAG field has 1 bit and may represent a repetition flag of an L1 signal.

The GUARD_Interval field has 3 bits and may indicate the size of a guard interval of the current transmission system.

The PAPR field has 4 bits and may indicate a PAPR reduction scheme. As described above, ACE or TR scheme may be used as the PAPR scheme in the present invention.

The L1_MOD field has 4 bits and may indicate QAM modulation type of the L1-post signaling information.

The L1_COD field has 2 bits and may indicate the code rate of the L1-post signaling information.

The L1_FEC_TYPE field has 2 bits and may indicate the FEC type of the L1-post signaling information.

The L1_POST_SIZE field has 18 bits and may indicate the size of the L1-post signaling information.

The L1_POST_INFO_SIZE field has 18 bits and may indicate the size of an information region of the L1-post signaling information.

The PILOT_PATTERN field has 4 bits and may indicate a pilot insertion pattern.

The TX_ID_AVAILABILITY field has 8 bits and may indicate transmitter identification availability in a current geographical cell range.

The CELL_ID field has 16 bits and may indicate a cell identifier.

The NETWORK_ID field has 16 bits and may indicate a network identifier.

The SYSTEM_ID field has 16 bits and may indicate a system identifier.

The NUM_FRAMES field has 8 bits and may indicate the number of transmission frames per super-frame.

The NUM_DATA_SYMBOLS field 12 bits and may indicate the number of OFDM symbols per transmission frame.

The REGEN_FLAG field has 3 bits and may indicate the number of regenerations of a signal according to a repeater.

The L1_POST_EXTENSION field has 1 bit and may indicate presence or absence of an extension block of the L1-post signaling information.

The NUM_RF field has 3 bits and may indicate the number of RF bands for TFS.

The CURRENT_RF_IDX field has 3 bits and may indicate the index of a current RF channel.

The RESERVED field has 10 bits and is reserved for later use.

The CRC_32 field has 32 bits and may indicate a CRC error extraction code of the L1-pre signaling information.

FIG. 7 shows L1-post signaling information included in a transmitted/received signal according to an embodiment of the present invention.

The L1-post signaling information may include parameters necessary for the receiver to encode PLP data.

The L1-post signaling information may include a configurable block, a dynamic block, an extension block, a cyclic redundancy check (CRC) block, and an L1 padding block.

The configurable block may include information equally applied to one transmission frame and the dynamic block may include characteristic information corresponding to a currently transmitted frame.

The extension block may be used when the L1-post signaling information is extended, and the CRC block may include information used for error correction of the L1-post signaling information and may have 32 bits. The padding block may be used to adjust sizes of information respectively included in a plurality of encoding blocks to be equal when the L1-post signaling information is transmitted while being divided into the encoding blocks and has a variable size.

FIG. 7 shows a table included in the configurable block, which includes the following fields. The size of each field and field types that can be included in the table are variable.

The SUB_SLICES_PER_FRAME field has a size of 15 bits and may indicate the number of sub-slices per transmission frame.

The NUM_PLP field has a size of 8 bits and may indicate the number of PLPs.

The NUM_AUX field has a size of 4 bits and may indicate the number of auxiliary streams.

The AUX_CONFIG_RFU field has a size of 8 bits and is a reserved region.

The following fields are included in "for loop" (or frequency loop) to be repeated based on the number of RF (NUM_RF filed-1) of the present system. NUM_RF field may be signaled via L1-pre signaling information.

The RF_IDX field has a size of 3 bits and may indicate an RF channel index.

The FREQUENCY field has a size of 32 bits and may indicate an RF channel frequency.

The following fields are used only when the LSB of S2 field is 1, that is, when S2='xxx1'.

The FEF_TYPE field has a size of 4 bits and may be used to indicate a future extension frame (FEF).

The FEF_LENGTH field has a size of 22 bits and may indicate the length of an FEF.

The FEF_INTERVAL field has a size of 8 bits and may indicate the duration of an FEF interval.

The following fields are included in "for loop"(or PLP loop) to be repeated based on the number of PLP in the super frame(NUM_PLP filed-1).

The PLP_ID field has a size of 8 bits and may be used to identify a PLP.

The PLP_TYPE field has a size of 3 bits and may indicate whether a current PLP is a common PLP or a PLP including normal data.

The PLP_PAYLOAD_TYPE field has a size of 5 bits and may indicate a PLP payload type. That is, PLP PAYLOAD may include GFPS, GCS, GSE, TS, IP data perceived by PLP_PAYLOAD_TYPE.

The FF_FLAG flag has a size of 1 bit and may indicate a fixed frequency flag.

The FIRST_RF_IDX field has a size of 3 bits and may indicate the index of the first RF channel for TFS.

The FIRST_FRAME_IDX field has a size of 8 bits and may indicate the first frame index of a current PLP in a super-frame.

The PLP_GROUP_ID field has a size of 8 bits and may be used to identify a PLP group. A PLP group may be referred to as a link-layer-pipe (LLP) and PLP_GROUP_ID field is called LLP_ID field in an embodiment of the present invention.

The PLP_COD field has a size of 3 bits and may indicate a code rate of a PLP.

The PLP_MOD field has a size of 3 bits and may indicate a QAM type of a PLP.

The PLP_ROTATION field has a size of 1 bit and may indicate a constellation rotation flag of a PLP.

The PLP_FEC_TYPE field has a size of 2 bits and may indicate FEC type of a PLP.

The PLP_NUM_BLOCKS_MAX field has a size of 10 bits and may indicate a maximum number of PLPs of FEC blocks.

The FRAME_INTERVAL field has a size of 8 bits and may indicate an interval of a transmission frame.

The TIME_IL_LENGTH field has a size of 8 bits and may indicate a symbol interleaving (or time interleaving) depth.

The TIME_IL_TYPE field has a size of 1 bit and may indicate a symbol interleaving (or time interleaving) type.

The IM-BAND_B_FLAG field has a size of 1 bit and may indicate an in-band signaling flag.

The RESERVED_1 field has a size of 16 bits and is used in the PLP loop in the future.

The RESERVED_2 field has a size of 32 bits and is used in the configurable block in the future.

The following fields are included in an auxiliary stream loop.

THE AUX_RFU field has a size of 32 bits and is called "for loop" to be repeated based on the number of sub-stream (NUM_AUX field -1). That is, it is a filed to be used in the sub-stream loop.

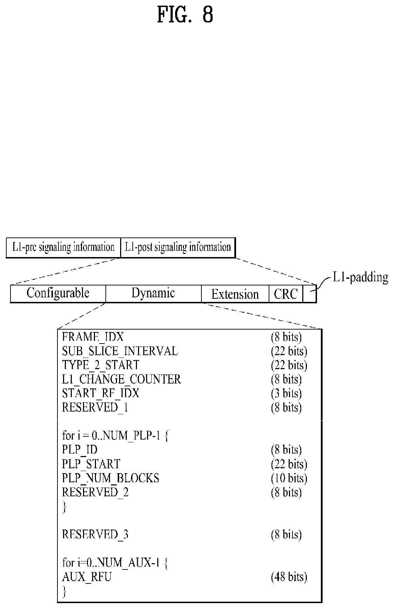

FIG. 8 shows L1-post signaling information included in a transmitted/received signal according to another embodiment of the present invention.

The table included in a dynamic block shown in Fig. 8 includes parameters necessary for the receiver to decode PLP and especially includes information regarding the current frame. The table shown in Fig. 8 can signal to in-band to efficiently implement slicing in the receiver.

A table shown in FIG. 8 is included in the dynamic block and includes the following fields. The size of each field and field types that can be included in the table are variable.

The FRAME_IDX field has a size of 8 bits and may indicate a frame index in a super-frame.

The SUB_SLICE_INTERVAL field has a size of 22 bits and may indicate a sub-slice interval.

The TYPE_2_START field has a size of 22 bits and may indicate a start position of PLPs of a symbol interleaver over a plurality of frames. L1_CHANGE_COUNTER field has a size of 8 bits and may indicate a change in L1 signaling.

The START_RF_IDX field has a size of 3 bits and may indicate a start RF channel index for TFS.

The RESERVED_1 field has a size of 8 bits and is a reserved field.

It is a filed called "for' loop" to be repeated as many times as the number of PLP in the super frame (NUM_PLP FIELD VALUE -1).

The PLP_ID field has a size of 8 bits and may be used to identify each PLP.

The PLP_START field has a size of 22 bits and may indicate a PLP start address in a frame.

The PLP_NUM_BLOCKS field has a size of 10 bits and may indicate the number of PLPs of FEC blocks.

The RESERVED_2 field has a size of 8 bits and may be used in the PLP loop in the future.

The RESERVED_3 field has a size of 8 bits and may be used in the dynamic block in the future.

The following field is included in the auxiliary stream loop.

The AUX_RFU field has a size of 48 bits and may be used in the auxiliary stream loop in the future.

In addition, the present invention proposes a MIMO system using scalable video coding (SVC). SVC is a video coding method developed to cope with a variety of terminals and communication environments and variations in the terminals and communication environments. SVC can code a video hierarchically such that desired definition is generated and transmit additional video data having a base layer from which video data about an image having basic definition can be restored and an enhancement layer from which an image having higher definition can be restored. Accordingly, a receiver can acquire the basic definition image by receiving and decoding only the video data of the base layer, or obtain the higher definition image by decoding the video data of the base layer and the video data of the enhancement layer according to characteristics thereof. In the following description, the base layer can include video data corresponding to the base layer and the enhancement layer can include video data corresponding to the enhancement layer. In the following, video data may not be a target of SVC, the base layer can include data capable of providing a fundamental service including basic video/audio/data corresponding to the base layer, and the enhancement layer can include data capable of providing a higher service including higher video/audio/data corresponding to the enhancement layer.

The present invention proposes a method of transmitting the base layer of SVC through a path through which signals can be received according to SISO or MISO using SVC and transmitting the enhancement layer of SVC through a path through which signals can be received according to MIMO in the broadcast system of the present invention. That is, the present invention provides a method by which a receiver having a single antenna acquires an image with basic definition by receiving the base layer using SISO or MISO and a receiver having a plurality of antennas acquires an image with higher definition by receiving the base layer and the enhancement layer using MIMO.

A description will be given of a method of transmitting the MIMO broadcast data including the base layer and the enhancement layer in association with terrestrial broadcast frames for transmitting terrestrial broadcast signals.

(1) Method of transmitting MIMO broadcast data using predetermined PLP

It is possible to transmit the MIMO broadcast data included in a predetermined PLP while distinguishing the predetermined PLP from a PLP including terrestrial broadcast data. In this case, the predetermined PLP is used to transmit the MIMO broadcast data, and signaling information for describing the predetermined PLP may be additionally transmitted to prevent an error in the conventional receiving system. In the following, the predetermined PLP including the MIMO broadcast data may be referred to as a MIMO broadcast PLP and the PLP including the terrestrial broadcast data may be referred to as a terrestrial broadcast PLP.

As MIMO broadcast data may not be implemented in a terrestrial broadcast receiver, it is necessary to have additional information for signalling to distinguish terrestrial PLP and MIMO broadcast PLP. In this case, signaling can use a reserved field in the L1 signaling information of the terrestrial broadcast system. When a plurality of anttenas are used for transmitting MIMO broadcast data on the transmitting side, the terrestrial broadcast data can be transmitted by MISO. The present invention, in order to perceive PLP, utilizes L1-post signaling information.

(2) Method of transmitting MIMO broadcast data using predetermined frame

It is possible to include the MIMO broadcast data generated as described above in a predetermined frame and to transmit the predetermined frame including the MIMO broadcast data while distinguishing the predetermined frame from a terrestrial broadcast frame. In this case, the predetermined frame is used to transmit the MIMO broadcast data, and signaling information for describing the predetermined frame may be additionally transmitted to prevent an error in the conventional receiving system.

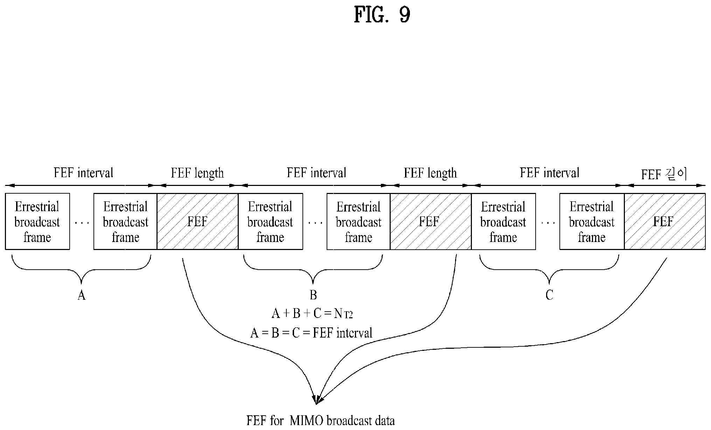

Fig. 9 shows a conceptual diagram for a method of transmitting broadcast signals.

As shown in Fig. 9, terrestrial broadcast data and MIMO broadcast data in frame units can be distinctively transmitted. The FEF length of a MIMO broadcast frame (FEF) can be allocated in between terrestrial broadcast frames in an FEF interval. In this case, MIMO system data can co-exist in a frequency band within the terrestrial broadcast system, and malfunction can be prevented by the broadcast signal receiver perceiving a frame through L1 signaling and ignoring MIMO broadcast frames. In that case, the MIMO system can use some of the thruput by FEF related parameters such as FEF_TYPR, FEF_LENGTH, FEF_INTERVAL defined by the L1-post signaling information.

(3) Method of transmitting MIMO broadcast PLP using terrestrial broadcast frame and MIMO broadcast frame

PLPs including MIMO broadcast data may be transmitted through a terrestrial broadcast frame and a MIMO broadcast frame. Since a MIMO broadcast PLP may be present in the terrestrial broadcast frame (or basic frame), distinguished from the above-mentioned embodiments, it is necessary to signal the relationship between connected PLPs present in the terrestrial broadcast frame and the MIMO broadcast frame. To achieve this, the MIMO broadcast frame may also include L1 signaling information, and information about the MIMO broadcast PLP present in the broadcast frame may be transmitted along with L1 signaling information of the terrestrial broadcast frame.

MIMO broadcast PLP data in different frames are connected by using PLP fields including L1-post signanling information. According to an embodiment of the present invention, the receiving system includes as L1-post signaling information PLP_ID information, PLP+TYPE information, PLP_PAYLOAD_TYPE information, PLP_GROYP_ID information, uses those information to check the PLP connection between MIMO broadcast PLP data. It then acquires services by continuously decoding desired MIMO broadcast PLP data.

terrestrial broadcast PLP in the terrestrial broadcast frames can be transmitted as a preset mode and also as mentioned a new mode to support the MIMO system can be transmitted. According to an embodiment of the present invention, the MIMO broadcast PLP in the terrestrial broadcast frames as a base layer can be transmitted by MISO or SISO method and MIMO broadcast PLP in MIMO broadcast frames as an enhancement layer can be transmitted by the MIMO method.

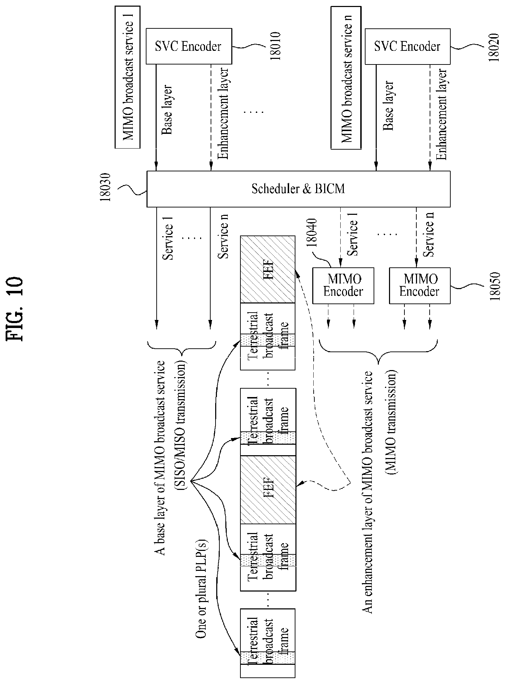

Fig. 10 shows a conceptual diagram for a broadcast signal transmitting method according to another embodiment of the present invention.

Fig. 10 indicates, as shown in the method 3, transmitting the broadcast signals of the MIMO broadcast system in terrestrial broadcast system. The MIMO broadcast services (MIMO broadcast service 1~n) encodes each SVC encoder (18010, 18020) through a base layer and enhancement layer. Scheduler&BICM (Bit Interleaved Coding and Modulation) module (18030) allocates the base layers of the MIMO broadcast services with the terrestrial broadcast frames and the enhancement layers with MIMO encoders (18040, 18050). The enhancement layers encodes by each MIMO encoder (18040, 18050) and transmits to the MIMO broadcast frame of the MIMO broadcast system. The base layers transmits in the terrestrial broadcast frames and in that case, SISO or MISO supported by the terrestrial broadcast system.

When broadcast signals including the terrestrial broadcast frames and the MIMO broadcast frames, as mentioned in the method 1 and 3, singaling information is created and the terrestrial broadcast receiver perceives terrestrial broadcast PLP in the terrestrial broadcast frames. Thus, the receiver can acquire the terrestrial broadcast services withough malfunctioning. Also, the MIMO broadcast receiver can acuire and provide the MIMO broadcast service corresponding to the base layer only by the terrestrial broadcast frame. It can acquire and provide the MIMO broadcast service corresponding to the base layer and enhancement layer by acquiring the MIMO broadcast PLP of the terrestrial broadcast frame and MIMO broadcast frame of the MIMO broadcast frame.

The MIMO broadcast PLP in the terrestrial broadcast frame can only be transmitted by MISO/MIMO. In that case, the MIMO broadcast PLP, as the system demands, can include a code rate of a new error correction code, and new time interleaving mode and can only transmit to a base layer.

The MIMO broadcast PLP of the MIMO broadcast frame includes PLP of the SISO, MISO, and MIMO methods. In that case, PLP of the SISO/MISO methods or a base layer in a carrier can be transmitted and PLP of the MIMO method or the carrier can transmit the enhancement layer. The rate of PLP of the SISO/MISO methods, or carrier and PLP of the MIMO method, or carrier can be varied from 0 to 100%. The ract can be determined for each frame accordingly.

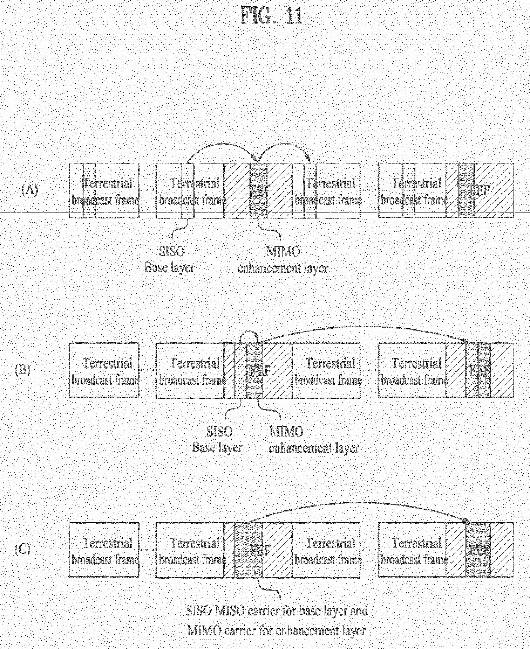

Fig. 11 shows broadcast signals transmitted by a broadcast system being applied by a MIMO system using a SVC.

Fig. 11 shows a broadcast signal that allocates terrestrial data and MIMO broadcast data to a frame or PLP by using the SVC and generating a base and enhancement layer.

Fig. 11A shows a broadcast signal transmitted by a broadcast system being applied by a MIMO transmitting system by using the SVC.

The broadcast system in Fig. 11A transmits broadcast signals including a terrestrial broadcast frame and MIMO broadcast frame. The MIMO broadcast PLP in Fig. 11A can exist in a terrestrial broadcast frame or a MIMO broadcast frame. The MIMO broadcast PLP in the terrestrial broadcast frame as a base layer can be transmited by the SISO or MISO method and the MIMO braod cast PLP in the MIMO broadcast frame as an enhancement layer can be transmitted by the SISO, MISO, or MIMO method.

Fig. 11B shows a broadcast signal being applied by a MIMO transmitting system using a SVC.

In Fig. 11B, the broadcast system transmits broadcast signals including the terrestrial broadcast frame and the MIMO broadcast frame. The MIMO broadcast PLP in Fig. 11B only exists in the MIMO broadcast frame. In that case, the MIMO broadcast PLP indludes PLP with a base layer and PLP with an enhancement layer. The PLP with the base layer can be transmitted by the SISO or MISO method, and the PLP with the enhancement layer can be transmitted by the SISO, MISO, or MIMO method. The rate of the PLP with base layer and the PLP with enhancement layer can be varied from 0 to 100%.

Fig. 11C shows a broadcast signal transmitted by a broadcast system being applied by a MIMO transmitting system using a SVC.

The broadcast system of Fig. 11C transmits broadcast signals including terrestrial broadcast frames and MIMO broadcast frames. The MIMO broadcast data exists only in the MIMO broadcast frame. But, as opposed to Fig. 11B, a base layer and an enhancement layer are not transmitted by PLP but carriers.

Various technologies are introduced to improve transmission efficiency and perform robust communication in a digital broadcast system. One of the technologies is a method of using a plurality of antennas at a transmitting side or a receiving side. This method may be divided into SISO(Single-Input Single-Output), SIMO(Single-Input Multi-Output), MISO(Multi-Input Sinle-Output) and MIMO(Multi-Input Multi-Output). While multiple antennas are described as two antennas in the following, the present invention is applicable to systems using two or more antennas.

SISO is a normal broadcast system using a single transmit antenna and a single receive antenna. SIMO is a broadcast system using a single transmit antenna and multiple receive antennas.

MISO is a broadcast system that provides transmission diversity using a plurality of transmit antennas and a plurality of receive antennas. An example of MISO is Alamouti scheme. MISO can receive data using a single antenna without performance loss. While a reception system may receive the same data through a plurality of receive antennas for performance improvement, this is included in MISO in the specification.

MIMO is a broadcast system that provides transmit/receive diversity and high transmission efficiency using a plurality of transmit antennas and a plurality of receive antennas. MIMO can process signals differently in temporal and spatial dimensions and transmit a plurality of data streams through parallel paths simultaneously operating in the same frequency band to achieve diversity and high transmission efficiency.

In an embodiment, MIMO can use spatial multiplexing (SM) and Golden code (GC) schemes, which will be described in detail.

A modulation scheme in broadcast signal transmission may be represented as M-QAM (Quadrature Amplitude Modulation) in the following description. That is, BPSK (Binary Phase Shift Keying) can be represented by 2-QAM when M is 2 and QPSK (Quadrature Phase Shift Keying) can be represented by 4-QAM when M is 4. M can indicate the number of symbols used for modulation.

A description will be given of a case in which a MIMO system transmits two broadcast signals using two transmit antennas and receives two broadcast signals using two receive antennas as an example.

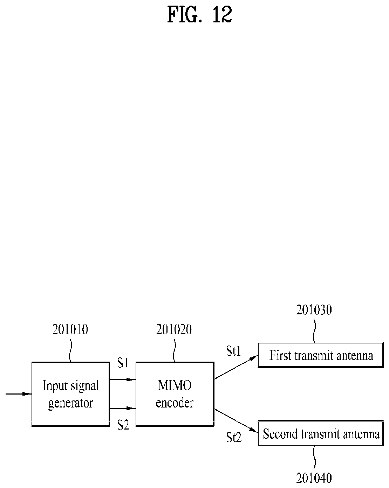

FIG. 12 illustrates MIMO transmission and reception systems according to an embodiment of the present invention.

As shown in FIG. 12, the MIMO transmission system includes an input signal generator 201010, a MIMO encoder 201020, a first transmit antenna 201030, and a second transmit antenna 201040. In the following, the input signal generator 201010 may be referred to as a divider and the MIMO encoder 201020 may be referred to as a MIMO processor.

The MIMO reception system may include a first receive antenna 201050, a second receive antenna 201060, a MIMO decoder 201070, and an output signal generator 201080. In the following, the output signal generator 201080 may be referred to as a merger and the MIMO decoder 101070 may be referred to as an ML detector.

In the MIMO transmission system, the input signal generator 201010 generates a plurality of input signals for transmission through a plurality of antennas. In the following, the input signal generator 201010 may be referred to as a divider. Specifically, the input signal generator 201010 may divide an input signal for transmission into 2 input signals and output the first input signal S1 and the second input signal S2 for MIMO transmission.

The MIMO encoder 201020 may perform MIMO encoding on the plurality of input signals S1 and S2 and output a first transmission signal St1 and a second transmission signal St2 for MIMO transmission and the output transmission signals may be transmitted through a first antenna 201030 and a second antenna 201040 via required signal processing and modulation procedures. The MIMO encoding 201020 may perform encoding on a per symbol basis. The SM scheme or the GC scheme may be used as the MIMO encoding method. In the following, the MIMO encoder may be referred to as a MIMO processor. Specifically, the MIMO encoder may process a plurality of input signals according to a MIMO matrix and a parameter value of the MIMO matrix which are described below.

The input signal generator 201010 is an element that outputs a plurality of input signals for MIMO encoding and may also be an element such as a demultiplexer or a frame builder depending on the transmission system. The input signal generator 201010 may also be included in the MIMO encoder 201020 such that the MIMO encoder 201020 generates a plurality of input signals and performs encoding on the plurality of input signals. The MIMO encoder 201020 may be a device that performs MIMO encoding or MIMO processing on a plurality of signals and outputs the encoded or processed signals so as to acquire diversity gain and multiplexing gain of the transmission system.

Since signal processing should be performed on a plurality of input signals after the input signal generator 201010, a plurality of devices may be provided next to the input signal generator 201010 to process signals in parallel or one device including one memory may be provided to sequentially process signals or to simultaneously process signals in parallel.

The MIMO reception system receives a first reception signal Sr1 and a second reception signal Sr2 using a first receive antenna 201050 and a second receive antenna 201060. The MIMO decoder 201070 then processes the first reception signal and the second reception signal and outputs a first output signal and a second output signal. The MIMO decoder 201070 processes the first reception signal and the second reception signal according to the MIMO encoding method used by the MIMO encoder 201020. As an ML detector, the MIMO decoder 201070 outputs a first output signal and a second output signal using information regarding the channel environment, reception signals, and the MIMO matrix used by the MIMO encoder in the transmission system. In an embodiment, when ML detection is performed, the first output signal and the second output signal may include probability information of bits rather than bit values and may also be converted into bit values through FEC decoding.

The MIMO decoder of the MIMO reception system processes the first reception signal and the second reception signal according to the QAM type of the first input signal and the second input signal processed in the MIMO transmission system. Since the first reception signal and the second reception signal received by the MIMO reception system are signals that have been transmitted after being generated by performing MIMO encoding on the first input signal and the second input signal of the same QAM type or different QAM types, the MIMO reception system may determine a combination of QAM types of the reception signals to perform MIMO decoding on the reception signals. Accordingly, the MIMO transmission system may transmit information identifying the QAM type of each transmission signal in the transmission signal and the QAM type identification information may be included in a preamble portion of the transmission signal. The MIMO reception system may determine the combination of the QAM types of the reception signals from the QAM type identification information of the transmission signals and perform MIMO decoding on the reception signals based on the determination.

The following is a description of a MIMO encoder and a MIMO encoding method that have low system complexity, high data transmission efficiency, and high signal reconstruction (or restoration) performance in various channel environments according to an embodiment of the present invention.

The SM scheme is a method in which data is simultaneously transmitted through a plurality of antennas without MIMO encoding. In this case, the receiver can acquire information from data that is simultaneously received through a plurality of receive antennas. The SM scheme has an advantage in that the complexity of a Maximum Likelihood (ML) decoder that the receiver uses to perform signal reconstruction (or restoration) is relatively low since the decoder only needs to check a combination of received signals. However, the SM scheme has a disadvantage in that transmit diversity cannot be achieved at the transmitting side. In the case of the SM scheme, the MIMO encoder bypasses a plurality of input signals. In the following, such a bypass process may be referred to as MIMO encoding.

The GC scheme is a method in which data is transmitted through a plurality of antennas after the data is encoded according to a predetermined rule (for example, according to an encoding method using golden code). When the number of the antennas is 2, transmit diversity is acquired at the transmitting side since encoding is performed using a 2x2 matrix. However, there is a disadvantage in that the complexity of the ML decoder of the receiver is high since the ML decoder needs to check 4 signal combinations.

The GC scheme has an advantage in that it is possible to perform more robust communication than using the SM scheme since transmit diversity is achieved. However, such a comparison has been made when only the GC scheme and the SM scheme are used for data processing for data transmission and, if data is transmitted using additional data coding (which may also be referred to as outer coding), transmit diversity of the GC scheme may fail to yield additional gain. This failure easily occurs especially when such outer coding has a large minimum Hamming distance. For example, the transmit diversity of the GC scheme may fail to yield additional gain compared to the SM scheme when data is transmitted after being encoded by adding redundancy for error correction using a Low Density Parity Check (LDPC) code having a large minimum Hamming distance. In this case, it may be advantageous for the broadcast system to use the SM scheme having low complexity.

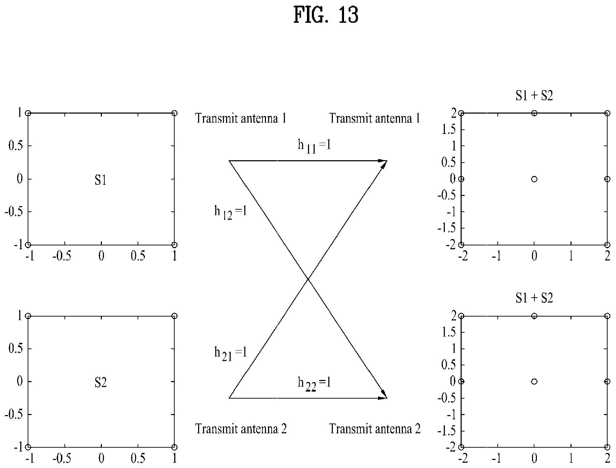

FIG. 13 illustrates a data transmission and reception method according to MIMO transmission of the SM scheme in a channel environment according to an embodiment of the present invention.

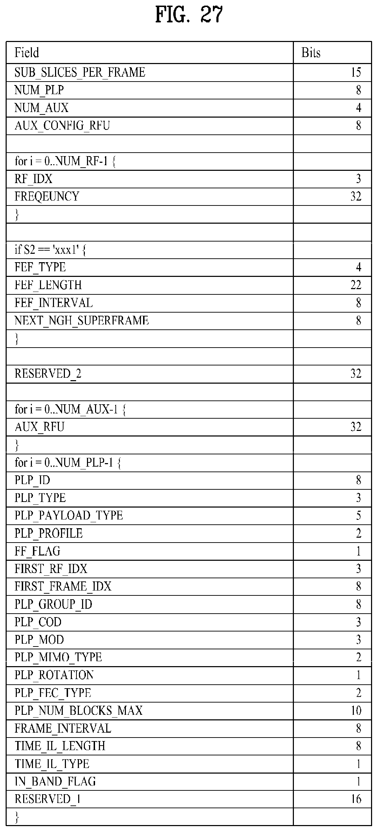

The MIMO transmission system may transmit input signal 1 (S1) and input signal 2 (S2) respectively through transmit antenna 1 and transmit antenna 2 according to the SM scheme. FIG. 27 illustrates an embodiment in which the transmitting side transmits a symbol modulated according to 4-QAM.

The transmit antenna 1 receives a signal through two paths. In the channel environment of FIG. 27, the received signal of the receive antenna 1 is $S1*h_{11} + S2h_{21}$ and the received signal of the receive antenna 2 is $S1*h_{12} + S2h_{22}$. The receiving side may acquire S1 and S2 through channel estimation to reconstruct data.

This is a scenario in which the transmission and reception paths are independent of each other. In the following, such an environment is referred to as being uncorrelated. On the other hand, channels of the transmission and reception paths may have a very high correlation with each other as in a Line Of Sight (LOS) environment, which is referred to as being fully correlated in the following description.

In the case in which channels are fully correlated in MIMO, each channel may be represented by a 2x2 matrix whose elements are all 1 (i.e., $h_{11}=h_{12}=h_{21}=h_{22}=1$) as shown in FIG. 13. Here, the receive antenna 1 and the receive antenna 2 receive the same reception signal (S1+S2). That is, if signals transmitted through 2 transmit antennas pass through the same channel and are received by 2 receive antennas, a reception signal received by the receiver, i.e., data added (or combined) through the channel, cannot express both symbols S1 and S2. As shown in FIG. 13, in the fully correlated channel environment, the receiver cannot receive a 16-QAM symbol, into which the signal S1 represented by a 4-QAM symbol and the signal S2 represented by a 4-QAM symbol are combined and the receiver cannot separate and reconstruct the signals S1 and S2 since the receiver receives a combined signal S1+S2 represented by 9 symbols as shown on the right side of FIG. 13.

In the following, a received signal that has passed through fully correlated channels may be represented by a signal corresponding to the sum of signals transmitted by the transmission system. That is, the MIMO encoding method will now be described on the assumption that, when the transmission system having two antennas transmits a first transmission signal and a second transmission signal, a received signal that has passed through the fully correlated channels corresponds to the sum of the first and second transmission signals.

In this case, the receiver cannot reconstruct a signal received according to MIMO using the SM scheme even when the receiver is in a very high SNR environment. In the case of a communication system, communication is generally performed in two ways and therefore such a channel environment may be signaled to the transmitter through a feedback channel established between the transmitter and the receiver to allow the transmitter to change the transmission method. However, in the case of a broadcast system, it may be difficult to perform bidirectional communication through a feedback channel and one transmitter covers a large number of receivers and a large range and therefore it may be difficult to deal with various channel environment changes. Accordingly, if the SM scheme is used in such a fully correlated channel environment, the receiver cannot receive services and it is difficult to deal with such an environment, increasing costs, unless the coverage of the broadcast network is reduced.

The following is a description of a method for dealing with the case in which the correlation between MIMO channels is 1, i.e., the case in which channels are in a fully correlated channel environment.

The present invention suggests that a MIMO system be designed such that signals received through MIMO channels satisfy the following conditions so as to deal with the case in which the MIMO channels are fully correlated.

1) A received signal should be able to represent both original signals S1 and S2. That is, coordinates of a constellation received by the receiver should be able to uniquely represent sequences of S1 and S2.
2) A minimum Euclidean distance of a received signal should be increased so as to reduce symbol error rate.
3) Hamming distance characteristics of a received signal should be good so as to reduce bit error rate.

First, the present invention suggests a MIMO encoding method that uses a MIMO encoding matrix including an encoding factor "a" as expressed in the following Expression 1 so as to satisfy such requirements.

[Expression 1]

$$\begin{bmatrix} 1 & a \\ a & -1 \end{bmatrix}$$

When a MIMO encoder encodes input signals S1 and S2 using a MIMO encoding matrix as shown in Expression 1, reception signal 1 (Rx1) and reception signal 2 (Rx2) received by antenna 1 and antenna 2 are calculated as expressed in the following Expression 2. The reception signal 1 (Rx1) and reception signal 2 (Rx2) are calculated as expressed in the last line of Expression 2, especially, when MIMO channels are fully correlated.

[Expression 2]

$$Rx_1 = h_{11}(S1 + aS2) + h_{21}(aS1 - S2)$$
$$Rx_2 = h_{12}(S1 + aS2) + h_{22}(aS1 - S2) \quad , if\ h_{11} = h_{21} = h_{12} = h_{22} = h,$$
$$R = Rx_1 = Rx_2 = h\{(a+1)S1 + (a-1)S2\}$$

First, when MIMO channels are uncorrelated, the reception signal 1 (Rx1) is calculated as Rx1 = $h_{11}$(S1+a*S2)+$h_{21}$(a*S1-S1) and the reception signal 2 (Rx2) is calculated as Rx2 = $h_{12}$(S1+a*S2)+$h_{22}$(a*S1-S2). Thus, since the signals S1 and S2 have the same power, it is possible to use gain of the MIMO system together with the SM scheme. When MIMO channels are fully correlated, the reception signals (R=Rx1=Rx2) expressed as R = h{(a+1)S1+(a-1)S2} are acquired and therefore it is possible to separate and acquire the signals S1 and S2 and the signals S1 and S2 are designed such that both have different power and therefore it is possible to secure robustness accordingly.

That is, the MIMO encoder may encode input signals S1 and S2 such that the input signals S1 and S2 have different powers according to the encoding factor "a" and are also received with different distributions even in fully correlated channels. For example, input signals S1 and S2 may be encoded such that both have different powers and the encoded signals may then be transmitted using constellations which have different Euclidean distances through normalization to allow the receiver to separate and reconstruct the input signals even when the signals have passed through fully correlated channels.

The MIMO encoding matrix described above may be represented as Expression 3 taking into consideration a normalization factor.

[Expression 3]

$$\frac{1}{\sqrt{1+a^2}}\begin{pmatrix} 1 & a \\ a & -1 \end{pmatrix} = \begin{pmatrix} \frac{1}{\sqrt{1+a^2}} & \frac{a}{\sqrt{1+a^2}} \\ \frac{a}{\sqrt{1+a^2}} & \frac{-1}{\sqrt{1+a^2}} \end{pmatrix} = \begin{bmatrix} \cos\theta & \sin\theta \\ \sin\theta & -\cos\theta \end{bmatrix}$$

MIMO encoding of the MIMO encoder that uses the MIMO encoding matrix (or rotation matrix) shown in Expression 3 may be considered as rotating the input signals by an arbitrary angle of θ that can be represented by the encoding factor a, separating the cosine and sine components (or real and imaginary components) of the rotated signals, assigning positive and negative (+/-) signs to the separated components, and transmitting the separated components through different antennas. For example, the MIMO encoder may encode the input signals S1 and S2 such that the cosine component of the input signal S1 and the sine component of the input signal S2 are transmitted through one transmit antenna and the sine component of the input signal S1 and the cosine component of the input signal S2 to which a negative sign is attached are transmitted through another transmit antenna. The angle, by which the input signals are rotated, changes according to change of the value of the encoding factor "a" and the power distributions of the input signals S1 and S2 become different according to the value of the factor and the angle. Since the power distribution difference can be represented by a distance between symbol coordinates in the constellations, the encoded input signals can be represented by different constellations even when the input signals are received by the receiving side via fully correlated channels such that it is possible to identify and separate the signals, thereby enabling reconstruction of the original input signals.

Specifically, the Euclidian distances of transmission signals change as the power distributions change, the transmission signals received by the receiving side can be represented by identifiable constellations having different Euclidian distances such that it is possible to reconstruct the signals even when the signals have passed through a fully correlated channel. That is, the MIMO encoder can encode the input signal S1 and the input signal S2 into signals having different Euclidian distances according to the value "a" and the receiving side can receive and reconstruct the encoded and transmitted signals using identifiable constellations.

MIMO encoding of the input signals using the above-described MIMO encoding matrix may be represented as Expression 4.

$$[Expression\ 4]$$

$$\begin{pmatrix} X1 \\ X2 \end{pmatrix} = \frac{1}{\sqrt{1+a^2}} \begin{pmatrix} 1 & a \\ a & -1 \end{pmatrix} \begin{pmatrix} S1 \\ S2 \end{pmatrix}$$

In Expression 4, S1 and S2 respectively represent normalized QAM symbols of constellations mapped by symbol mappers on MIMO paths of the input signals S1 and S2. X1 and X2 respectively denote MIMO-encoded symbols. That is, the MIMO encoder can apply the matrix as represented by Expression 4 to the first input signal including the symbols corresponding to S1 and the second input signal including the symbols corresponding to S2 to output a first transmission signal including the symbols corresponding to X1 and a second transmission signal including the symbols corresponding to X2.

The MIMO encoder may perform encoding on input signals using the MIMO encoding matrix described above while additionally adjusting the encoding factor a. That is, it is possible to adjust and optimize the encoding factor "a" taking into consideration additional data reconstruction performance of the MIMO transmission and reception system.

1. First Embodiment: MIMO encoding method that optimizes the encoding factor "a" taking into consideration Euclidian distances (in a fully correlated MIMO channel environment)

It is possible to calculate the encoding factor value "a" taking into consideration the Euclidean distance while using the MIMO encoding matrix. In a MIMO system having two transmit antennas and two receive antennas, when transmission signal St1 is an M-QAM symbol and transmission signal St2 is an N-QAM symbol, a signal St1+St2 that is received by the receiving side via a fully correlated MIMO channel is an (M*N)-QAM signal.

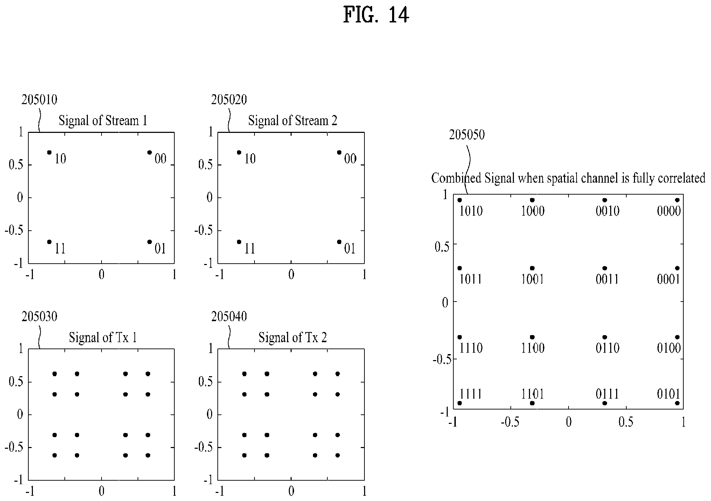

FIG. 14 illustrates input signals and transmission and reception signals when a MIMO encoding method has been performed according to an embodiment of the present invention.

In the embodiment of FIG. 14, an input signal S1 has a constellation 205010 as a 4-QAM symbol and an input signal S2 has a constellation 205020 as a 4-QAM symbol. When the input signal S1 and the input signal S2 are MIMO-encoded using the MIMO encoding matrix, the encoded transmission signals St1 and St2 transmitted through antenna 1 (Tx1) and antenna 2 (Tx2) are 16-QAM symbols and have a constellation 205030 and a constellation 205040 as shown in FIG. 14.

The first embodiment of the present invention suggests a method for optimizing the value "a" such that symbols have the same Euclidian distance in a constellation 205050 of a symbol of a reception signal that has passed through a fully correlated channel as shown in FIG. 14. In FIG. 14, the constellation 205050 of the reception signal is a constellation obtained by adjusting the Euclidean distance using the value "a" as expressed in the following Expression 5. That is, in the case in which input signals are encoded using the MIMO matrix, it is possible to calculate or set the value of the encoding factor "a" such that reception symbols have the same Euclidean distances in a constellation of a reception signal that has passed through a fully correlated channel and to encode the input signals using the calculated or set value "a" of the encoding factor. Such a value "a" may be represented by Expression 5 for each modulation scheme combination.

[Expression 5]

$$a = \begin{cases} 3 & , \text{for QPSK} + \text{QPSK} \\ \left(4+\sqrt{5}\right)/\left(4-\sqrt{5}\right) & , \text{for QPSK} + 16\text{QAM} \\ 0.6 & , \text{for } 16\text{QAM} + 16\text{QAM} \end{cases}$$

In the embodiment of FIG. 14, the constellation 205050 of the reception symbols corresponds to a constellation in which the value "a" has been set to 3 and input signals have been MIMO-encoded through a combination of 4-QAM and 4-QAM (i.e., QPSK+QPSK). That is, the distribution and constellation of the transmission and reception symbols change according to modulation schemes of the reception signals and a combination of the modulation schemes and the Euclidean distance changes according to the distribution and constellation of the symbols and therefore the value "a" for optimizing the Euclidean distance may also change accordingly. Expression 5 also shows an encoding factor value "a" for optimizing the Euclidean distance calculated when transmission and reception signals are a combination of 4-QAM and 16-QAM (i.e., QPSK+16-QAM) and an encoding factor value "a" calculated when transmission and reception signals are a combination of 16-QAM and 16-QAM (i.e., 16-QAM+16-QAM).

In other words, in the first embodiment, the value "a" is set such that the constellation of a signal obtained by summing first and second transmission signals that are obtained by MIMO-encoding first and second 4-QAM input signals, for example, is identical to the constellation of a 16-QAM signal.

In another embodiment of the present invention, a GC subset may be used as a MIMO encoding matrix when MIMO encoding is performed. In this case, the MIMO encoding matrix is represented by Expression 6.

[Expression 6]

$$\begin{bmatrix} \alpha & \alpha\theta \\ i\overline{\alpha} & i\overline{\alpha}\overline{\theta} \end{bmatrix} \begin{bmatrix} S1 \\ S2 \end{bmatrix}, \ \alpha = 1+(1-\theta)i, \overline{\alpha} = 1+(1-\overline{\theta})i, \theta = \frac{1+\sqrt{5}}{2}, \overline{\theta} = \frac{1-\sqrt{5}}{2}$$

Using the encoding matrix of Expression 6 exhibits better performance than the first embodiment of the present invention.

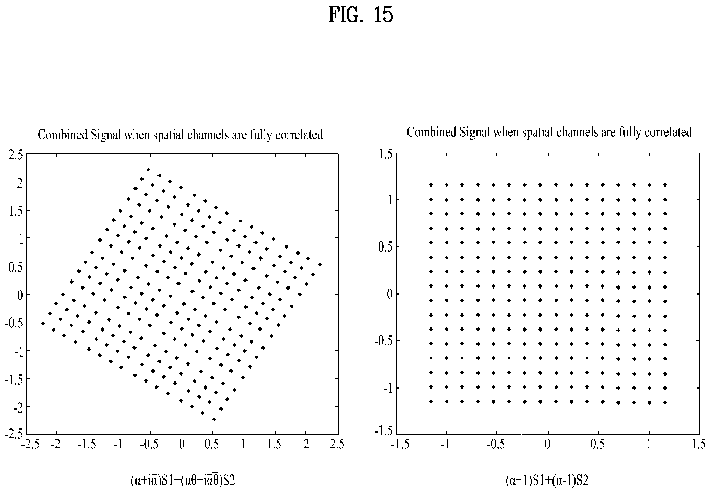

FIG. 15 illustrates a constellation when a GC subset is used as a MIMO encoding matrix and a constellation when the first embodiment is applied.

The constellation of FIG. 15 is a constellation in the case in which a 16-QAM type input signal S1 and 16-QAM type input signal S2 are MIMO-encoded using a MIMO encoding matrix and signals transmitted through 2 transmit antennas are received by a receiver through a fully correlated channel. The left part of FIG. 15 shows a reception constellation when a GC subset is used and the right part shows a reception constellation when the first embodiment is used.

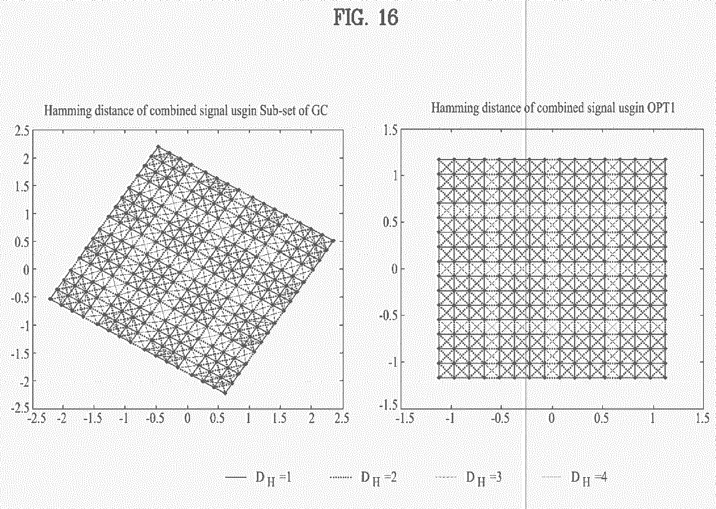

FIG. 16 illustrates a relationship between Euclidean distance and Hamming distance in a constellation when a GC subset is used as a MIMO encoding matrix and in a constellation when the first embodiment is used.

The left shows the constellation when the GC subset is used and the right shows the constellation when the first embodiment is used.

The reason why the SNR performance of the first embodiment is lower than that when the GC subset is used although the minimum Euclidean distance of the first embodiment is greater than when the GC subset is used is associated with the relationship between the Euclidian distance and the Hamming distance.

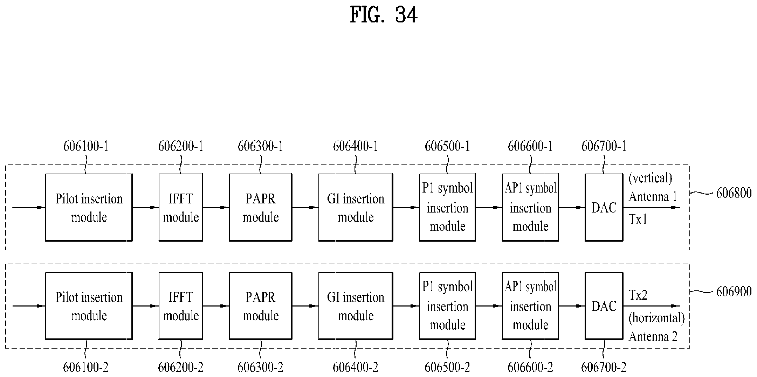

Hamming distance distributions when the first embodiment is applied and when the GC subset is used are similar and have no gray mapping. However, it can be seen from FIG. 34 that the Euclidian distance of a green line pair or a black line pair having a greater Hamming distance when the GC subset is used is greater than that when the first embodiment is applied. That is, although internal Euclidian distances of 4 by 4 16-QAM constellations which are distributed over 16 areas in the total constellation are similar in both cases, the Euclidian distance between the 4 by 4 16-QAM constellations when the GC subset is used is greater, thereby compensating for the Hamming distance performance difference.

Due to such characteristics, the case of using the GC subset exhibits higher BER performance than the case of the first embodiment although the minimum Euclidean distance when the GC subset is used is smaller than when the first embodiment is applied. Accordingly, in the following, the present invention suggests a MIMO encoding method having higher SNR performance or BER performance.

2. Second Embodiment: MIMO encoding method taking into consideration gray mapping in addition to Euclidian distance

The second embodiment suggests a MIMO encoding method in which an encoding factor value "a" is set so as to optimize the Euclidean distance, similar to the first embodiment, and MIMO encoding is performed such that a reception signal that has passed through a fully correlated channel has a gray mapping (or gray mapping form).

In the MIMO encoding method of the second embodiment, at the receiving side, the signs of real and imaginary parts of the input signal S2 among the input signals S1 and S2 may be changed according to a value of the input signal S1 such that each signal becomes a gray mapping signal. Data values included in the input signal S2 may be changed using a method represented by the following Expression 7.

That is, the MIMO encoder may perform MIMO encoding after changing signs of the input signal S2 according to the value of the input signal S1 while using the same MIMO encoding factor as used in the first embodiment. In other words, the sign of the input signal S2 may be determined according to the sign of the input signal S1, and then the MIMO encoding matrix may be applied to the first and second input signals S1 and S2 to output the first and second transmission signals, as described above.

$$[\text{Expression } 7]$$

$$S1 = b_0 b_1 ... b_{N-1}, \quad N = \log_2 M, \quad M = \text{QAM size of } S1$$

$$real(S1) = b_0 b_2 .. b_{N-2}$$

$$imag(S1) = b_1 b_3 .. b_{N-1}$$

$$for \ i = 1...N-1$$

$$si = sq = 1$$

$$if \ i = index \ of \ real(S1) \ and \ b_i = 1$$

$$si = -si$$

$$if \ i = index \ of \ imag(S1) \ and \ b_i = 1$$

$$sq = -sq$$

$$end \ for$$

$$S2 = si \cdot real(S2) + i \cdot sq \cdot imag(S2)$$

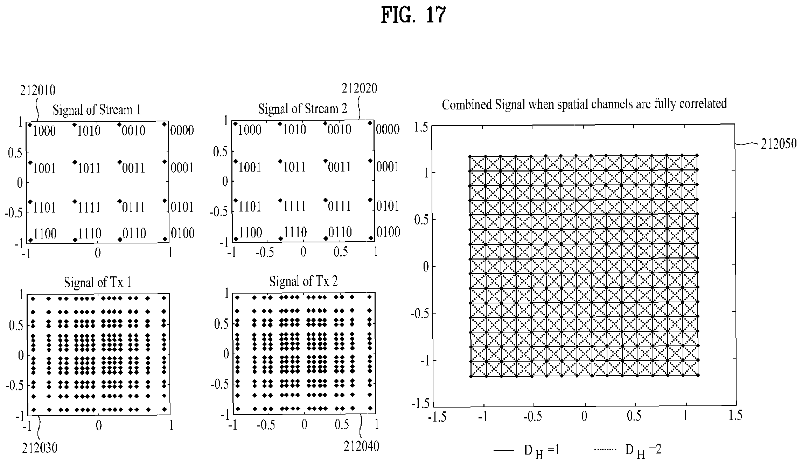

FIG. 17 illustrates input signals and transmission and reception signals when a MIMO encoding method has been performed according to the second embodiment of the present invention.

If bit values assigned to the real and imaginary parts of the input signal S1 212010 among the input signals S1 and S2 212010 and 212020 are XORed as in Expression 7 and the signs of the real and imaginary parts are determined according to the XORed value and transmission signal 1 202030 and transmission signal 2 212040 are transmitted respectively through antenna 1 and antenna 2, then reception symbols of a reception signal 212050, which is received by the receiver via a fully correlated channel, have a gray mapping form such that the Hamming distance between adjacent symbols in the constellation does not exceed 2 as shown in FIG. 17.

since an (M*N)-QAM signal received by the receiver has a minimum Euclidean distance and a gray mapping form, the second embodiment may achieve the same performance as the SIMO scheme even in a fully correlated MIMO channel environment. However, when signals S1 and S2 are acquired by decoding the reception signal at the ML decoder, complexity may be increased since the value of S2 depends on the value of S1 and performance may be degraded due to the correlation between input signals in an uncorrelated MIMO channel.

3. Third Embodiment: MIMO encoding method that sets MIMO encoding factor taking into consideration Hamming distance in addition to Euclidian distance

The third embodiment suggests a method in which MIMO encoding is performed by setting an encoding factor value "a" so as to optimize the Euclidian distance taking into consideration the Hamming distance of a reception signal rather than allowing the entire constellation of the reception signal to have a Euclidian distance as in the first embodiment.

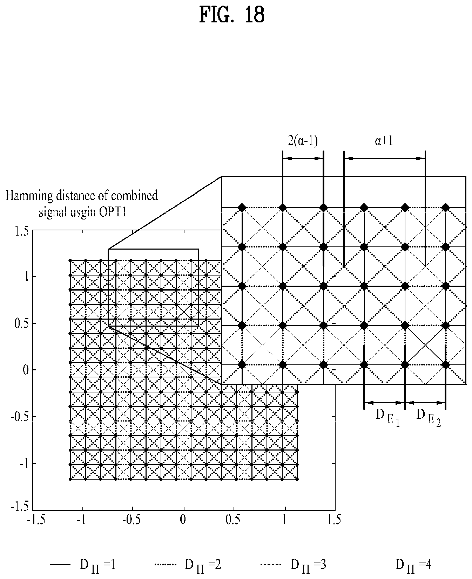

FIG. 18 illustrates a MIMO encoding method according to the third embodiment of the present invention.

FIG. 18 illustrates a relationship between the value of an encoding factor "a" of a MIMO encoding matrix and a Hamming distance in a constellation of a reception signal received through a fully correlated MIMO channel. In the third embodiment, a Hamming distance of interval D_E1 is smaller than a Hamming distance of interval D_E2 in the constellation of the reception signal and therefore the Euclidian distance is adjusted so as to compensate for the Hamming distance difference by maintaining the power difference between the interval D_E1 and the interval D_E2 such that the power of the interval D_E1 is twice the power of the interval D_E2. That is, the Euclidian distance is adjusted so as to compensate for the reconstruction performance difference due to the Hamming distance difference using the power difference.

In the example of FIG. 18, the Hamming distance of the interval D_E2 is twice higher than that of the interval D_E1. That is, the Euclidian distance between adjacent symbols in an interval, whose Hamming distance is twice greater than another interval since the number of bits thereof is twice greater than the other interval, can be increased so as to increase power of the interval, thereby compensating for performance degradation due to the Hamming distance difference when a reception signal is reconstructed. First, a relative Euclidian distance of a reception signal into which 2 transmission signals St1 and St2 received by the receiver are combined as shown in FIG. 18 is determined. It can be seen from the above Expression 1 that the minimum Euclidean distance of a 16-QAM symbol whose power is reduced is 2(a-1) and the minimum Euclidean distance of a 16-QAM symbol whose power is increased is 2(a+1) (since one reception signal is expressed as R = h{(a+1)S1 + (a-1)S2}). It can be seen from FIG. 18 that d_E1 is equal to the Euclidian distance of 16-QAM symbols whose power has been reduced. It can also be seen from FIG. 18 that D_E2 is twice a distance obtained by subtracting 3/2 of the Euclidean distance of 16-QAM symbols whose power has been reduced from 1/2 of the Euclidean distance of 16-QAM symbols whose power has been increased. This may be represented by Expression 8.

$$[Expression\ 8]$$

$$2D_{H_1} = D_{H_2}$$
$$\sqrt{2}D_{E_1} = D_{E_2}$$
$$2\sqrt{2}(a-1) = 2((a+1)-3(a-1))$$
$$a = \frac{\sqrt{2}+4}{\sqrt{2}+2}$$

That is, the MIMO encoder performs MIMO encoding on input signals by distributing different powers to the input signals using the MIMO matrix such that the signals have different Euclidian distances. In this case, the MIMO encoder may perform MIMO encoding by calculating and setting the encoding factor value "a" such that input signals with distributed power have Euclidian distances for compensating for a Hamming distance difference according to the third embodiment.

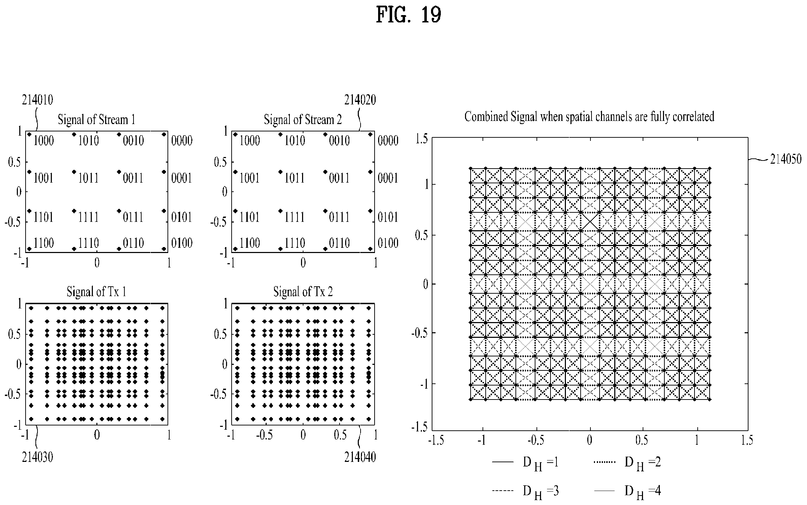

FIG. 19 illustrates input signals and transmission and reception signals when a MIMO encoding method has been performed according to the third embodiment of the present invention.

In the example of FIG. 19, when an input signal S1 (214010) and an input signal S2 (214020) are MIMO-encoded according to the third embodiment, the encoded transmission signals have constellations (214030) and (214040). When the transmission signals are transmitted through a MIMO channel, a reception signal received by the receiver has a constellation 214050. It can be seen from the constellation of the reception signal 214050 that the Euclidean distance has been adjusted according to the Hamming distance.

In the example described above with reference to FIGs. 18 and 19, the value "a" is calculated when the input signal S1 is a 16-QAM signal and the input signal S2 is also a 16-QAM signal. The value "a" of a different modulation scheme may be calculated as shown in Expression 8 using the same principle.

[Expression 9]

$$a = \begin{cases} \sqrt{2}+1 & ,\text{for QPSK} + \text{QPSK} \\ \left(\sqrt{2}+3+\sqrt{5}\right)/\left(\sqrt{2}+3-\sqrt{5}\right) & ,\text{for QPSK} + \text{16QAM} \\ \left(\sqrt{2}+4\right)/\left(\sqrt{2}+2\right) & ,\text{for 16QAM} + \text{16QAM} \end{cases}$$

Here, it is assumed that, in the case of QPSK+16-QAM MIMO, the values suggested above are obtained when power of the input signals S1 and S2 has been normalized to 1 after the input signals S1 and S2 are QAM-modulated through QPSK and 16-QAM, respectively, at the symbol mapper. When the power has not been normalized, the value "a" may be modified accordingly.

In addition, in the case of QPSK+16-QAM, a value of 4.0 other than the above-suggested values may be used as the value "a". The reason for this is that the combined signal can represent all input signals S1 and S2 even when the SM scheme is applied in a fully correlated channel environment. In this case, a value of 4.0 or a value close to 4.0 may be used instead of the value calculated using Expression 9 in order to compensate a high code rate of the outer code.

When the second embodiment and the third embodiment are compared with reference to the above descriptions and charts, it can be seen that the second embodiment exhibits the same performance as SIMO in a fully correlated MIMO channel environment and thus does not suffer any performance loss, thereby solving the problems of the MIMO scheme in a fully correlated MIMO channel environment. However, in the second embodiment, input signals S1 and S2 are not independent of each other due to MIMO encoding such that the signal S2 changes according to the signal S1, thereby causing performance degradation in an uncorrelated channel. Accordingly, iterative ML detection may be used in order to solve the problem that reception and decoding errors of the signal S1 are reflected in the signal S2, causing an additional decoding error of the signal S2.

In the iterative ML detection method, an outer code is included in an iterative loop and a detection error of the signal S1 is reduced using a soft posteriori probability value of the signal S1 output from an outer port as an a priori probability value of the ML detector, thereby reducing the probability of application of the detection error of the signal S1 for detection of the signal S2. This method allows the MIMO encoding method of the second embodiment to exhibit performance of the SIMO system in a fully correlated MIMO channel environment and exhibit performance of the SIMO system in an uncorrelated MIMO channel environment.

In the MIMO encoding method of the third embodiment, a reception signal received through a fully correlated MIMO channel is designed taking into consideration both the Hamming distance and the Euclidian distance. Accordingly, the MIMO encoding method of the third embodiment not only has better performance in a fully correlated MIMO channel but also has no performance loss compared to the SM scheme in an uncorrelated MIMO channel such that it is possible to use both MIMO transmission and reception gains. In this case, there is an advantage in implementation of the receiver since the receiver has complexity similar to the SM scheme.

Power imbalance may occur between signals that are transmitted through respective communication paths when MIMO transmission and reception is performed. That is, signals transmitted through a plurality of transmission antennas may be received by a receiver with different powers. In the worst case, only a signal transmitted by one transmission antenna may be received by the receiver. The following is a description of a MIMO encoding method which can minimize performance degradation in such a power imbalance situation. Especially, a MIMO encoding method in which MIMO encoding is performed by additionally taking into consideration a power imbalance situation while using the MIMO encoding matrix of the present invention having an encoding factor as described above.

4. Fourth Embodiment: MIMO encoding method for minimizing encoding factor value "a" taking into consideration Euclidian distance of transmission signal

The value "a" may be calculated taking into consideration the Euclidian distance of the transmission signal while using the MIMO encoding matrix described above. In a MIMO system having 2 transmission antennas and 2 reception antennas, when an input signal S1 is an M-QAM symbol and an input signal S2 is an N-QAM symbol, a signal S1+S2 received by a receiving side via a fully correlated MIMO channel is an (M*N)-QAM signal.

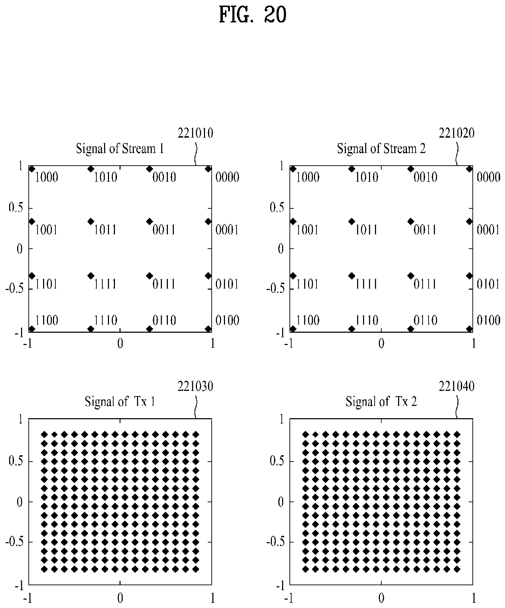

FIG. 20 illustrates input signals and transmission and reception signals when a MIMO encoding method has been performed according to the fourth embodiment of the present invention.

In the embodiment of FIG. 20, the input signal S1 has a constellation 221010 as a 16-QAM symbol and the input signal S2 has a constellation 221020 as a 16-QAM symbol. If the input signal S1 and the input signal S2 are MIMO-encoded using the MIMO encoding matrix, the encoded transmission signals St1 and St2 transmitted through antenna 1 (Tx1) and antenna 2 (Tx2) are 256-QAM symbols and the constellations of the encoded transmission signals have no minimum Euclidean distance. Although the value "a" may be determined by optimizing the Euclidian distance with reference to a reception signal as described above in the first embodiment, this may degrade decoding performance in a power imbalance situation. Accordingly, if the Euclidian distance is optimized with reference to transmission signals from the transmitting side, it is possible to minimize performance degradation that occurs in a power imbalance situation at the receiving side. The value "a" for optimizing the Euclidian distance with reference to transmission signals may be represented by Expression 10.

[Expression 9]

$$a = \begin{cases} 2 & , \text{for QPSK} + \text{QPSK} \\ 4 & , \text{for 16QAM} + \text{16QAM} \end{cases}$$

When the value "a" determined according to Expression 10 is used, i.e., when the value "a" is set to 4 and MIMO encoding is performed using the same in the example of FIG. 20, the transmission signals St1 and St2 have a constellation 221030 and a constellation 221040, respectively. From the constellations 221030 and 221040 of the transmission signals St1 and St2, it can be seen that the Euclidian distance is distributed uniformly. Accordingly, it can be understood that, when the MIMO encoding method of the fourth embodiment is used, it is possible to minimize reception performance degradation since the Euclidian distance of the transmission signals received in a power imbalance situation has been optimized.

However, a different value needs to be used when symbol types of input signals are different as in the QPSK+16-QAM transmission method. The reason for this is that, when modulation schemes of input signals used for MIMO transmission are different, a trade-off problem occurs such that, if the optimized value "a" is used for one transmission antenna, then a signal having relatively low performance is transmitted through another transmission antenna.

2. Fifth Embodiment: MIMO encoding method taking into consideration gray mapping in addition to Euclidian distance of transmission signal

The fifth embodiment suggests a MIMO encoding method in which an encoding factor value "a" is set so as to optimize the Euclidean distance of the transmission signal, similar to the fourth embodiment, and MIMO encoding is performed such that a transmission signal that has passed through a fully correlated channel has a gray mapping (or gray mapping form) in a power imbalance situation.

In the MIMO encoding method of the fifth embodiment, the signs of real and imaginary parts of the input signal S2 among the input signals S1 and S2 may be changed according to a value of the input signal S1 such that each transmission signal becomes a gray mapping signal. Similar to the second embodiment, data values included in the input signal S2 may be changed using a method represented by Expression 6 described above.

Bit values assigned to the real and imaginary parts of the input signal S1 among the input signals S1 and S2 may be XORed as in Expression 6 and the signs of the real and imaginary parts may be determined according to the XORed value and transmission signal 1 and transmission signal 2 having a gray mapping form may then be transmitted respectively through antenna 1 and antenna 2.

Since a (M*N)-QAM signal transmitted by the transmitting side has a minimum Euclidean distance and a gray mapping, the fifth embodiment may achieve the same performance as the SIMO scheme even in a power imbalance situation. However, when signals S1 and S2 are acquired by decoding the reception signal at the ML decoder, complexity may be increased since the value of S2 depends on the value of S1.

3. Sixth Embodiment: MIMO encoding method taking into consideration Hamming distance in addition to Euclidian distance of transmission signal

In the sixth embodiment, an encoding factor value "a" is set so as to optimize the Euclidian distance taking into consideration the Hamming distance of a transmission signal rather than allowing the entire constellation of the transmission signal to have a Euclidian distance as in the fourth embodiment. Specifically, it is possible to design an encoding matrix such that the square of the Euclidian distance between adjacent constellation points when the Hamming distance between the adjacent constellation points is 2 is twice the square of the Euclidian distance between the points when the Hamming distance is 1. That is, the Euclidian distance is adjusted such that a reconstruction performance difference due to a Hamming distance difference can be compensated for using a power difference.

Assuming that the transmission signal has a constellation shown in FIG. 18, a Hamming distance of interval D_E1 is 1/2 of a Hamming distance of interval D_E2 and therefore the Euclidian distance can be adjusted so as to compensate for the Hamming distance difference by maintaining the power difference between the interval D_E1 and the interval D_E2 such that the power of the interval D_E1 is twice the power of the interval D_E2. That is, the Hamming distance of the interval D_E2 is twice higher than that of the interval D_E1. Specifically, the Euclidian distance between adjacent symbols in an interval, whose Hamming distance is twice greater than another interval since the number of bits thereof is twice greater than the other interval, can be increased so as to increase power of the interval, thereby compensating for performance degradation due to the Hamming distance difference when a reception signal is reconstructed.

A description will be given of the method of setting value "a" in more detail.

For example, in a transmission signal, since a Hamming distance in a section between internal symbols representing a first input signal in constellations corresponds to half a Hamming distance in an inter-symbol section between constellations representing the first input signal, the Euclidean distance can be adjusted such that the Hamming distance difference is compensated by maintaining the power of the internal section twice that of a neighboring section. In other words, the neighboring section has a Hamming distance twice that of the internal section. That is, in neighboring symbols, the number of different bits in one symbols is twice the number of different bits in the other. The Euclidean distance can be increased such that the section having a double Hamming distance has higher power to as to compensate for performance deterioration due to a Hamming distance difference when a received signal is restored. In other words, it is possible to compensate for a restoration performance difference caused by a Hamming distance difference with a power difference by adjusting the Euclidean distance.

Relative Euclidean distances for signals St1 and St2 transmitted from a transmitter are detected in constellations. It can be determined from the above-mentioned equation 2 that a minimum Euclidean distance of a 16-QAM symbol having decreasing power is (a-1) and a minimum Euclidean distance of a 16-QAM symbol having increasing power is (a+1) (because one transmitted signal is represented as R=h{a+1}S1+(a-1)S2}). The value "a" may be obtained using the above conditions, which may be represented by Expression 11.

$$[\text{Expression 11}]$$

$$a = \begin{cases} \sqrt{2}+1 & ,\text{for QPSK}+\text{QPSK} \\ \sqrt{2}+3 & ,\text{for 16QAM}+\text{16QAM} \end{cases}$$

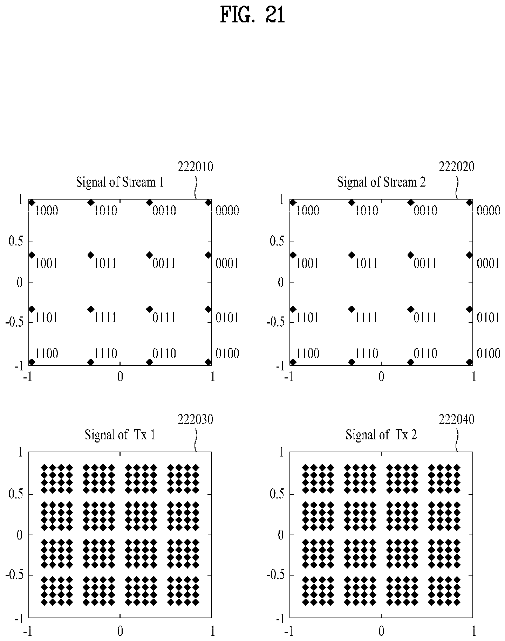

FIG. 21 illustrates input signals and transmission signals on which a MIMO encoding method according to a third embodiment of the present invention has been performed.

In the embodiment of FIG. 21, an input signal S1 corresponds to 16-QAM symbols and has a constellation 222010, whereas an input signal S2 corresponds to 16-QAM symbols and has a constellation 222020. When the input signal S1 and the input signal S2 are encoded using a MIMO encoding matrix including an encoding parameter set according to the third embodiment, encoded transmission signals St1 and St2, which are transmitted through antenna 1 (Tx1) and antenna 2 (Tx2), become 256-QAM symbols and respectively have constellations 208030 and 208040 having Euclidean distances taking Hamming distance into account. Furthermore, the transmission signals have symbol distributions having the Euclidean distances taking the hamming distance into account, and thus performance loss can be minimized even when a receiver receives and decodes only one of the transmission signals in a power imbalance situation.

However, when the input signals have different symbol types as in a QPSK+16-QAM transmission method, it is necessary to use different values 'a'. This is because, if a value 'a' optimized for one of the transmission antennas is used, a signal having lower quality may be transmitted through the other transmission antenna when different modulation schemes are employed for the input signals used for MIMO transmission, that is, trade-off may be generated.

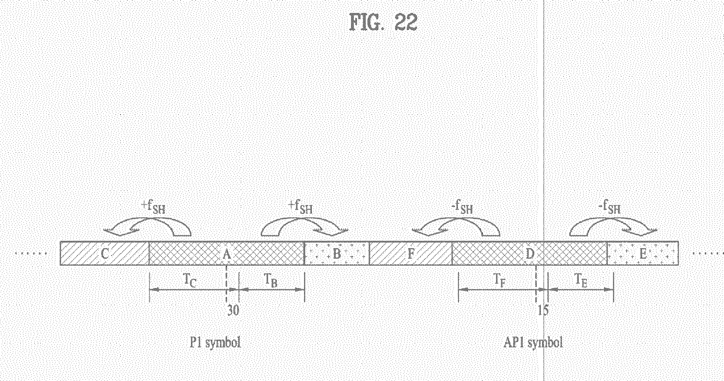

Fig. 22 illustrates an exemplary structure of a P1 symbol and an exemplary structure of an AP1 symbol according to an embodiment of the present invention.

P1 symbol is generated by having each of a front portion and an end portion of an effective (or valid) symbol copied, by having a frequency shift performed as much as +$f_{sh}$, and by having the frequency-shifted copies respectively positioned at a front portion (C) and an end portion (B) of the effective symbol (A). In the present invention, the C portion will be referred to as a prefix, and the B portion will be referred to as a postfix. More specifically, P1 symbol is configured of a prefix portion, an effective symbol portion, and a postfix portion.

In the same manner, AP1 symbol is generated by having each of a front portion and an end portion of an effective (or valid) symbol copied, by having a frequency shift performed as much as -$f_{sh}$, and by having the frequency-shifted copies respectively positioned at a front portion (F) and an end portion (E) of the effective symbol (D). In the present invention, the F portion will be referred to as a prefix, and the E portion will be referred to as a postfix. More specifically, AP1 symbol is configured of a prefix portion, an effective symbol portion, and a postfix portion.

Herein, the two frequency-shift values $+f_{sh}$, $-f_{sh}$, which are used in the P1 symbol and the AP1 symbol, may have the same absolute value yet be given opposite signs. More specifically, the frequency-shift is performed in opposite directions. And, the lengths C and F, which are copied to the front portion of the effective symbol, may be set to have different values. And, the lengths B and E, which are copied to the end portion of the effective symbol, may be set to have different values. Alternatively, the lengths C and F may be set to have different values, and the lengths B and E may be set to have the same value, or vice versa. According to another embodiment of the present invention, an effective symbol length of the P1 symbol and an effective symbol length of the AP1 symbol may be differently determined. And, according to yet another embodiment of the present invention, a CSS (Complementary Set Sequence) may be used for tone selection and data scrambling within the AP1 may be scrambled by AP1.

According to the embodiment of the present invention, the lengths of C and F, which are copied to the front portion of the effective (or valid) symbol, may be set to have different values, and the lengths of B and E, which are copied to the end portion of the effective (or valid) symbol, may also be set to have different values.

The C,B,F,E lengths according to the present invention may be obtained by using Equation 12 shown below.

```
[Expression 12]

Length of C (T_C) = {Length of A (T_A)/2 + 30}

Length of B (T_B) = {Length of A (T_A)/2 - 30}

Length of E (T_F) = {Length of D (T_D)/2 + 15}

Length of E (T_E) = {Length of D (T_D)/2 - 15}
```

As shown in Equation 12, P1 symbol and AP1 symbol have the same frequency shift value. However, each of the P1 symbol and the AP1 symbol are given opposite signs. Additionally, in order to determine the lengths of C and B, the present invention determines an offset value being added to or subtracted from a value corresponding to the length of A $(T_A)$/2. And, in order to determine the lengths of F and E, the present invention determines an offset value being added to or subtracted from a value corresponding to the length of D $(T_D)$/2. Herein, each of the offset values is set up differently. According to the embodiment of the present invention, the offset value of P1 symbol is set to 30, and the offset value of AP1 symbol is set to 15. However, the values given in the above-described examples are merely exemplary. And, therefore, it will be apparent that the corresponding values may easily be varied or changed by anyone skilled in the art. Thus, the present invention will not be limited only to the values presented herein.

According to the present invention, by generating AP1 symbol and an AP1 symbol to configure the structure shown in Fig. 22, and by inserting the generated symbols to each signal frame, the P1 symbol does not degrade the detection performance of the AP1 symbol, and, conversely, the AP1 symbol does not degrade the detection performance of the P1 symbol. Additionally, the detection performance of the P1 symbol is almost identical to the detection performance of the AP1 symbol. Furthermore, by configuring the symbols so that the P1 symbol and the AP1 symbol have similar symbol structures, the complexity level of the receiver may be reduced.

At this point, the P1 symbol and the AP1 symbol may be transmitted consecutively, or each of the symbols may be allocated to different positions within the signal frame and may then be transmitted. And, in case the P1 symbol and AP1 symbol are each allocated to a different position within the signal frame, so as to be transmitted, a high time diversity effect may be gained with respect to the preamble symbol. According to the embodiment of the present invention, the P1 symbol and the AP1 symbol are consecutively transmitted. In that case, the AP1 symbol, according to Fig. 3, transmits information necessary for decoding signaling information spread in a pilot pattern or a frame of a data area. It can be generated in Fig. 5.

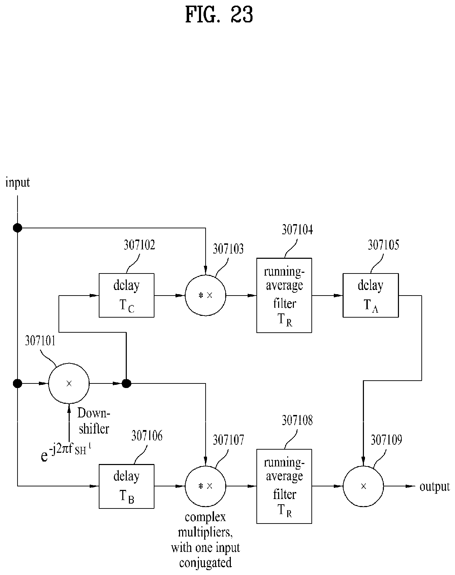

Fig. 23 illustrates an exemplary structure of a P1 symbol detector according to an embodiment of the present invention. The P1 symbol detector may be included in the OFDM demodulator(107100) explained in Fig. 2.

Herein, the P1 symbol detector may also be referred to as a C-A-B preamble detector. The P1 symbol detector may include down shifter (307101), 1st conjugator (307103) and 2nd delayer (307106).

The down shifter (307101) performs inverse modulation by multiplying

$$e^{-j2\pi f_{SH}t}$$

by the input signal. When inverse modulation is performed by the down shifter (307101), the signal being frequency-shifted and inputted is recovered to the original signal. The inverse modulated signal may be outputted to a 1st delayer (307102) and a 2nd conjugator (307107).

The 1st delayer (307102) delays the inverse-modulated signal by a length of part C ($T_C$) and then outputs the delayed signal to the 1st conjugator (307103). The 1st conjugator (307103) performs complex-conjugation on the signal, which is delayed by a length of part C ($T_C$). Then, the 1st conjugator (307103) multiplies the input signal by the complex-conjugated signal, thereby outputting the processed signal to a 1st filter (307104). The 1st filter (307104) uses a running average filter having the length of $T_R=T_A$, so as to remove (or eliminate) any excessively and unnecessarily remaining modulation elements, thereby outputting the processed signal to a 3rd delayer (307105). The 3rd delayer (307105) delays the filtered signal by a length of part A (i.e., effective (or valid) symbol) ($T_A$), so as to output the delayed signal to a multiplier (307109).

The 2nd delayer (307106) delays the input signal by a length of part B ($T_B$) and then outputs the delayed signal to the 2nd conjugator (307107). The 2nd conjugator (307107) performs complex-conjugation on the signal, which is delayed by a length of part B ($T_B$). Then, the 2nd conjugator (307107) multiplies the complex-conjugated signal by an inverse-modulated signal, thereby outputting the processed signal to a 2nd filter (307108). The 2nd filter (307108) uses a running average filter having the length of $T_R=T_A$, so as to remove (or eliminate) any excessively and unnecessarily remaining modulation elements, thereby outputting the processed signal to the multiplier (307109).

The multiplier (307109) multiplies the output of the 2nd filter (307109) by a signal, which is delayed by a length of part A ($T_A$). Thus, a P1 symbol may be detected from each signal frame of the received broadcast signal.

Herein, the length of part C ($T_C$) and the length of part B ($T_B$) may be obtained by applying Equation 12 shown above.

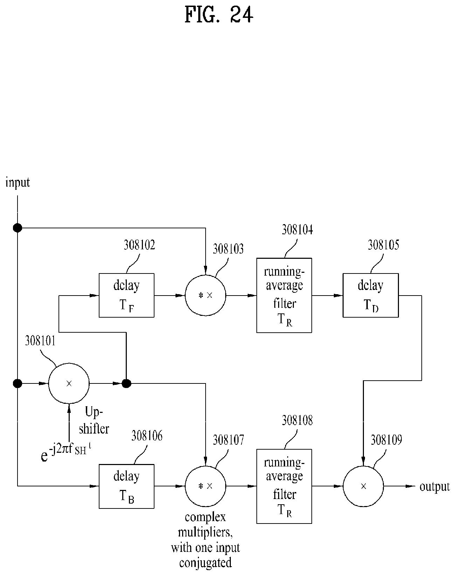

Fig. 24 illustrates an exemplary structure of an AP1 symbol detector according to an embodiment of the present invention. The AP1 symbol detector may be included in the OFDM demodulator(107100) explained in Fig. 2.

Herein, the AP1 symbol detector may also be referred to as an F-D-E preamble detector. The AP1 symbol detector may include down shifter (308101), 1st conjugator (308103) and 2nd delayer (308106). The AP1 symbol detector may receive a signal inputted to broadcast signal receiver or a signal outputted from the P1 symbol detector explained in FIG. 23.

The up-shifter (308101) performs inverse modulation by multiplying

$$e^{j2\pi f_{SH'}}$$

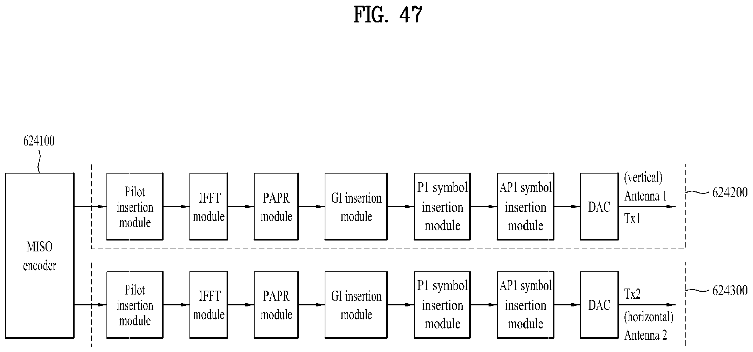

by the input signal. When inverse modulation is performed by the up-shifter (308101), the signal being frequency-shifted and inputted is recovered to the original signal. More specifically, the up-shifter (308101) of Fig. 47 has the same structure as the down-shifter (307101) of the P1 symbol detector (306601). However, the frequency direction of each inverse modulation process is completely opposite to one another. The signal that is inverse modulated by the up-shifter (308101) may be outputted to a 1st delayer (308102) and a 2nd conjugator (308107).

The 1st delayer (308102) delays the inverse-modulated signal by a length of part F ($T_F$) and then outputs the delayed signal to the 1st conjugator (308103). The 1st conjugator (308103) performs complex-conjugation on the signal, which is delayed by a length of part F ($T_F$). Then, the 1st conjugator (308103) multiplies the input signal by the complex-conjugated signal, thereby outputting the processed signal to a 1st filter

(308104). The 1st filter (308104) uses a running average filter having the length of $T_R=T_D$, so as to remove (or eliminate) any excessively and unnecessarily remaining modulation elements, thereby outputting the processed signal to a 3rd delayer (308105). The 3rd delayer (308105) delays the filtered signal by a length of part D (i.e., effective (or valid) symbol) ($T_D$), so as to output the delayed signal to a multiplier (308109).

The 2nd delayer (308106) delays the input signal by a length of part E ($T_E$) and then outputs the delayed signal to the 2nd conjugator (308107). The 2nd conjugator (308107) performs complex-conjugation on the signal, which is delayed by a length of part E ($T_E$). Then, the 2nd conjugator (308107) multiplies the complex-conjugated signal by an inverse-modulated signal, thereby outputting the processed signal to a 2nd filter (308108). The 2nd filter (308108) uses a running average filter having the length of $T_R=T_D$, so as to remove (or eliminate) any excessively and unnecessarily remaining modulation elements, thereby outputting the processed signal to the multiplier (308109).

The multiplier (308109) multiplies the output of the 2nd filter (308109) by a signal, which is delayed by a length of part D ($T_D$). Thus, an AP1 symbol may be detected from each signal frame of the received broadcast signal. Herein, the length of part F ($T_F$) and the length of part E ($T_E$) may be obtained by applying Equation 12 shown above.

As shown in Fig. 3, a frame according to an embodiment of the present invention comprises a preamble area and a data area. The preamble are comprises a P1 and P2 and there can be a plurality of data symbols in the data area.

Also, as the designer intends, there can be an AP1 in the preamble area.

Then, P1 signaling information is transmitted by the P1 symbol, the AP1 signaling information is transmitted by the AP1 symbol, and L1-pre and L1-post signaling information is transmitted by the P2 symbol.

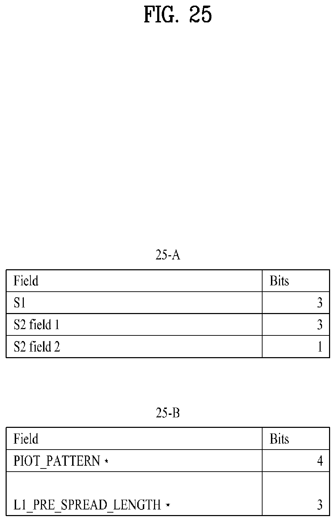

Fig. 25A and B show P1 signaling information and AP1 signaling information according to an embodiment of the present invention.

Fig. 25A shows a table diagram having P1 signaling information according to an embodiment of the present invention.

As shown in Fig. 25A, the P1 signaling information includes a S1 field and S2 field. The further description is as follows.

The S1 field has a size of 3 bits and indicates a preamble format and P2 type.

The S2 field has a size of 4 bits and can have S2 field 1 and 2.

S2 field 1 field has a size of 3 bits and indicates partial information about FFT size information and guide interval (GI). FFT size indicates the number of sub-carriers to comprise one OFDM symbol and the GI size indicates the ratio of GI in one OFDM symbol. Thus, the length of an OFDM symbol can be varied depending on the FFT and GI size.

S2 field 2 field has a size of 1 bin and indicates whether the preamble of the frame is the same type.

Fig. 25B shows a table having the AP1 signaling information according to an embodiment of the present invention.

As shown in Fig. 25B, the AP1 signaling information includes a PILOT_PATTERN field and L1_PRE_SPREAD_LENGTH field. The further description is as follows.

The PILOT_PATTERN field has a size of 4 bits and indicates a pilot pattern of the frame. According to an embodiment of the present invention, when the pilot pattern information is transmitted through the AP1 symbol, the P2 symbol is not transmitted. Even when L1 signaling information is spread in the data symbols in the data area, the receiver can discover the pilot pattern before decoding the L1 signaling information of the data area.

L1_PRE_SPEAD_LENGTH field has a size of 3 bits and indicates the length of a spreading interval in the data area for the L1-pre signaling information. That is, it indicates the number of data symbols in the data area having the spreading interval for the L1 pre signaling information. According to the present invention, the spreading interval for L1 pre signaling information is called L1-pre spread interval. If L1_PRE_SPREAD_LENGTH field value is "000", it means that L1 signaling information in a data area of a frame is not spread.

Fields having P1 signaling information and AP1 signaling information and themselves are illustrated for the better understanding of the present invention and each field and information can be varied as the designer intends..

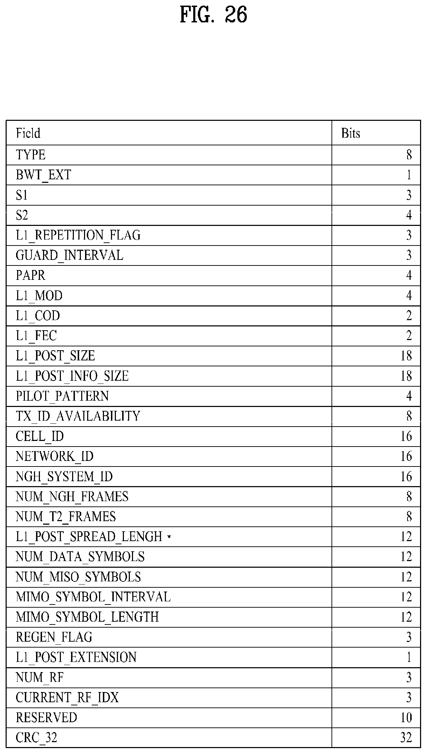

Fig. 26 shows another embodiment of the present invention for L1-pre signaling information. As shown in Fig. 6, L1-pre signaling information includes information necessary for decoding L1 post signaling.

L1-pre signaling information shown in Fig. 26 is shown as an embodiment of Fig. 6 and description for the same fields as in Fig. 6 are omitted.

In the following, fields that are not illustrated in Fig. 6 are only described. The size and table of each filed can be added or modified as the designer intends.

NUM_T2_FRAMES field has a size of 8 bits and indicates the number of frames for the existing terrestrial broadcast system in the super frame. The receiver determines a structure of the super frame by the field. The frame is used to calculate information necessary for hopping a frame that can transmit additional data or data about a new broadcast system other than the existing broadcast systems.

L1_POST_SPREAD_LENGTH field has a size of 12 bits and indicates the length of a spreading interval in the data area for L1-post signaling information. That is, it indicates the number of the data symbols having the spreading interval for the L1-post signaling information. In the present invention, the spreading interval for L1-post signaling information is called L1-post spread interval. If the value of L1_POST_SPREAD_LENGTH field is all 0, L1_post signaling information is not spread.

NUM_MISO_SYMBOLS field has a size of 12 bits and indicates the number of MISO symbols in the data symbols of the current frame.

MIMO_SYMBOL_INTERVAL field has a size of 12 bits and indicates the number of MIMO symbols between two MIMO symbol parts.

MIMO_SYMBOL_LENGTH field has a size of 12 bits and indicates the number of MIMO symbols in one MIMO symbol part.

Fig, 27 shows another embodiment of L1-post signaling information.

As shown in Fig. 7, the L1-post signaling information comprises a configurable block, a dynamic block, an extension block, a Cyclic Redundancy Check block (CRC) and a L1 padding block.

A table shown in Fig. 27 is a part of the configurable block and description for the same fields as in Fig. 7 are omitted.

In the following, fields that are not illustrated in Fig. 7 are only described.

The size and table of each filed can be added or modified as the designer intends.

Fields included in frequency loop are as follows.

NEXT_NGH_SUPERFRAME field has a size of 8 bits and indicates the number of super frames between the current frame and the next NGH frame.

Fields included in PLP loop are as follows.

PLP_PROFILE field has a size of 2 bits and indicates profile of stream included in the current PLP. That is, PLP_PROFILE field may indicate whether the current PLP is PLP of a base layer or PLP of an enhancement layer.

PLP_MIMO_TYPE field has a size of 2 bits and determines whether the current PLP is the MIMO or MISO type.

As an embodiment, PLP_MOD field value is determined by combining with PLP_MIMO_TYPE field. If the PLP_MIMO_TYPE field value indicates the MISO type, the PLP_MOD field is used for symbol-remapping. If the PLP_MIMO_TYPE field value indicates the MIMO type, the PLP_MOD field can be interpreted as a constellation size having a spectrum effect generated after indicating MIMO.

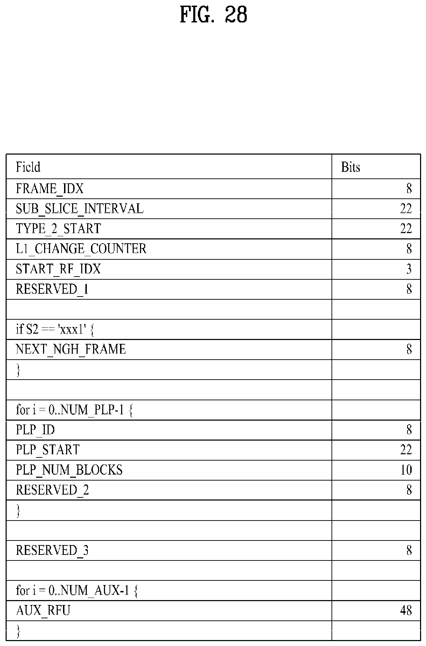

Fig. 28 shows another embodiment of L1-post dynamic signaling information.

A table shown in Fig. 28 is a part of the dynamic block and description for the same fields as in Fig. 8 are omitted.

In the following, fields that are not illustrated in Fig. 8 are only described. The size and table of each filed can be added or modified as the designer intends.

NEXT_NGH_FRAME field has a size of 8 bits and is used only when the LSB of the S2 field is 1, that is, when S2 is "xxx1". NEXT_NGH_SUPERFRAME field indicates the number of FEF frames or frames between the first frame and the next in a super frame having additional transmitting frames. NEXT_NGH_FRAME and NEXT_NGH_SUPERFRAME are used for calculating the necessary amount for hopping the next frame. That is, NEXT_NGH_FRAME field and the NEXT_NGH_SUPERFRAME field have only FEF or many mixed regular frames. When all the FEF frames are not used for additional frames, an efficient hopping mechanism will be provided. Especially, the receiver can perform hopping in the next additional frame without decoding P1 signaling information in all the frames in the super frame.

An embodiment of a broadcast signal transmitter or receiver for MIMO processing is as follows.

The broadcast signal transmitter comprises as shown in Fig. 1 an input processor 101200, a BIC< encoder 101300, a frame builder 101400, and an OFDM generator 101500. Also, the broadcast signal receiver, as shown in Fig. 2, comprises an OFDM demodulator 107100, a frame demapper 107200, a BICM decoder 107300, and an output processor 1073400.

The input processor 101200 of the broadcast signal transmitter executes FEC encoding for transmitting data in a form of block. The BICM encoder 101300 performs encoding for correcting errors. The frame builder 101400 performs mapping data in a frame, and the OFDM generator 101500 performs OFDM demodulating in the frame-mapped data into symbol units and transmit the data. Devices in the broadcast signal receiver can perform reverse-functioning corresponding to the counterpart devices in the transmitter.

The present invention suggests a broadcast signal transmitter or receiver that independently applies MISO or MIMO processing for each PLP from a plurality of PLP inputs. According to the present invention, the present invention can effectively adjust the quality of service (QOS) or services from PLP in a physical layer.

Four embodiments for performing MISO/MISO processing in a plurality of signals from the transmitter and receiver through a plurality of antennas are as follows.

A first embodiment is about a broadcast signal transmitter or a corresponding receiver independently performing MISO or MIMO processing for each PLP data input during a BICM encoding process.

A second embodiment is about another broadcast signal transmitter or a corresponding receiver independently performing MISO or MIMO processing for each PLP data input during a BICM encoding process.

A third embodiment is about a broadcast signal transmitter or a corresponding receiver independently performing MISO or MIMO processing for mapped PLP data input during a OFDM generating process.

A fourth embodiment is about a broadcast signal transmitter or a corresponding receiver independently performing MISO or MIMO processing for each PLP data input during a BICM encoding process, wherein an OFDM generator performs MISO processing in MISO PLP data and L1-signaling information.

In more detail, the BICM encoder of the broadcast signal transmitter according to the first embodiment performs MISO encoding or MIMO encoding in PLP data after constellation-mapping, cell interleaving, and time interleaving. Also, the BICM decoder of the broadcast signal transmitter according to the first embodiment can reverse the whole process.

According to the second embodiment, the BICM encoder of the broadcast signal transmitter according to the second embodiment performs MISO encoding or MIMO encoding in PLP data after constellation-mapping, and then performs cell interleaving and time interleaving. Also, the BICM decoder of the broadcast signal transmitter according to the second embodiment can reverse the whole process.

According to the third embodiment, the OFDM generator of the broadcast signal transmitter performs MISO or MIMO encoding in PLP data transmitted from a frame builder.

According to the fourth embodiment, the BICM encoder of the broadcast signal transmitter according to the fourth embodiment performs MISO encoding or MIMO encoding in PLP data after time interleaving or constellation-mapping. Also, the OFDM generator of the broadcast signal transmitter performs MISO encoding in MISO PLP data for MISO processing and L1-signaling information. The BICM decoder of the broadcast signal receiver and the OFDM demodulator of the broadcast signal transmitter according to the fourth embodiment can reverse the whole process.

A broadcast signal transmitter/receiver according to each embodiment is as follows. The broadcast signal transmitter/receiver can perform MIMO processing for a plurality of signals through a plurality of antennas. The broadcast signal transmitter/receiver with two signals by two antennas is described below.

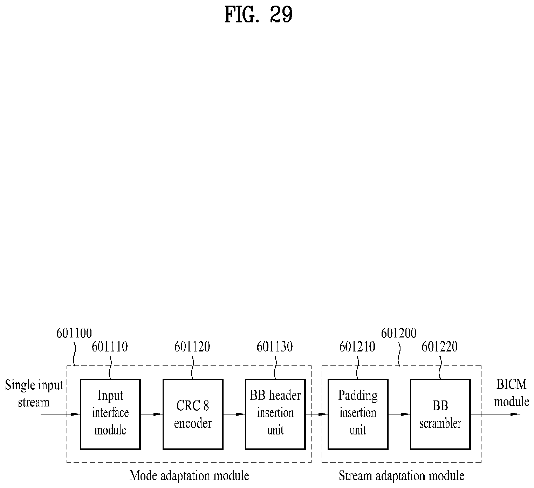

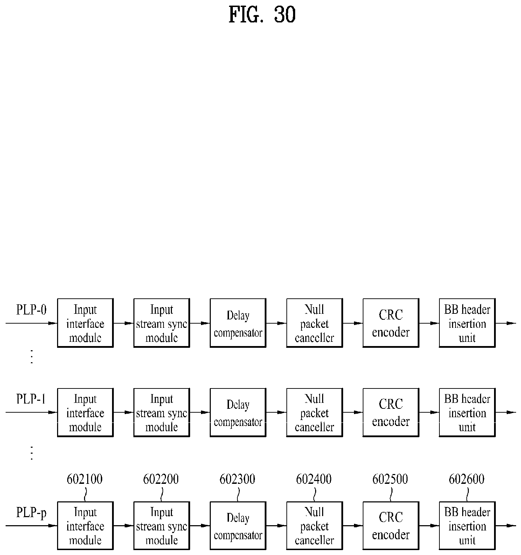

Fig. 29 and Fig. 30 show an input process that the broadcast signal transmitter comprises in common. Further description is as follows.

Fig. 29 shows an input processor of the broadcast signal transmitter according to an embodiment.

The input process 101200 in Fig. 1 is shown as an embodiment in Fig. 29 performing only one PLP. The input processor in Fig. 29 comprises a mode adaptation module 601100 and a stream adaptation module 601200. The mode adaptation module 601100 further comprises an input interface module 601110, a CRC-8 encoder 601120 and a BB header insertion module 601130, wherein a stream adaptation module 1020 comprises a padding insertion module 601210 and a BB scrambler 601220.

The input interface module 601110 in the input processor performing a single PLP performs mapping by distinguishing the input bit stream in a logical unit to perform FEC (BCH/LDPC) encoding at the end of the BICM encoder. The CRC-9 encoder 601120 performs CRC encoding in the mapped bit stream and a BB header insertion module 1050 inserts a BB header in the data field. In that case, the BB header includes all adaptation type (TS/GS/IP) information, user packet length information, and data field length.

Also, if the input data does not have a BB frame for FEC encoding, the stream adaptation block 601200 generates a padding insertion unit and a Pseudo Random Binary Sequence (PRBS) and includes a BB scrambler 601220 randomizing data computed by the PRBS and XOR. Such a move by the BB scrambler 601220 can ultimately lower the Peak-to-Average Power Ratio of the OFDM-modulated signal.

Fig. 30 shows a mode adaptation module as an input processor of the broadcast signal transmitter performing a plurality of PLP. The mode adaptation module in Fig. 30 comprises a plurality of input interface modules 602100 performing mode adaptation for each PLP in parallel, an input stream synchronizer 602200, a compensating delay module 602300, null packet deletion module 602400, a CRC-0 encoder 602500, and a BB header insertion unit 602600. The description of the input interface module 6021000, the CRC-8 encoder 602500 and the BB header insertion unit 602600 illustrated in Fig. 19 is omitted.

The input stream synchronizer 602200 inserts timing information necessary for restoring input stream clock reference information (ISCR), transport stream (TS) or generic stream (GS). The compensating delay module 602300 synchronizes a group of PLP based on the timing information.

The null packet deletion module (602400) deletes null packet that is unnecessarily transmitted and inserts the number of the deleted null packets based on the deleted position.

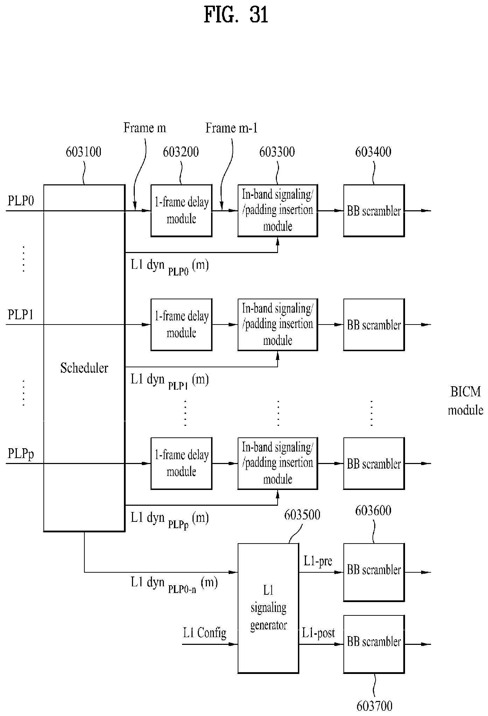

Fig. 31 shows a stream adaptation module as an input processor of the broadcast signal transmitter performing a plurality of PLP.

The stream adaptation module in Fig. 31 receives the data in PLP units from the mode adaptation in Fig. 30.

The scheduler 603100 performs scheduling for the MIMO transmitting system using a plurality of antennas including dual polarity and generates parameters for a demultiplexer, a cell interleaver, a time interleaver. Also, the scheduler 603100 transmits L1-dynamic signaling information for the current frame besides in-band signaling, and performs cell mapping based on the scheduling.

A plurality of a 1-frame delay module 603200 executing a plurality of PLP delays one frame so that scheduling information of the next frame for in-band signaling can be included in the current frame. A plurality of in-band signaling/padding insertion module inserts L1-dynamic signaling information to the delayed data. Also, if there is any room for padding, the in-band signaling/padding insertion module 603300 inserts padding bits and in-band signaling information into the padding area. And, the BB scrambler 603400 generates a pseudo random binary sequence (PRBS) as shown in Fig. 29 and randomizes the data by computing the PRBS with XOR.

The stream adaption module in Fig. 31 generates L1-signaling information transmitted by the preamble symbol of the frame or the spread data symbol. Such L1-signaling information includes L1-pre signaling information and L1-post signaling information. The L1-pre signaling information includes parameters necessary for performing the L1-post signaling information and static L1-signaling information, and the L1-post signaling information includes the static L1-signaling information and dynamic L1-signaling information. The L1-signaling generator 603500 can transmit the generated L1-pre signaling information and L1-post signaling information. The transmitted L1-pre signaling information and L1-post signaling information is scrambled by each BB scramble 603600, 603700. Also, according to another embodiment, the L1 signaling generator 603500 transmits L1-signaling information having L1-pre signaling and L1-post signaling information and scrambles L1-signaling information transmitted by one BB scrambler.

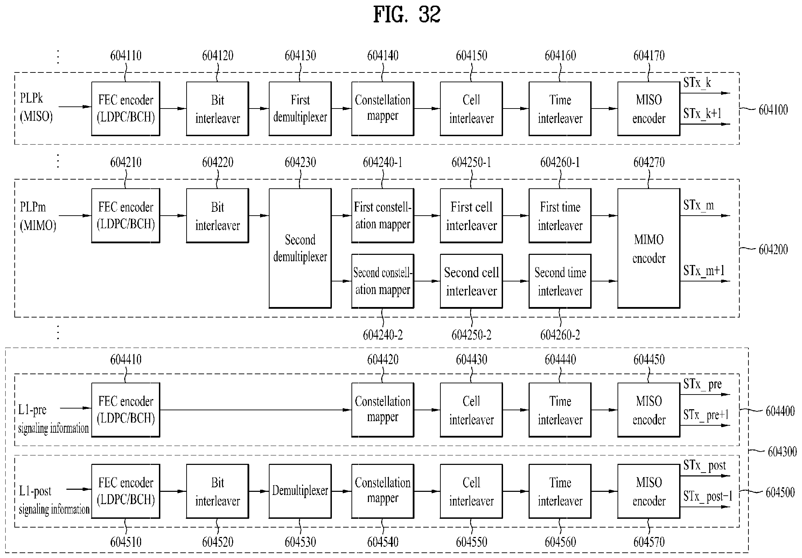

Fig. 32 and Fig. 34 show a structure block of a broadcast signal transmitter according to an embodiment. Further description is as follows.

Fig. 32 shows a BICM encoder according to a first embodiment of the present invention.

The BICM encoder shown in Fig. 32 is an embodiment of the BICM encoder 101300 in Fig. 1.

The BICM encoder according to the first embodiment performs bit-interleaving in a plurality of PLP data after performing input-processing, L1-pre signaling information, and L1-post signaling information, and encoding for correcting errors.

Also, the BICM encoder independently performs MISO and MIMO encoding in PLP data. That is, the BICM encoder in Fig. 32 includes a first BICM encoding block 604100 performing MISO encoding in PLP data, a second BICM encoding block 604200 performing MIMO encoding in PLP data, and a third BICM encoding block 604300 performing MIMO encoding in signaling information. However, as the signaling information includes information necessary for restoring PLP data in a frame from the receiver, more robustness is required between the transmitter and receiver compared to PLP data. Thus, an embodiment of the present invention is the MISO process performing the signaling information.

The description of data performing process for each block is as follows.

First, the first BICM encoding block 604100 includes a BICM encoder 604100, a FEC (Forward Error Correction) encoder 604110, a bit-interleaver 604120, a first demultiplexer 604130, a constellation mapper 604140, a cell interleaver 604150, a time interleaver 604160, and a MISO encoder 604170.

The FEC encoder 604110 performs BCH encoding and LDPC encoding in PLP data after performing input processing with redundancy to correct channel errors from the receiver. The bit-interleaver 604120 prepares to have robustness for bust errors by performing bit-interleaving in the FEC-encoded PLP data by each FEC block unit. In that case, the bit interleaver can perform bit interleaving by using two FEC block units. When using two FEC blocks, a pair of cell units may be generated from two different FEC blocks in the frame-builder. Thus, the broadcast signal receiver may improve the reception by ensuring the diversity of FEC blocks.

A first demultiplexer 604130 can perform demultiplexing in the bit-interleaved PLP data into one FEC block unit. In that case, the first demultiplexer 604130 uses two FEC blocks and performs demultiplexing. When using the two blocks, pairs of cells in the frame builder may be generated from different FEC blocks. Thus, the receiver can improve reception by ensuring the diversity of FEC blocks.

The constellation mapper 604140 performs mapping in the bit-demultiplexed PLP data into symbol units. In that case, the constellation mapper 604140 can rotate a certain angle depending on the modulation type. The rotated constellation mappers can be expressed in I-phase (In-phase) and Q-phase (Quadrature-phase), and the constellation mappers can delay only the Q-phase for a certain value. Then, the constellation mapper 604140 performs re-mapping in the In-phase element with the delayed Q-phase element.

The cell interleaver 604150 performs interleaving in the re-mapped data into cell units, and the time interleaver 604160 performs interleaving in the cell-interleaved PLP data into time units.

In that case, the time interleaver 604160 uses two FEC blocks for interleaving. Through this process, as pairs of cells are generated from two different FEC blocks, the receiver can improve reception by ensuring the diversity of the FEC blocks.

The MSIO encoder 604170 performs MISO encoding by using MISO encoding matrix in the time-interleaved PLP data and transmits MISO PLP data through two routes (STx_k, STx_k+1). The present invention includes an OSTBC (Orthogonal Space-Time Block Code)/OSFBC(Orthogonal Space Frequency Block Code/Alamouti code) as an embodiment of a MISO encoding method.

The second BICM encoding block 604200 includes a FEC encoder 604210, a bit-interleaver 604220, a second demultiplexer 604230, a first constellation mapper 604240-1 and a second constellation mapper 604240-2, a first cell interleaver 604250-1 and a second interleaver 604250-2, and a first time interleaver 604260-1 and a second cell interleaver 604260-2 and a MIMO encoder 604270. The FEC encoder 604210 and the bit-interleaver 604220 can perform the same function as the FEC encoder 604110 and the bit-interleaver 604120 of the MISO method.

The second demultiplexer 604230 can transmit the PLP data by demultiplexing to two routes necessary for MIMO transmission in addition to performing the same function as the first demultiplexer 604130 of the MISO method. In that case, the character of the data transmission for each route may be different. Thus, the second demultiplexer can randomly allocate the bit-interleaved PLP data into each route.

The first constellation mapper 604240-1 and the second constellation mapper 604240-2 can operate the same function as the constellation mapper (604140) of the MISO method.

The first cell interleaver (604250-1) and the second cell interleaver (604250-2) can perform cell-interleaving in only a half of the PLP data in one of the FEC blocks from the routes. Thus, the first interleaver 603260-1 and second interleaver 603260-2 can operate the same as the cell interleaver 604150. Also, in order to execute data from a plurality of routes, as the first cell interleaver 604250-1 and the second cell interleaver 604250-2 are not allocated additional memory, there is an advantage of performing cell interleaving by using the memory of the cell interleaver 604150. The first time interleaver 603260-1 and the second time interleaver 603260-2 can operate the same as the time interleaver 603260 of the MISO method. In that case, the first time interleaver 603260-1 and the second time interleaver 603260-2 can be performed the same time interleaving or a different time interleaving.

The MIMO encoder 604270 performs MIMO encoding in the time-interleaved PLP data from by using MIMO encoding matrix and transmit MIMO PLP data to two routes (STx_m, STx_m+1).

The MIMO encoding matrix of the present invention includes a spatial multiplexing, a Golden code (GC), a full-rate full diversity code, and a linear dispersion code. Also, the MIMO encoder 604170 performs MIMO encoding by using MIMO encoding matrix according to the first and sixth embodiment of the present invention in Fig. 14 and Fig. 21.

L1-signaling information includes L1-pre signaling information and L1-post signaling information. It can independently perform MISO encoding in the L1-pre signaling information and L1-post signaling information.

Thus, the third BICM encoding block 604300 includes a first encoding block 604400 executing the L1-pre signaling information and the second encoding block 604500 executing the L1-post signaling information.

The first encoding block 604400 includes a FEC encoder 604470, a constellation mapper 604420, a cell interleaver 604430, a time interleaver 604560, and a MISO encoder 604570.

The L1-pre signaling information includes information necessary for decoding L1-post signaling information and the L1-post signaling information includes information necessary for restoring data transmitted from the receiver.

That is, the receiver needs to decode the L1-pre signaling information quickly and correctly for decoding the L1-signaling information and the data. Thus, the receiver of the present invention does not perform bit-interleaving and de-multiplexing for the L1-pre signaling information in order to perform the fast decoding.

The description of first encoding block 604500 and the second encoding block 604600 is omitted because they perform the same function as the first BICM block 604100.

As a result, to execute the L1-pre signaling information, the first encoding block 604400 performs MISO encoding in the L1-pre signaling information and transmits the free-signaling data to two routes (STx_pre, STx_pre+1). Also, to execute L1-post signaling information the second encoding block 604500 performs MISO encoding in the L1-post signaling information and transmits the L1-post signaling data to two routes (STx_post, STx_post+1).

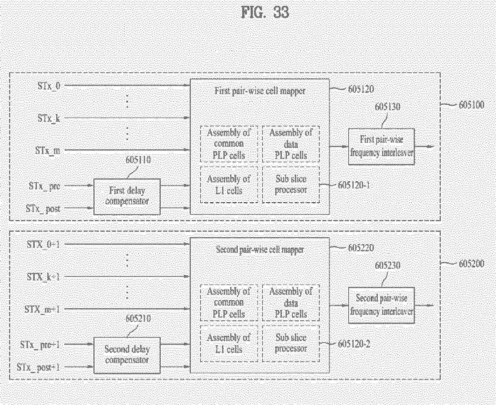

Fig. 33 shows a frame builder according to a first embodiment.

The frame builder shown in Fig. 33 is an embodiment of the frame builder 101400 shown in Fig. 1.

The first BICM encoding block 604100 transmits MISO PLP data to two routes (STx_k, STx_K+1) and the second BICM encoding block (604200) transmits MIMO PLP data to two routes (STx_m, STx_m+1). Also, the third BICM encoding block (604300) transmits the L1-pre signaling information and the L1-post signaling information to two routes (STx_pre, Stx_pre_1 and STx_post, STx_post+1).

Each data is inputted into the frame builder. In that case, as shown in Fig. 33, the frame builder includes a first route receiving the BICM encoded data from STx_0 to STx_post, and a second route receiving the BICM encoded data from STx_0+1 to Stx_post+1. The data received in the first route is transmitted through a first antenna (Tx_1) and the data in the second route is transmitted through a second antenna (Tx_2).

As shown in Fig. 33, the frame builder according the first embodiment includes a first frame building block 605100 executing the data from the first route and a second frame building block 605200 executing the data from the second route. The first frame building block 605100 includes a first delay compensator 604110, a first pair-wise cell mapper 605120, and a first pair-wise frequency interleaver 605300-1, and a second frame building block 605200 includes a second delay compensator 605100-2 executing the data from the second route, a second pair-wise cell mapper 605200-2, and a second pair-wise frequency interleaver 605300-2.

The first pair-wise cell mapper 605120 and the first pair-wise frequency interleaver 605130, or the second pair-wise cell mapper 605120 and the second pair-wise frequency interleaver 605310 operate independently but the same functions in the first and the second routes respectively.

A method of performing data in the first frame building block 605100 and the second frame building block 605200.

The first delay compensator 605110 and the second delay compensator 605110 can compensate the L1-pre signaling data or the L1-post signaling data for the delay in the first frame and by the BICM encoder 604300. The L1-signaling information can include information not only in the current frame but also in the next frame. Thus, during the input processing, the L1-signaling information can be delayed one frame as opposed to PLP data inputted in the current frame. Through this process, one frame of the L1-signaling information having information about the current and the next frames.

The first pair-wise cell mapper 605120 and the second pair-wise cell mapper 605220 can perform mapping in the PLP data and the L1-signaling data in symbol units into cell units in a frame in the sub-carrier of the OFDM symbols.

In that case, the PLP data includes a common PLP DATA, a MISO/MIMO encoded PLP data and a sub-slice processor module 605120-1~2 performs frame-mapping in the PLP data in cell units for the diversity effect.

Also, the first pair-wise cell mapper 605120 and the second pairwise cell mapper 605220 can perform frame-mapping in two consecutive inputted cells in pairs.

For the better restoration performance of MISO signals, coherence between MSI transmitting channels should be secured when performing MISO encoding. Thus, in order to secure coherence, the first pair-wise cell mapper 605120 and the second pair-wise cell mapper 605220 pair up cells generated from the same PLP and perform OFDM modulating in the paired-up cells. Then coherence between the channels will be maximized.In other words, according to an embodiment of the present invention, as the MISO encoder is positioned in the front of the BICM encoder, the structure of the frames is in pairs considering such MISO encoding process.

As mentioned above, when performing bit-interleaving or time interleaving by the bit-interleaver 604120 and the time interleaver 604160 using two FEC blocks, two paired up cells can be generated from two different FEC blocks. As the receiver ensures diversity, higher reception can be obtained. The first pair-wise frequency interleaver 605130 and the second pair-wise frequency interleaver 605230 perform frequency interleaving in the data in cell units from each route and transmits the frequency-interleaved data to the OFDM generator through each route.

In that case, the first pair-wise frequency interleaver 605130 and the second pair-wise frequency interleaver 605230 pair up two consecutive cells in interleaving units and then perform frequency interleaving. This is to maximize coherence between channels.

Fig. 34 shows an OFDM generator according to a first embodiment.

The OFDM generator in Fig. 34 is an embodiment of the OFDM shown in Fig. 1.

The present invention transmits broadcast signals by the MISO/MIMO method through two antennas. The OFDM generator in Fig. 34 receives and demodulates the broadcast signals through a first and a second route. It then transmits the signals to two antennas (Tx1, Tx2).

A first OFDM generating block 606800 modulates the broadcast signals through the first antenna (Tx1) and a second OFDM generating block 606900 modulates the broadcast signals through the second antenna (TX2).

If channel correlation between the first and second antennas is large, transmitted signals can apply polarity depending on the channel correlation. In the present invention, such a method is called polarity multiplexing MIMO. The first antenna is called "vertical antenna" and the second antenna is called "horizontal antenna". The first OFDM generating block 606100 performs OFDM modulating in broadcast signals through the first antenna (Tx1) and the second transmitter 606900 performs OFDM modulating in the broadcast signals from the first route and transmits the signals to the second antenna (Tx2).

Modules including the first OFDM generating block 606800 and the second OFDM generating block 606900 are as follows.

The first OFDM generating block 606800 includes a pilot insertion module 606100-1, an IFFT module 606200-1, a PAPR module 606300-1, a GI insertion module 606400-1, a P1 symbol insertion module 606500-1, an AP1 symbol insertion module 606600-1 and a DAC 606700-1, wherein modules in the first transmitting unit 606800 operate the same functions.

The second OFDM generating block 606900 includes a pilot insertion module 606100-2, an IFFT module 606200-2, a PAPR module 606300-2, a GI insertion module 606400-2, a P1 symbol insertion module 606500-2, an AP1 symbol insertion module 606600-2 and a DAC 606700-2, wherein modules in the first transmitting unit 606800 operate the same functions.

Thus, modules in the first OFDM generating block 606800 will be illustrated in more detail. The pilot insertion module inserts a pilot of the predetermined pilot pattern into a frame and transmits it to the IFFT module 606200-1. The pilot pattern information is transmitted with AP1 signaling information or L1-signaling information.

The IFFT module 606200-1 performs IFFT algorithm in the signals and transmits them to the PAPR module 606300-1.

The PAPR module 606300-1 reduces PAPR of the signals in a time domain and transmits them to the GI insertion module 606400-1. Also, feedback on necessary information based on the PAPR reduction algorithm is given to the pilot insertion module 606100-1.

The GI insertion module 606400-1 copies the end of the effective OFDM symbol, inserts guard intervals in cyclic prefix to each OFDM symbol, and transmits them to the P1 symbol insertion module 606500-1. The GI information can be transmitted through the P1 signaling information or L1-pre signaling information.

The P1 and AP1 symbol are inserted in every frame of the P1 insertion module in the OFDM generator. That is, the P1 insertion module can insert more than two preamble symbols in every frame. When using more than two preamble symbols, burst fading that can happen in the mobile fading conditions will be more strengthened and signal detection performance will be improved.

The P1 symbol insertion module 606500-1 inserts a P1 symbol in the beginning of each frame and transmits it to the AP1 symbol insertion module 606600-1.

The AP1 symbol insertion module 606600-1 inserts an AP1 symbol at the end of the P1 symbol and transmits it to the DAC 606700-1.

The DAC 606700-1 converts the signal frame having the P1 symbol to an analog signal and transmits it to the transmitting antenna (Tx1).

According to the second embodiment of the present invention, a structure block of a broadcast signal transmitter is illustrated as follows.

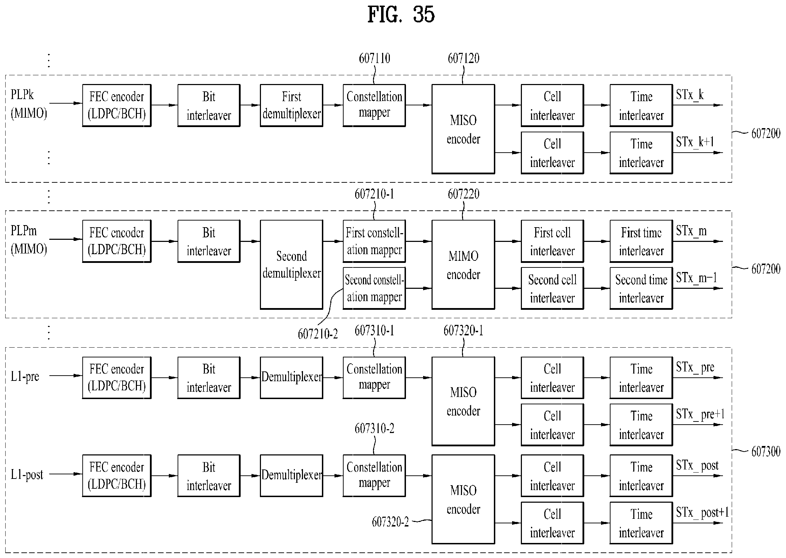

Fig. 35 shows a BICM encoder according to the second embodiment.

The BICM encoder shown in Fig. 35 is an embodiment of the BICM encoder 101300 in Fig. 1.

The BICM encoder according to the second embodiment performs bit-interleaving in a plurality of PLP data after performing input-processing, L1-pre signaling information, and L1-post signaling information, and encoding for correcting errors.

Also, the BICM encoder independently performs MISO and MIMO encoding in PLP data.

The BICM encoder in Fig. 35 includes a first BICM encoding block 607100 performing MISO encoding in PLP data, a second BICM encoding block 607200 performing MIMO encoding in PLP data, and a third BICM encoding block 607300 performing MIMO encoding in signaling information.

As the BICM encoding blocks in Fig. 35 operate the same as the BICM encoding blocks in Fig. 32, further description of them is omitted. However, the BICM encoding blocks of the MISO encoder 607120, 6074320-1~2 and the MIMO encoder 607320 are positioned at the end of the constellation mapper 607110, 6071210-1~2, 607310-1~2, which is distinguishable from the BICM encoding blocks according to the first embodiment.

The PLP data and the signaling information are performed into symbol units after the constellation mapping. Thus, the cell interleaver, time interleaver, MISO encoder, and MIMO encoder in the BICM encoding block according to the first embodiment in Fig. 32 and the BICM encoding block according to the second embodiment in Fig. 35 can perform the inputted data into symbol units. Also, the broadcast signal receiver performs the reverse process for the received data. Also, the MISO decoder, MIMO decoder and time deinterleaver and cell deinterleaver of the broadcast signal receiver can perform the input data in symbol units.

However, the BICM decoder according to the first embodiment performs MISO/MIMO first and then outputs the data in bit units. It is because the output data of the MISO/MIMO decoder can the probability information of bit units. Thus, although the BICM decoder can perform time deinterleaving or cell deinterleaving, information about symbol units is required because the output data will be imputed in bit units. Therefore, the memory complexity of the broadcast signal receiver will increase because it should store information about symbol mapping of the input bits during the deinterleaving process.

As shown in Fig. 35, in the BICM encoder according to the second embodiment I the MISO encoder 607100, 607300, 607400 and the MIMO encoder 607200 are located at the end of the constellation mapper. Thus, the BICM decoder can perform MISO/MIMO decoding after time deinterleaving and cell deinterleaving in symbol units. Thus, the memory complexity will be reduced compared to the broadcast signal receiver according to the first embodiment.

As the frame builder and the OFDM generator according to the second embodiment in Fig. 33 and Fig. 34 operate the same as the frame builder and the OFDM generator according to the first embodiment, the further description is omitted.

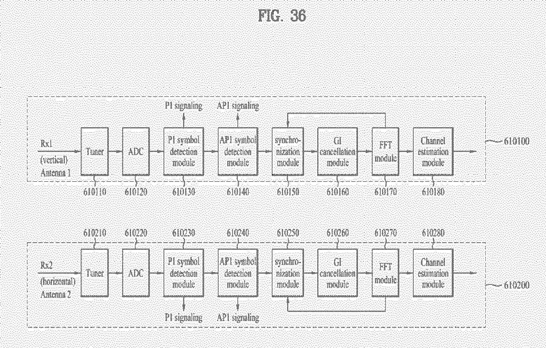

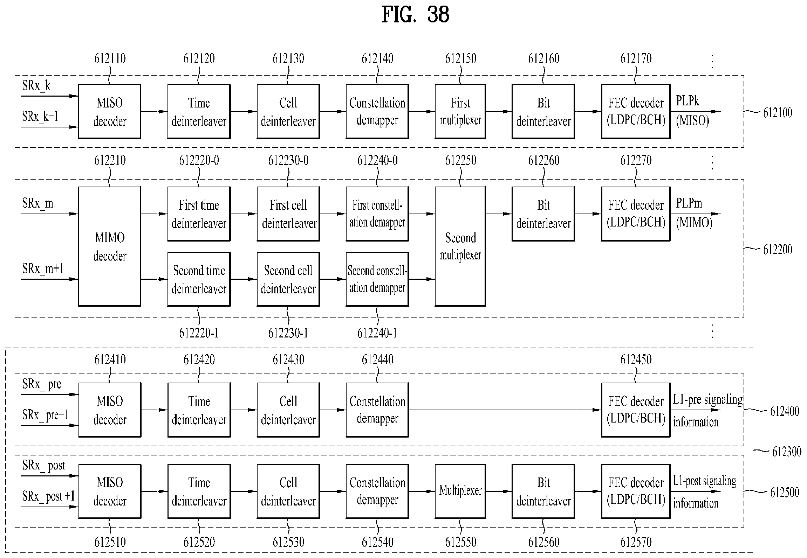

Fig. 36 and Fig. 38 show a structure block of the broadcast signal receiver according to the first embodiment.

Fig. 36 shows an OFDM demodulator according to the first embodiment of the present invention.

Fig. 36 shows a drawing of the OFDM demodulator according to the first embodiment.

The OFDM modulator shown in Fig. 36 is an embodiment of the OFDM demodulator 107100 illustrated in Fig. 2.

According to an embodiment of the present invention, the present invention requires two antennas, Rx1 and Rx2, to receive transmitted signals by MIMO/MISO. The OFDM demodulator shown in Fig. 36 can perform OFDM demodulation through the Rx1 and Rx2 antennas.

A block demodulating transmitted signals through a first antenna (Rx1) is called a first OFDM demodulating block 610100 and a block demodulating transmitted signals through a second antenna (Rx2) is called a second OFDM demodulating block 610200.

In addition, the present invention can utilize polarity multiplexing MIMO according to an embodiment of the present invention. The first OFDM demodulating block 610100 performs OFDM demodulation in the broadcast signals transmitted through the first antenna (Rx1) and outputs the signals by a frame demapper to a first route, and the second demodulating block 610200 performs OFDM demodulating in the broadcast signals transmitted through the second antenna (Rx2) and outputs the signals by a frame demapper to a second route.

Also, the OFDM according to the first embodiment in Fig. 36 can perform the reverse process of the OFDM generator according to the first embodiment. Modules including the first OFDM demodulating block 610100 and the second OFDM demodulating block are as follows.

The first OFDM demodulating block 610100 includes a tuner 610110, an ADC 610120, a P1 symbol detection module 610130, an AP1 symbol detection module 610140, a synchronizing module 610150, a GI cancellation module 610160, a FFT module 610170 and a channel estimation module 610180.

The second OFDM demodulating block 610200 comprises a tuner 610210, an ADC 610220, a P1 symbol detection module 610230, an AP1 symbol detection module 610240, a synchronizing module 610250, a GI cancellation module 610260, a FFT module 610270 and a channel detection module 610280, and operates the same as the first OFDM demodulating block 610100.

Thus, modules in the first OFDM demodulating block 610100 will be further illustrated.

The tuner 610110 receives broadcast signals by selecting a frequency range and transmits it to the ADC 610120 by compensating the size of the signal.

The ADC 610120 coverts analog broadcast signals into digital signals and transmits them to the P1 symbol detection module 610130.

The P1 symbol detection module 610130 extracts P1 symbols in the P1 signaling information and decodes the P1 signaling information. Also, the P1 symbol detection module 610130 transmits the decoded P1 signaling information to the synchronizing module 610150 and a system controller (not shown in the drawing). The system controller determines which frame the received signal has by using the decoded P1 signaling information and controls other devices.

The AP1 symbol detection module 610140 extracts AP1 symbols in the AP1 signaling information and decodes the AP1 signaling information. Also, the AP1 symbol detection module 610140 transmits the decoded AP1 signaling information to the synchronizing module 610150 and a system controller (not shown in the drawing). The system controller determines the pilot pattern information in the current frame and L1-pre spread interval information by using the decoded AP1 signaling information.

The synchronizing module 610150 performs time and frequency synchronizing by using the decoded P1 signaling information and the AP1 signaling information.

The GI cancellation module 610160 deletes guard intervals included in the synchronized signals and transmits them to the FFT module 610170.

The FFT module 610170 converts the signals from the time domain to the frequency domain by performing FFT algorithm.

The channel detection module 610180 detects a transmitting channel from the transmitting antenna to the receiving antenna by using pilot signals having the converted signals. Then, the channel detection module 610180 can additionally perform equalizing for each of the received data. Signals that are converted into the frequency domain will be inputted in the frame demapper.

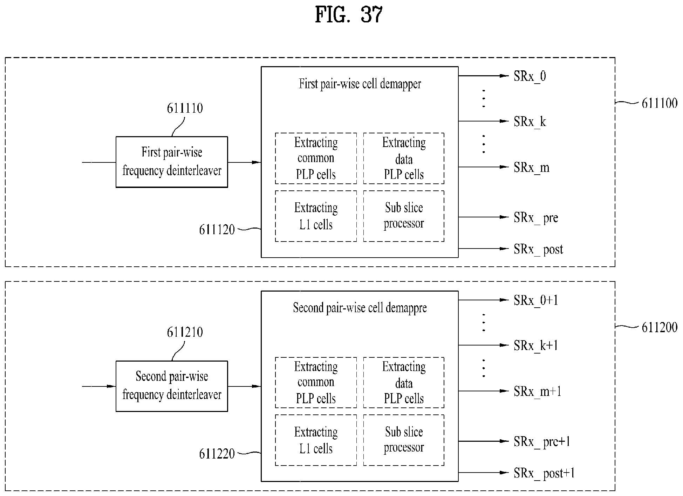

Fig. 37 shows a frame demapper according to the first embodiment of the present invention.

The frame demapper in Fig. 37 is an embodiment of the frame demapper 107200 in Fig. 2.

The frame demapper according to the first embodiment includes the first frame demapping block 611100 executing data from a first route and a second frame demapping block 611200 executing data from a second route. The first frame demapping block 611100 includes a first pair-wise frequency deinterleaver 611110 and a first pair-wise cell demapper 611120, and the second demapping block 611200 includes a second pair-wise frequency deinterleaver 611210 and a second pair-wise cell demapper 611220.

Also, the first pair-wise frequency deinterleaver 61110 and the first pair-wise cell demapper 611120 or the second pair-wise frequency deinterleaver 611210 and the second pair-wise cell demapper 611220 can operate independently and the same through a first route and a second route respectively.

Also, the frame demapper according to the first embodiment can perform the reverse process of the frame builder according to the first embodiment in Fig. 33.

A method of performing data by blocks included in the first frame builder demapping block 611100 and the second frame builder demapping block 611200 is as follows.

The first pair-wise frequency deinterleaver 611110 and the second pair-wise frequency deinterleaver 611210 perform deinterleaving in data in the frequency domain through the first and seoncd routes into cell units in that case, the first pair-wise frequency deinterleaver 611110 and the second frequency deinterleaver 611210 pair up two consecutive cells in deinterleaving units and perform frequency deinterleaving. The deinterelaving process can be performed in a reverse direction of the interleaving process in the transmitting unit. The frequency-deinterleaved data will be transmitted in the original order.

The first pair-wise cell demapper 611120 and the second pair-wise cell demapper 611220 can extract common PLP data, PLP data and L1-signaling information in cell units from the de-interleaved data. The extracted PLP data includes MISO PLP data for the MISO method and MIMO PLP data for the MIMO method, and the extracted L1-signaling data includes information necessary for the current and next frames. Also, if the transmitter performs sub-slicing in the PLP data, the first and the second pair-wise cell demappers 611120, 611220 can merge the sliced PLP data and generate it in one stream.

Also, the first pair-wise cell demapper 611120 and the second pair-wise cell demapper 611220 can pair up two consecutive cells.

Data transmitted through the first route is inputted to the BICM decoder by the route from SRx_0 to SRx_post and data transmitted through the second route is inputted to the BICM decoder by the route from SRx_0+1 to SRx_post+1.

Fig. 38 shows a BICM decoder according to the first embodiment.

The BICM decoder in Fig. 38 is an embodiment of the BICM decoder 107300 shown in Fig. 2.

The BICM decoder according to the first embodiment receives data from the first route via SRx_0 to SRx_post by a frame demapper and data from the second route via SRx_0+1 to SRx_post+1 and performs BICM decoding.

Also, the BICM decoder according to the first embodiment independently performs MISO/MIMO encoding in each of the data.

That is, the BICM decoder in Fig. 38 includes a first BICM decoding block 612100 performing MISO PLP data from SRx_k and SRx_k+1, a second BICM decoding block 612200 performing MIMO PLP data from SRx_m and SRx_m+1, and a third BICM decoding block 612300 performing MISO encoding in the L1-signaling information from SRx_pre, SRx_pre+1, SRx_post, and SRx_post+1.

Also, the BICM decoder in Fig. 32 can perform the reverse process of the BICM encoder.

Data-performation method for each block is illustrated.

First, the first BICM decoding block 612100 includes a MISO decoder 612110, a time deinterleaver 6122120, a cell deinterleaver 612130, a constellation demapper 612140, a first demultiplexer 612150, a bit deinterleaver 612160, and a FEC decoder 612170.

The MISO decoder 612110 can perform MISO decoding in MISO PLP data. The MISO decoder 612110 can perform four functions.

First, if the channel estimation modules 610800-1~2 included in the OFDM demodulator does not perform channel equalizing, the MISO decoder 612110 applies the effect of the channel detection regarding every transmissible reference point and computes an LLR value. Therefore, it will have the same effect.

Second, the MISO decoder 612110 performs the following functions based on the performance of the constellation mapper 604140. If the BICM encoder of the broadcast signal transmitter rotates the constellation mapper with a certain angle and delays the Q-phase element of the constellation for a certain value, the MISO decoder 612110 delays the I-phase element of the constellation for a certain value and computes a 2D-LLR value based on the rotation angle.

If the constellation mapper 604140 does not rotate constellation and does not delay the Q-phase of constellation for a certain value, the MSIO decoder 612110 can compute the 2-D LLR value based on the normal QAM.

Third, the MISO decoder 612110 selects a decoding matrix to perform the reverse process based on the encoding matrix used by the MISO encoder 604170.

Fourth, the MISO decoder 612440 can combine signals inputted from two antennas. The signal combining method includes maximum ratio combining, equal gain combining, and selective combining and obtains the diversity effect by maximizing the SNR of the combined signals.

The MISO decoder 612110 performs MISO decoding in the combined signal and combine the MISO-decoded combined signals.

The time deinterleaver 6122120 restores the MISO decoded data into a time domain and the cell deinterleaver 612130 performs deinterleaving in the time-deinterleaved data into cell units.

The constellation demapper 612140 can perform the following functions based on the performance of the MISO decoder 612110.

First, if the MISO decoder 612110 does not transmit the LLR value directly and only performs MISO decoding, the constellation demapper 612140 can compute the LLR value. In more detail, if the constellation demapper 604140 in the BICM encoder performs constellation rotation or Q-phase element delay, the constellation demapper 612140 delay the I-phase LLR element and computes the LLR value. If the constellation demapper 604140 does not perform the constellation rotation and Q-phase element delay, the constellation demapper 612140 can compute the LLR value based on the normal QAM.

The computing the LLR value includes computing 2-D LLR and computing 1-D LLR. When computing the 1-D LLR, the complexity of the LLR computation can be reduced by executing either one of a first or a second route.

The first multiplexer 612150 restores demapped data in bit stream.

The bit-interleaver 612160 performs deinterleaving in the bit-stream, FEC decoding in the deinterleaved data, and outputs MISO PLP data by correcting errors in the transmitting channels.

The second BICM decoding block 612200 includes a MIMO decoder 612210, a first time deinterleaver 612220-0 and a second time deinterleaver 612220-1, a first cell deinterleaver 612230-0 and a second cell deinterleaver 612230-1, a first constellation demapper 612240-0 and a second constellation demapper 612240-1, a second multiplexer 612250, a bit interleaver 612260 and a FEC decoder 612270.

The MIMO decoder 612210 performs in MIMO PLP data from SRx_m and SRx_m+1. The MIMO decoder 612210 can perform the four functions of the MISO decoder 612110 except for the fourth function in which the signals are to be combined. Then, the MIMO decoder 612210 performs decoding by using MIMO encoding matrix of the first and sixth embodiment.

The first time deinterleaver 612220-0 and the second time deinterleaver 612220-1 perform deinterleaving in the MIMO decoded data into cell units. In that case, the first cell deinterleaver 612230-0 and the second deinterleaver 612230-1 performs cell deinterleaving in only a half of the cell data in one FEC block. As a result, cell deinterleaving by the first and second cell deinterleaver 612230-0, 612230-1 has the same effect as deinterleaving by cell deinterleaver 612130 using one FEC block.

The first constellation demapper 612240-0, the second constellation demapper 612240-1, the second multiplexer 612250, bitinterleaver 612260 and FEC decoder 612270 operates the same as those according to the first BICM decoding block 612100.

The third BICM decoding block 612300 includes a first decoding block 612400 performing L1-pre signaling data and a second decoding block 612500 performing L1-post signaling data. The first decoding block 612400 includes a MISO decoder 612410, a time deinterleaver 612420, a cell deinterleaver 612430, a constellation demapper 612440, and a FEC decoder 612450, and the second decoding block 612500 includes a MISO decoder 612510, a time deinterleaver 612520, a cell deinterleaver 612530, a constellation demapper 612540, a multiplexer 612550, a bit deinterleaver 612560, and a FEC decoder 612570.

As the first decoding block 612400 and the second decoding block 612500 have the same functions, the description of the first BICM decoding block 612100 is omitted.

As a result, the first BICM decoding block 612400 outputs the BICM decoded MISO PLP data to an output processor and the second BICM decoding block 612200 transmits the BICM decoded MIMO PLP data to the output processor.

The first decoding block 612400 in the third BICM decoding block 612300 performs MSIO decoding in L1-pre signaling data and transmits the data. Also, the second decoding block 612500 in the third BCIM decoding block performs MISO decoding in L1-post signaling data and transmits one L1-post signaling information.

A structure block of the broadcast signal receiver according to the second embodiment is described below. An OFDM demodulator and frame demapper according to the second embodiment in Fig. 36 and Fig. 37 operates the same as those according to the first embodiment. Further description is omitted.

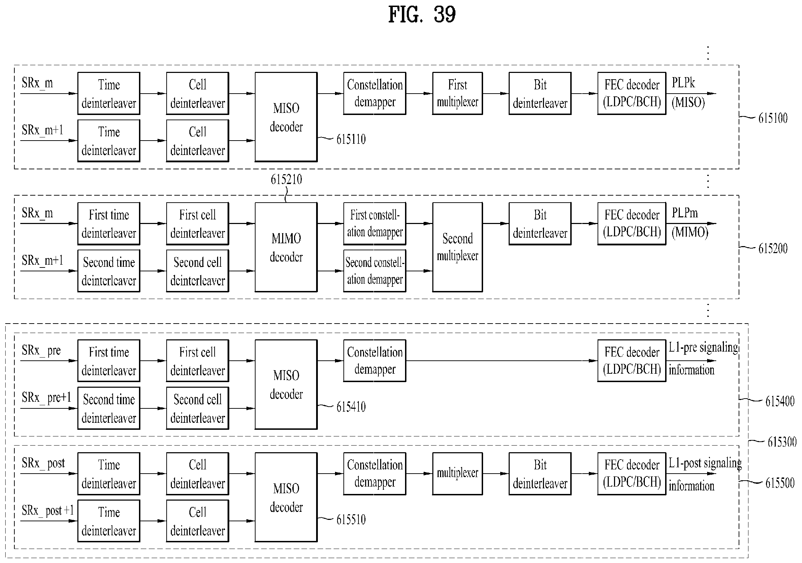

Fig. 39 shows a BICM decoder according to the second embodiment.

The BICM decoder in Fig. 39 is an embodiment of the BICM decoder 107300 in Fig. 2.

The BICM decoder according to the second embodiment receives data transmitted from a first route to a route of from SRx_0 to SRx_post and data transmitted from a second route to a route of from SRx_0+1 to SRx_post+1, and performs BICM decoding. Also, the BICM decoder according to the second embodiment can independently apply the MISO/MIMO process.

That is, the BICM decoder in Fig. 39 includes a first BICM decoding block 615100 performing MISO encoding in MSIO PLP data from SRx_k and SRx_k+1, a second BICM decoding block 615200 performing in MIMO PLP data from SRx_post and SRx_post+1, and a third BICM decoding block performing MISO encoding in L1-signaling data from SRx_pre, SRx_pre+1, SRx_post, and SRx_m+1.

Also, the third BICM decoding block 615300 includes a first decoding block 615400 performing the L1-pre signaling data and a second decoding block 615500 performing L1-post signaling data. Also, the BICM decoder according to the second embodiment can perform the reverse process of the BICM encoder.

As the BICM decoder operates the same as the BICM encoder, further explanation is omitted.

The decoding blocks according to the second embodiment in Fig. 39 operate the same as the decoding blocks according to the first embodiment in Fig. 38. Therefore, further description is omitted. However, the only difference is that in the BICM decoder the MISO decoder 615110, 615410, 615510 and the MIMO decoder 615310 are located at the end of the cell deinterleaver.

As shown in Fig. 35, the memory complexity of the receiver may be reduced because the BICM decoder performs MISO/MIMO decoding after time deinterleaving and cell deinterleaving in symbol units.

As a result, the first BICM decoding block 615100 transmits the BICM decoded MISO PLP data to an output processor and the second BICM decoding block 615200 transmits the BICM decoded MIMO PLP data to the output processor. Also, the first decoding block 615400 in the third BICM decoding block 615300 performs MISO decoding in L1-pre signaling data and outputs the L1-pre signaling information. Also, the second decoding block 615500 in the third BICM decoding block 615300 performs MISO decoding in L1-post signaling data and transmits the data.

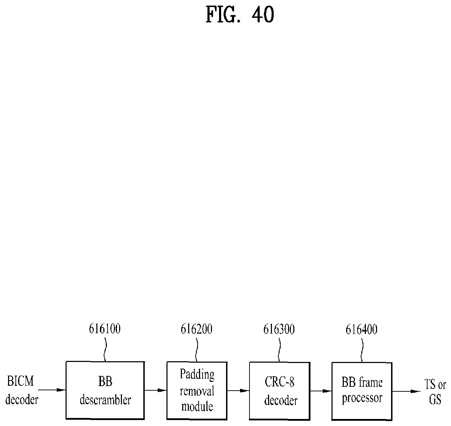

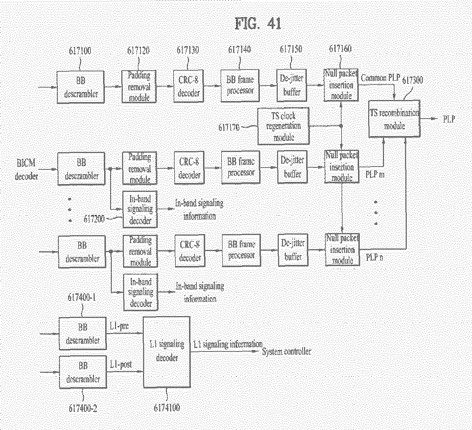

Fig. 40 and Fig. 41 show an embodiment of an output processor included broadcast signal receiver according to each embodiment. The following is a specific description of the output processor according to an embodiment of the present invention.

Fig. 40 shows an output processor of the broadcast signal receiver according to an embodiment.

The output processor in Fig. 40 is an embodiment of the output processor 107400 in Fig. 2.

The output processor in Fig. 40 as opposed to an input processor performing single PLP in Fig. 29 performs the reverse process of it and includes a BB discrambler 616100, a padding remove module 616200, a CRC-8 decoder 616300 and a BB frame processor 616400. The output processor performs the reverse process of the input processor by receiving bit stream from the BICM decoder.

The BB descrambler 616100 receives bit stream, performs XOR algorithm with the same bit-string as PRBS processed by the BB scrambler and outputs it. The padding remove module 616200 removes, if necessary, padding bits inserted in the padding insertion module. The CRC-8 decoder 616300 performs CRC decoding in the bit-stream and the BB frame processor 616400 decodes information in the BB frame header and restores TS or GS by using the decoded information.

Fig. 41 shows another embodiment of an output processor.

The output processor in Fig. 41 as opposed to the input processor in Fig. 30 and Fig. 31 performing a plurality of PLP performs the reverse process of it. The output processor includes a plurality of blocks for a plurality of PLP. The blocks are as follows. The output processor includes a BB descrambler 617100, 617400-1, 617400-2) and a padding removal module 617120, a CRC-8 decoder 617130, a BB frame processor 617140, a De-jitter buffer 617150, a null packet insertion module 617160, a TS clock regeneration module 617170, an in-band signaling decoder 617180, a TS recombination module 617300 and a L1 signaling decoder 617410. The same blocks as in Fig. 40 are omitted.

Processing for a plurality of PLP can be shown as decoding PLP data regarding common PLP or decoding service components like scalable video service or a plurality of services at once. The BB descrambler 617110, the padding removal module 617120, the CRC-8 decoder 617130 and the BB frame processor 617140 operate the same as those in Fig. 40.

The De-jitter buffer 617150 compensates a temporarily inserted delay for the synchronization of a plurality of PLP based on Time To Output (TTO) parameters. The null packet insertion module 617160 restores the deleted null packet based on the Deleted Null Packet (DNP) information. The TS clock regeneration module restores the detailed time synchronization of the outputted packet based on Input Stream Time Reference information. The TS recombination module 617300 receives the restored common PLP and related PLP data and transmit the original TS, IP or GS. The TTO parameters, DNP information, and ICSR information are obtained by the BB frame processor and it can transmit the data to each block or a system controller.

The in-band signaling decoder 617200 restores in-band signaling information via the padding bit filed of PLP data and transmits it.

As for L1 signaling information, the BB descramblers 617400-1, 617400-2 performs descrambling in the corresponding L1 pre signaling information data and L1-post signaling information, and the L1 signaling decoder 6174100 decodes the descrambled data and restores the L1 signaling information. The restored L1-signlaing information includes L1-pre signaling information and L1-post signaling information. It will also be transmitted to the system controller and provides parameters for BICM decoding, frame demapping, and OFDM demodulating. The L1 signaling information can be inputted as one BB descrambler and will be descrambled.

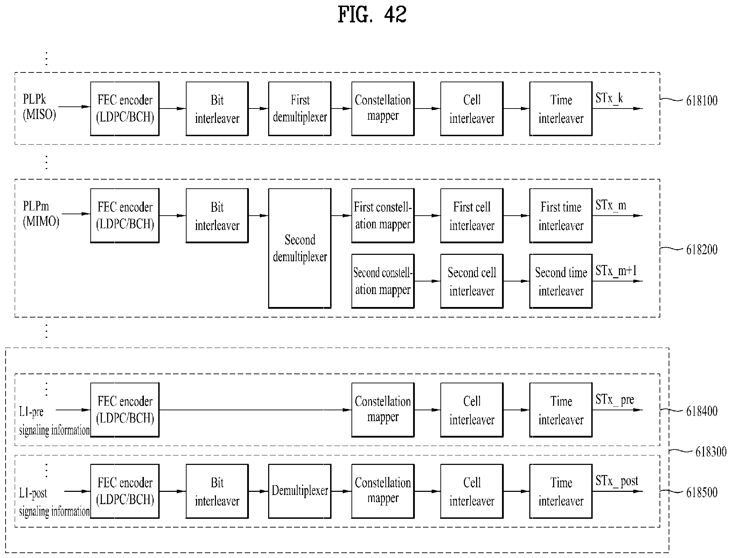

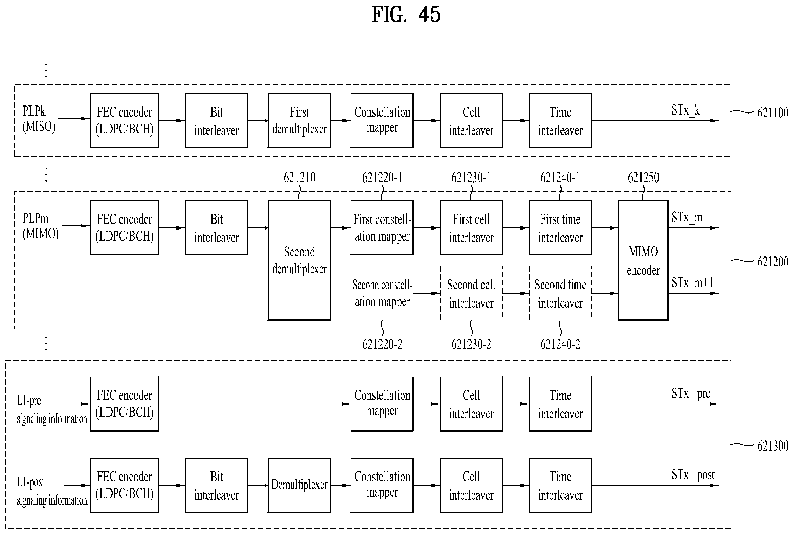

Fig. 42 and Fig. 45 show a structural block of a broadcast signal transmitter according to a third embodiment.

Fig. 42 shows a BICM encoder according to the third embodiment.

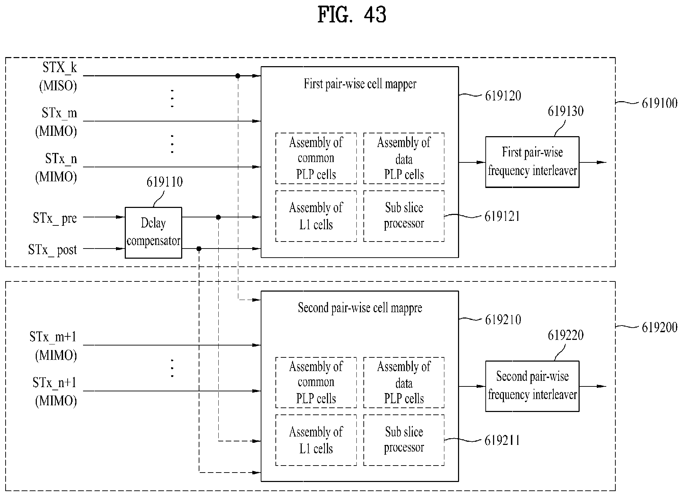

The BICM encoder in Fig. 43 is an embodiment of the BICM encoder 101300 in Fig. 29.

The BICM encoder according to the third embodiment of the present invention performs bit interleaving in a plurality of the input-processed PLP data, L1-pre signaling information, and L1-post signaling information and encoding for correcting errors as described in Fig. 32.

The OFDM generator according to the third embodiment of the present invention performs MISO/MIMO encoding in the MIMO/MISO encoded PLP data and L1-signaling information.

As shown in Fig. 42, the BICM encoder includes a first BICM encoding block 618100 performing MISO encoding in MISO PLP data, a second BICM encoding block 618200 performing MIMO encoding in MIMO PLP data, and a third BICM encoding block 618300 performing MISO encoding in signaling information. The BICM encoding block according to the third embodiment operates the same as the BICM encoding block according to the first embodiment. However, the only difference is that the BICM encoding block according to the third embodiment does not include the MISO/MIMO encoder.

As a result, the first BICM encoding block 618100 transmits the time interleaved MISO PLP data from one route (Tx_k) and transmits it to a frame builder. The second BICM encoding block (618200) transmits the time interleaved MIMO PLP data from one route (STx_m) and transmits it to a frame builder. And, third BICM encoding block (618300) includes the first encoding block 618400 performing L1-pre signaling information and the second encoding block 618500 performing L1-post signaling information, wherein the first encoding block 618400 transmits the time interleaved L1-pre signaling data and the second encoding block 618500 transmits the time interleaved L1-post signaling data.

Fig. 43 shows a frame builder according to a third embodiment.

The frame builder in Fig. 43 is an embodiment of the frame builder 101400 in Fig. 1.

As shown in Fig. 43, the time interleaved MISO PLP data transmitted from the BICM encoder, 2 MIMO PLP data, 2 MIMO PLP data L1-pre signaling data, and L1-post signaling data can be inputted to the frame builder.

In that case, the frame builder receives the MISO PLP data, MIMO PLP data, L1-pre signaling data, and L1-post signaling data from a first route, and the MIMO PLP data from a second route. The data from the first route can be transmitted through a first antenna (Tx_1) and the data from the second route can be transmitted through a second antenna (Tx_2).

The frame builder according to the third embodiment includes a first frame building block 619100 performing data from the first route and a second frame building block 619200 performing data from the second route. The first frame building block 619100 includes a first delay compensator 619110, a first cell mapper 619120, and a first frequency interleaver 619300-1 and a second frame building block 619200 includes a second cell mapper 619210 and a second frequency interleaver 619220 for performing data from the second route.

The first cell mapper 619120 and the first frequency interleaver 619130, the second cell mapper 619120 and the second frequency interleaver 619310 can operate independently for each route.

A method of data processing in the first frame builder block 619100 and the second frame builder block 619200 is described below.

The delay compensator 619110 compensates for a delay in the first frame and a delay caused by the encoding of the third BICM encoding block 619300. As the L1-signaling information can include information of the current frame and the next frame, during the input processing, the L1-signaling information can be delayed one frame as opposed to the PLP data. Through this process, the L1-signaling information having the current and next frame information can be transmitted at the same time.

The first cell mapper 619120 and the second cell mapper 619210 perform mapping the PLP data and L1-signaling data in symbol units into cell units in a sub-carrier of the OFDM symbol.

Also, the first cell mapper 619120 and the second cell mapper 619210 perform mapping the MISO PLP data and the MIMO PLP data in symbol units into cell units in a sub-carrier of the OFDM symbol. According to the third embodiment, after frequency interleaving, that is, after MISO/MIMO encoding in the OFDM generating process, MIMO/MISO encoding can be done in OFDM symbol units. If the MISO PLP data cells and MIMO PLP data cells are mapped in the same OFDM symbol, the OFDM generator cannot perform MISO/MIMO encoding independently. Thus, the first cell mapper 619120 and the second cell mapper 619210 dose not map the MISO/MIMO PLP data in the same OFDM symbol.

The PLP data from the first cell mapper 619120 and the second cell mapper 619210 include common PLP DATA, MISO/MIMO encoded PLP data and sub-slice processor modules 619120-1, 619210-1 performs frame-mapping in the PLP data in cell units for the diversity effect.

Also, in order to simplify the transmitting system, the first and second cell mappers 619120, 619210 operate the same.

But, although the MISO PLP data, L1-pre and post signaling data is transmitted from the first route only, the MIMO PLP data can be from the first and the second routes. Therefore, depending on the data inputted, the performance of the cell mapper is different.

More detailed description is as follows.

First, the first cell mapper 619120 and the second cell mapper 619210 receive the same MISO PLP data from the first route and the same L1-pre and post signaling data from the delay compensator 619110. In that case, the first cell mapper 619120 and the second cell mapper 619210 perform mapping in the inputted data to be allocated into a sub-carrier of the OFDM symbol.

Second, among the first cell mapper 619120 and the second cell mapper 619210, the first cell mapper 619120 only receives the MISO PLP data and the delayed compensated L1-pre and post signaling data. In that case, the second cell mapper 619210 performs mapping only for the MIMO PLP.

The first frequency interleaver 619130 and the second frequency interleaver 619220 performs frequency interleaving in the inputted data by cell units and transmits the data to the OFDM generator.

In that case, the first frequency interleaver 619130 and the second frequency interleaver 619220 perform frequency interleaving in the OFDM symbol into interleaving units. Also, if the second cell mapper 619210 receives MIMO PLP data only, the second frequency interleaver also performs interleaving in MIMO PLP data only.

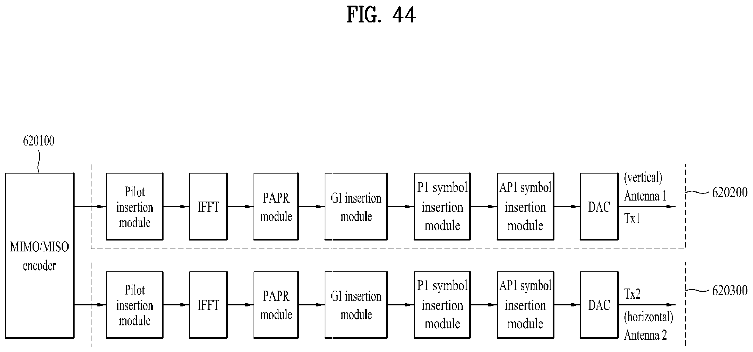

Fig. 44 shows an OFDM generator according to a third embodiment.

The OFDM generator in Fig. 44 is an embodiment of the OFDM generator 101500 in Fig. 1.

The present invention transmits broadcast signals by the MISO/MIMO method through two antennas. The OFDM generator in Fig. 44 receives and demodulates the frequency-interleaved broadcast signals through a first and a second route. It then transmits the signals to two antennas (Tx1, Tx2).

A first OFDM generating block 620200 modulates the broadcast signals through the first antenna (Tx1) and a second OFDM generating block 620300 modulates the broadcast signals through the second antenna (TX2). In the present invention, such a method is called polarity multiplexing MIMO.

As shown in Fig. 44, the first OFDM generator includes a MISO/MIMO encoder 620100, a first OFDM generating block 620200 and a second OFDM generating block 620300. The first OFDM block 620200 includes a pilot insertion module, an IFFT module, a PAPR module, a GI insertion module, a P1 symbol insertion module, an AP1 symbol insertion module and a DAC 606700-2, wherein modules in the first transmitting unit 620200 operate the same functions.

As the first OFDM generating block 620200 and the second OFDM generating block 620300 in the OFDM generator according to the third embodiment of the present invention operate the same as the OFDM generator according to the first embodiment in Fig. 34, further description is omitted. But, the OFDM generator according to the third embodiment includes a MIMO/MISO encoder 620100 as opposed to the OFDM generator according to the first embodiment. In that regard, further illustration is as follows.

If the input data is MISO PLP data or L1-pre and post signaling data from the first and second routes, the MIMO/MISO encoder 603100 performs MISO encoding in the data into OFDM symbol units by using MISO encoding matrix and transmits it to the first and second generating blocks 620200, 620300. In that case, the input data is transmitted from either of the first or second route. According to an embodiment, the MISO encoding matrix can include an OSTBC (Orthogonal Space-Time Block Code)/OSFBC(Orthogonal Space Frequency Block Code/Alamouti code).

If data from the first and second routes is MIMO PLP data, the MIMO/MISO encoder 620100 performs MIMO encoding in the data into OFDM symbol units by using MIMO encoding matrix and transmits it to the first and second OFDM generating blocks. 620200, 620300. The MIMO encoding matrix of the present invention includes a spatial multiplexing, a Golden code (GC), a full-rate full diversity code, and a linear dispersion code. Also, the MIMO encoder performs MIMO encoding by using MIMO encoding matrix according to the first and sixth embodiment of the present invention in Fig. 14 and Fig. 21.

Fig. 45 and Fig. 47 show a structural block of the transmitting system according to the fourth embodiment. Further description is as follows.

Fig. 45 shows a BICM encoder according to the fourth embodiment.

The BICM encoder in Fig. 45 is an embodiment of the BICM encoder 101300 in Fig. 1.

The BICM encoder according to the fourth embodiment performs bit-interleaving in a plurality of PLP data after performing input-processing, L1-pre signaling information, and L1-post signaling information, and encoding for correcting errors.

Although the third and the fourth embodiments are nearly the same, the fourth embodiment performs MIMO encoding in MIMO PLP data. That is, the BICM encoder according to the fourth embodiment includes a first BICM encoding block 621100 performing MISO encoding in PLP data, a second BICM encoding block 621200 performing MIMO encoding in PLP data, and a third BICM encoding block 621300 performing MISO encoding in signaling information, wherein the third BICM encoding block 621300 includes a first encoding block 621400 performing L1-pre signaling information and a second encoding block 621500 performing L1-post signaling information.

As shown in Fig. 45, the first and third BICM encoding blocks 621100, 621300 according to the fourth embodiment is the same as the BICM encoding blocks according to the third embodiment in Fig. 42. Thus, further description is omitted. However, the second BICM encoding block 621200 includes a MIMO encoder 621210 as opposed to the third embodiment. Further illustration is as follows. Except for the MIMO encoder 621210, blocks in the second BICM encoding block 621200 operate the same as the blocks according to the third embodiment in Fig. 42. Thus, further description is omitted.

The second encoding block 621200 performs FEC encoding and bit-interleaving in the MIMO PLP data and transmits it to the second demultiplexer 621210.

The second demultiplexer 621210 creates two input routes for MIMO encoding and it can be varied as the designer intends. Also, the MIMO PLP data transmitted through the two input routes may or may not have the same transmitting characters.

If the transmitting characters of the two MIMO PLP data are different, the second demus 621210 can randomly allocate the bit-words of the MIMO PLP data included in one FEC block into each input route.

Also, if the modulation QAM types of the two MIMO PLP data are the same, a second constellation mapper 621220-2, a second cell interleaver 621230-2 and a second time interleaver 621240-2 in the dotted area in Fig. 45 may not be used. In that case, a first constellation mapper 621220-1, a first cell interleaver 621230-1 and a first time interleaver 621240-1 can transmit the two input data to a MIMO encoder 621250.

As the MIMO encoder 621210 operates the same as the MISO/MIMO encoder 620100 according to the third embodiment in Fig. 44, further description is omitted.

As a result, the first BICM encoding block 621100 transmits MISO PLP data from one route (STx_k) to a frame builder and the second BICM encoding block (621200) transmits MIMO PLP data from two routes (STx_m, STx_m+1) to the frame builder. Also, the third BICM encoding block (621300) transmits the L1-pre signaling information and the L1-post signaling information from two routes (STx_pre, Stx_pre_1 and STx_post , STx_post+1) to the frame builder.

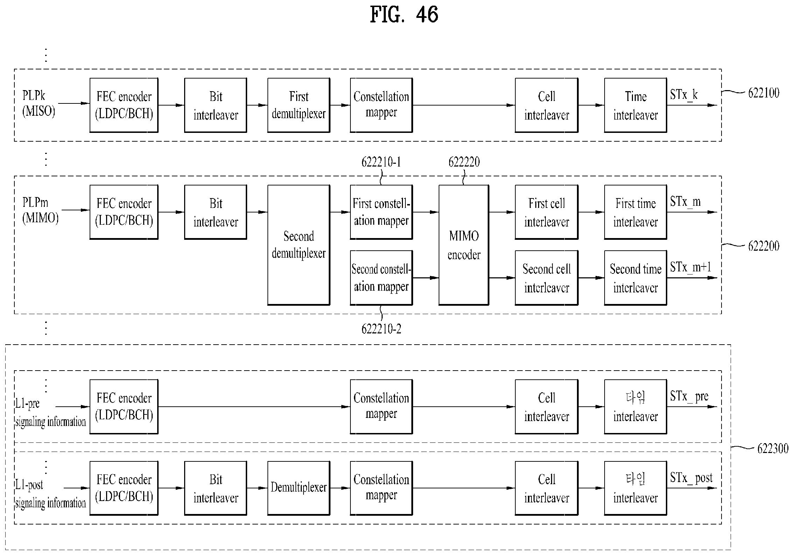

Fig. 46 shows another embodiment of the BICM encoder according to the fourth embodiment in Fig. 47.

As shown in Fig. 46, the BICM encoder includes a first BICM encoding block 622100, a second BICM encoding block 622200, and a third BICM encoding block 622300.

Although blocks here are nearly the same as the blocks in the BICM encoder according to the second embodiment in Fig. 45, a MIMO encoder 622220 in a second BICM encoding block 622200 is located next to a first constellation mapper 622210-1 and a second constellation mapper 622210-1 as opposed to Fig. 45.

PLP data and signaling data can be performed into symbol units after constellation mapping. Thus, the second BICM encoding block 622200 in Fig. 46 performs cell interleaving, time interleaving, and MIMO encoding in the MIMO PLP data into OFDM symbol units. In that case, the broadcast signal receiver performs the reverse process. That is, the MIMO decoder, time deinterleaver, and cell deinterleaver of the broadcast signal receiver can perform the received data in symbol units.

However, the BICM decoder of the broadcast signal receiver corresponding to the BICM encoder in Fig. 45 performs MIMO decoding in the MIMO PLP data first and then transmits the MIMO-decoded data in bit units. Although the BICM decoder can perform time deinterleaving or cell deinterleaving, information about symbol units is required because the output data will be imputed in bit units.

Therefore, the memory complexity of the broadcast signal receiver will increase because it should store information about symbol mapping of the input bits during the deinterleaving process.

As shown in Fig. 46, in the BICM encoder according to the second embodiment, the MIMO encoder 622220 is located at the end of the first constellation mapper 622210-1, and the second constellation mapper 622210-2. Thus, the BICM decoder can perform MIMO decoding after time deinterleaving and cell deinterleaving in symbol units.

In that case, since MIMO decoded data in bit units goes through the constellation demapping process, no symbol mapping information is needed. Thus, the memory complexity will be reduced compared to the broadcast signal receiver according to the first embodiment.

As a result, a first BICM encoding block 622100 transmits the time interleaved MISO PLP data from one route (STx_k) and transmits it to a frame builder. The second BICM encoding block (605200) transmits the MIMO PLP data from two routes (STx_m, STx_m+1) and transmits it to a frame builder.

A frame builder according to a fourth embodiment operates the same as the frame builder according to the third embodiment in Fig. 43.

Fig. 47 shows an OFDM generator according to the fourth embodiment.

The OFDM generator in Fig. 47 is an embodiment of the OFDM generator 101500 in Fig. 1.

The present invention transmits broadcast signals by the MISO/MIMO method through two antennas. The OFDM generator in Fig. 47 receives the MIMO encoded MIMO PLP data, the frequency-interleaved MISO PLP data and L1-signaling data, performs MISO encoding in only the MISO PLP data and L1-signaling data, demodulates the rest, and transmits them to two antennas (Tx1, Tx2).

A first OFDM generating block 620200 modulates the broadcast signals through the first antenna (Tx1) and a second OFDM generating block 620300 modulates the broadcast signals through the second antenna (TX2). In the present invention, such a method is called polarity multiplexing MIMO.

As shown in Fig. 47, the OFDM generator according to the fourth embodiment includes a MISO encoder 624100, a first OFDM generating block 624200 and a second OFDM generating block 624300. The first OFDM generating block 624200 and the second OFDM generating block 624300 perform the same functions as the blocks according to the third embodiment in Fig. 44. Thus, further description is omitted. But, the OFDM generator according to the fourth embodiment includes a MISO encoder 624100 as opposed to the OFDM generator according to the third embodiment. In that regard, further illustration is as follows.

The MISO encoder 624100 performs MISO encoding in the frequency-interleaved MISO PLP data, L1-pre signaling data and L1-post signaling data. The MISO encoder 624100 operates the same as the MIMO/MISO encoder 620100 in Fig. 44. In addition, if the MIMO encoded MIMO PLP data is inputted, it may be bypassed and the MISO encoder may perform MISO encoding in the MIMO encoded MIMO PLP data.

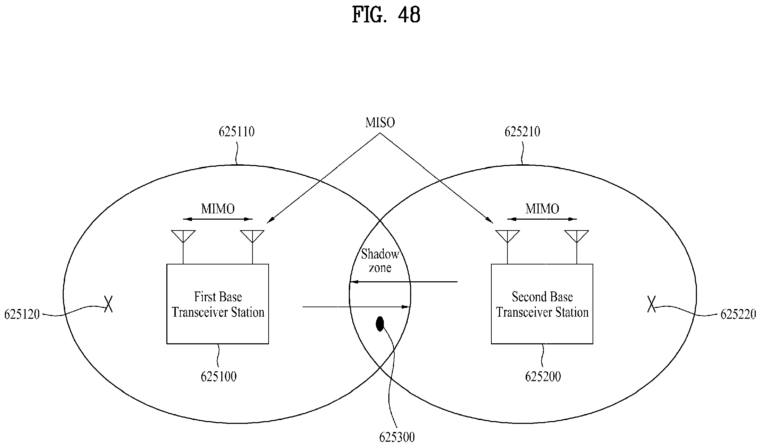

Fig. 48 shows a broadcast signal transmitting/receiving system according to the fourth embodiment.

As shown in Fig. 48, according to the fourth embodiment, a first Base Transceiver Station (BTS) 625100 and a second BTS 625200 transmits broadcast signals by two antennas. The broadcast signals of each BTS can be generated by MIMO encoding.

A receiver 625120 of a first broadcast network cell 625110 receives the MIMO broadcast signals from the first BTS 625100 and a receiver 625220 of a second broadcast network cell 625210 receives the MIMO broadcast signals from the second BTS 625220. Thus, the receivers 625120, 625220 ensure diversity and high reception performance.

But as for a receiver 625300 far from the first BTS 625100 and the second BTS 625200 the degradation of the reception performance may happen. An area where it happens is called a shadow zone.

Thus, as shown in Fig. 47, if the MISO encoder 624100 performs MISO encoding in MIMO encoded PLP, the broadcast signals from the first and the second BTSs 625100, 625200 are performed MISO and MIMO encoding, a MIMO and MISO gain will happen. In that case, as the receiver 625300 within the shadow zone receives the MISO decoded signals, the degradation of the reception performance can be compensated.

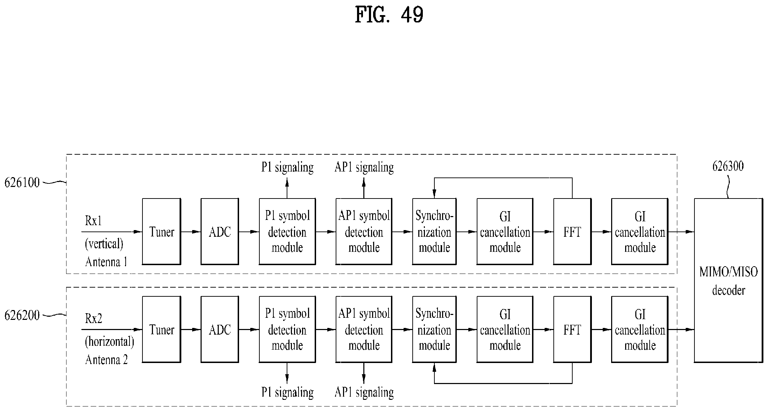

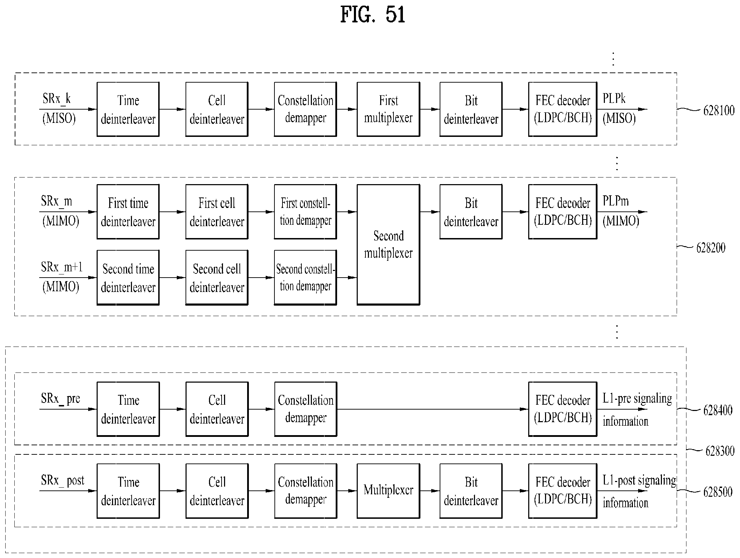

Fig. 49 and Fig. 51 show a structural block of a broadcast signal receiver according to the third embodiment.

Fig. 49 shows an OFDM demodulator according to the third embodiment.

As shown in Fig. 49, the OFDM demodulator is another embodiment of the OFDM demodulator 107100 in Fig. 2.

According to an embodiment of the present invention, the present invention requires two antennas, Rx1 and Rx2. The OFDM demodulator shown in Fig. 49 can perform OFDM demodulation through the Rx1 and Rx2 antennas.

A block demodulating transmitted signals through a first antenna (Rx1) is called a first OFDM demodulating block 626100 and a block demodulating transmitted signals through a second antenna (Rx2) is called a second OFDM demodulating block 626200.

In addition, the present invention can utilize polarity multiplexing MIMO according to an embodiment of the present invention. The first OFDM demodulating block 626100 performs OFDM demodulation in the broadcast signals transmitted through the first antenna (Rx1) and outputs the signals to a MISO/MIMO decoder 626300, and the second demodulating block 626200 performs OFDM demodulating in the broadcast signals transmitted through the second antenna (Rx2) and outputs the signals to a MISO/MIMO decoder 626300.

Also, as shown in Fig. 49, the OFDM demodulator of the third embodiment can perform the reverse process of the OFDM generator of the third embodiment.

According to the third embodiment, the OFDM demodulator includes a first OFDM demodulating block 626100, a second OFDM demodulating block 626200, and a MISO/MIMO decoder 626300. The first OFDM demodulating block 626100 comprises a tuner, an ADC, a P1 symbol detection module, an AP1 symbol detection module, a synchronizing module, a GI cancellation module, a FFT module and a channel detection module, and operates the same as the first OFDM demodulating block 626100.

The first OFDM demodulating block 626100 and the second OFDM demodulating block 626200 in the OFDM demodulator of the third embodiment operates the same as the OFMD demodulator of the first embodiment in Fig. 36. Thus, further illustration is omitted. But since the OFDM demodulator of the third embodiment includes a MIMO/MISO decoder 626300, further description is as follows.

When the MIMO/MISO decoder 626300 performs MISO decoding in MISO PLP data and L1-signaling data, there are four functions.

First, if the channel estimation modules, included in a first receiving unit 626100 and a second receiving unit 626200, do not perform channel equalizing, the MISO/MIMO decoder 626300 applies the effect of the channel detection regarding every transmissible reference point and computes an LLR value. Therefore, it will have the same effect.

Second, the MIMO/MISO decoder 626300 performs the following functions based on the performance of the constellation mapper in the BICM encoder according to the third embodiment in Fig. 42. If the BICM encoder of the broadcast signal transmitter rotates the constellation mapper with a certain angle and delays the Q-phase element of the constellation for a certain value, the MIMO/MIISO decoder 626110 delays the I-phase element of the constellation for a certain value and computes a 2D-LLR value based on the rotation angle.

If the constellation mapper does not rotate constellation and does not delay the Q-phase of constellation for a certain value, the MIMO/MISO decoder 626110 can compute the 2-D LLR value based on the normal QAM.

Third, the MIMO/MISO decoder 626110 selects a decoding matrix to perform the reverse process based on the encoding matrix used by the MIMO/MISO encoder 620100 in the OFMD generator in Fig. 20.

Fourth, the MIMO/MISO decoder 626300 can combine MISO PLP data inputted from two antennas. The signal combining method includes maximum ratio combining, equal gain combining, and selective combining and obtains the diversity effect by maximizing the SNR of the combined signals.

The MIMO/MISO decoder 626300 performs MISO decoding in the combined signal and combine the MISO-decoded combined signals.

The MIMO/MISO decoder 626300 performs MIMO decoding in MIMO PLP data from a first and a second routes. In that case, it can perform the MISO decoding but not the last function. That is, combining signals cannot be performed.

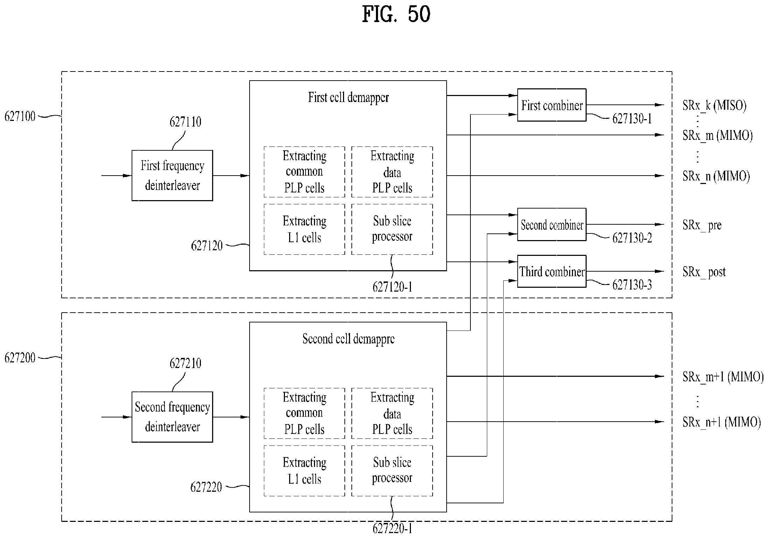

Fig. 50 shows a frame demapper according to the third embodiment.

The frame demapper in Fig. 50 is another embodiment of the frame builder 101400 in Fig. 1.

As shown in Fig. 50, the frame demapper includes a first frame demapping block 627100 performing data from a first route and a second frame demapping block 627200 performing data from a second route.

The first frame demapping block 627100 includes a first frequency deinterleaver 627110, a first cell demapper 627120, a first combiner 627130-1, a second combiner 627130-2 and a third combiner 627130-3, and the second frame demapping block 627200 includes a second frequency deinterleaver 627210 and a second cell demapper 627220.

Also, the first frequency deinterleaver 627110 and the first cell demapper 627120 or the second frequency deinterleaver 627210 and the second cell demapper 627220 can operate independently and the same through a first route and a second route respectively.

Also, the frame demapper according to the third embodiment can perform the reverse process of the frame builder according to the third embodiment in Fig. 43.

A method of data processing by blocks included in the first frame builder demapping block 627100 and the second frame builder demapping block 627200 is as follows.

The first frequency deinterleaver 627110 and the second frequency deinterleaver 627210 perform deinterleaving in data in the frequency domain through the first and seoncd routes into cell units.

The extracted PLP data includes the MISO decoded MISO PLP data and MIMO decoded MIMO PLP data, and the extracted L1-signaling data includes information necessary for the current and next frames. Also, if the transmitter performs sub-slicing in the PLP data, the first sub-slice processor 627120-1, 627220-1 of the first and the second cell demappers 627120, 627220 can merge the sliced PLP data and generate it in one stream.

The first combiner 627130-1 can combine the MISO decoded MISO PLP data if it does not combine the MISO PLP data in the MIMO/MISO decoder 626300.

The second combiner 627130-2 and the third combiner 627130-3 can operate the same as the first combiner but it deals with L1-pre and post signaling data.

As shown in Fig. 50, the extracted data through the first route, the MISO PLP data, MIMO PLP data and signaling data are inputted to the BICM decoder through SRx_k to SRx_post, and the MIMO PLP data is inputted to the BICM decoder through SRx_m+1 to SRx_n+1.

Fig. 51 shows a BICM decoder according to the third embodiment.

The BICM decoder in Fig. 51 is another embodiment of the BICM decoder 107300 in Fig. 2.

The BICM according to the third embodiment receives data transmitted by a frame demapper from the first route via SRx_k to SRx_post and data from the second route via SRx_m+1 to SRx_n+1, performs BICM decoding and transmits the data to an output processor.

The BICM decoder according to the first embodiment independently performs BICM encoding in the MISO PLP data, MIMO PLP data, and signaling data.

As shown in Fig. 51, the BICM decoder according to the third embodiment includes a first BICM decoding block 628100 performing the MISO decoded MISO PLP data from SRx_k, a second BICM decoding block 628200 performing the MIMO decoded MIMO PLP data from SRx_m and SRx_m+1, and a third BICM decoding block 628300 performing the MISO encoded L1-signaling data from SRx_pre, SRx_post. Also, the third BICM decoding block 628300 includes a first decoding block 628400 performing L1-pre signaling data and a second decoding block 628500 performing L1-post signaling data.

Also, as the BICM decoder according to the third embodiment in Fig. 51 operates the same as the BICM encoding blocks according to the first embodiment in Fig. 38, further illustration is omitted. However, the only difference is that the BICM decoding blocks according to the third embodiment do not include MISO/MIMO decoders.

Also, the BICM decoder according to the third embodiment performs the reverse process of the BICM encoding blocks according to the first embodiment.

As a result, the first BICM decoding block 628100 outputs the BICM decoded MISO PLP data to an output processor and the second BICM decoding block 628200 transmits the BICM decoded MIMO PLP data to the output processor. The first decoding block 628400 and the second decoding block 628500 in the third BCIM decoding block 6285300 transmits the BICM decoded L1-pre and post signaling information.

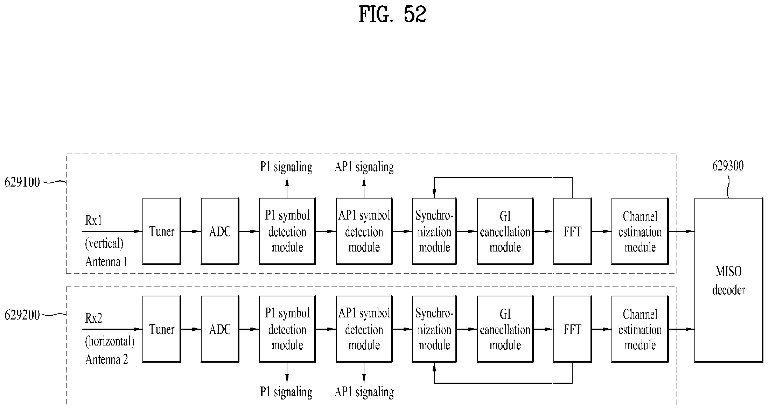

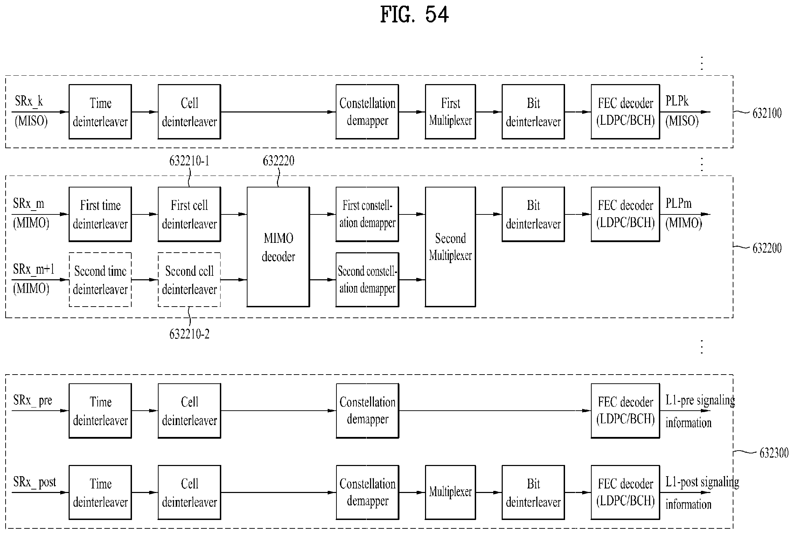

Fig. 52 and Fig. 54 show a structural block of a broadcast signal receiver according to the fourth embodiment.

Fig. 52 shows an OFDM demodulator according to the fourth embodiment.

The OFDM demodulator in Fig. 52 is another embodiment of the OFDM demodulator 107100 in Fig. 2.

According to an embodiment of the present invention, the present invention requires two antennas, Rx1 and Rx2. The OFDM demodulator shown in Fig. 52 can perform OFDM demodulation through the Rx1 and Rx2 antennas.

A block demodulating transmitted signals through a first antenna (Rx1) is called a first OFDM demodulating block 629100 and a block demodulating transmitted signals through a second antenna (Rx2) is called a second OFDM demodulating block 629200.

In addition, the present invention can utilize polarity multiplexing MIMO according to an embodiment of the present invention. Thus, the OFDM demodulator includes a first OFDM demodulating block 629100, a second OFDM demodulating block 629200 and a MISO encoder 629300. The first OFDM demodulating block 629100 performs OFDM demodulation in the broadcast signals transmitted from a first route through the first antenna (Rx1) and outputs the signals to the MISO decoder 629300, and the second demodulating block 629200 performs OFDM demodulating in the broadcast signals transmitted through the second antenna (Rx2) and outputs the signals to the MISO decoder 629300.

Also, the OFDM according to the fourth embodiment in Fig. 47 can perform the reverse process of the OFDM generator according to the fourth embodiment.

The first OFDM demodulating block 629100 includes a tuner, an ADC, a P1 symbol detection module, an AP1 symbol detection module, a synchronizing module, a GI cancellation module, a FFT module and a channel estimation module. The second OFDM demodulating block 629200 comprises the same.

The first OFDM demodulating block 629100 according to the fourth embodiment and blocks included in the second OFDM demodulating block 629200 operate the same as the first OFDM demodulating block 626100 and the second OFDM demodulating block 626200. Thus, further description is omitted.

Also, the MISO decoder 629300 operates the same as the MISO/MIMO decoder 626300 according to the third embodiment in Fig. 49.

The frame demapper according to the fourth embodiment operates the same as the frame demapper in Fig. 50.

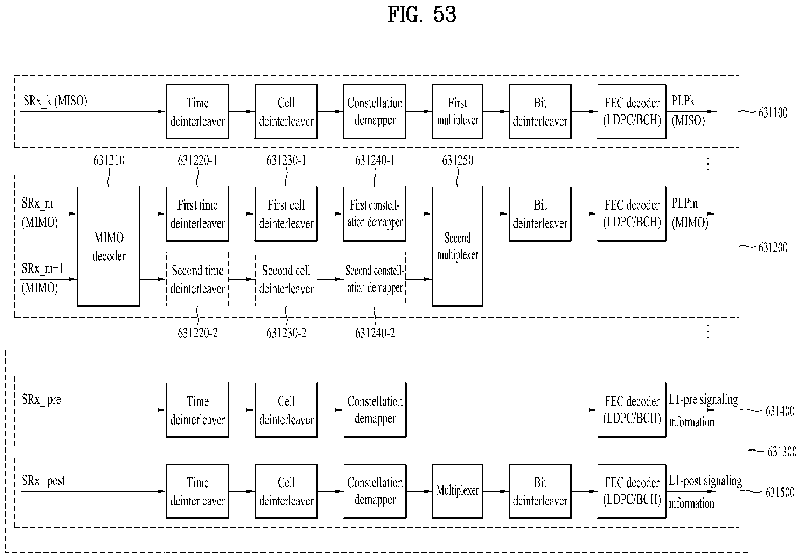

Fig. 53 shows a BICM decoder according to the fourth embodiment.

The BICM decoder in Fig. 53 is an embodiment of the BICM decoder 107300 in Fig. 2.

The BICM decoder according to the fourth embodiment receives data transmitted from a first route from SRx_0 to SRx_post and data transmitted from a second route from SRx_0+1 to SRx_post+1, performs BICM decoding and transmits the data to the output processor.

Also, the BICM decoder according to the fourth embodiment can independently perform BICM decoding in the MISO PLP data and L!-signaling data from the first and second route and performs MIMO and BICM decoding in the MIMO PLP data.

Thus, the BICM decoder in Fig. 53 includes a first BICM decoding block 631100 performing MISO encoding in MSIO PLP data from SRx_k, a second BICM decoding block 631200 performing in MIMO PLP data from SRx_pre and SRx_post, and a third BICM decoding block 631300.

Also, the third BICM decoding block includes a first decoding block 631400 performing L1-signaling data and a second decoding block 631500 performing L1-post signaling data.

Also, the BICM decoder according to the fourth embodiment can perform the reverse process of the BICM encoder according to the fourth embodiment in Fig. 45.

As the first BICM decoding block 631100 according to the fourth embodiment in Fig. 53 and the third decoding block 631300 operate the same as the BICM decoding blocks according to the third embodiment in Fig. 51, further description is omitted. But, the only difference is that the BICM decoding block 631200 includes the MIMO decoder 631210 as opposed to the second BICM decoding block 628200. The second BICM decoding block will be further illustrated. Only the performance of the second BICM decoding block 631200 will be illustrated. However, as blocks in the second BICM decoding block 631200 operates the same as the second BICM decoding block 628200 according to the third embodiment, further description is omitted.

The MIMO decoder 631210 can operate the same as the MIMO/MISO decoder 626300 according to the third embodiment in Fig. 49. In that case, the transmitting character of MIMO PLP data from a first and a second route may or may not be the same.

Also, if the modulation orders of the two MIMO PLP data are the same, a second constellation mapper 631220-2, a second cell interleaver 6312302 and a second time interleaver 631240-2 in the dotted area in Fig. 53 may not be used. Thus, two of the MIMO PLP data will be merged into one input in the first time deinterleaver 631200-1, the first cell deinterleaver 631300-1, the first constellation demapper 631400-1, and then will be inputted to the second multiplexer 631500.

As a result, the first BICM decoding block 631100 transmits the BICM decoded MISO PLP data and the second BICM decoding block 631200 transmits MIMO PLP data to the output processor. Also, a first decoding block 631400 and a second decoding block 631500 in the third BICM decoding block 631300 transmits the BICM decoded L1-pre signaling information and the L1-post signaling information.

Fig. 54 shows a BICM decoder according to the fourth embodiment.

As shown in Fig. 54, the BICM decoder includes a first BICM decoding block 632100 performing the MSIO PLP data from SRx_k, a second BICM decoding block 632200 performing MIMO PLP data from SRx_m and SRx_m+1, and a third BICM decoding block 621300 performing the MISO decoded L1-signaling data from SRx_pre and SRx_post.

Also, the BICM decoder according to the fourth embodiment can perform the reverse process of the BICM encoder according to the fourth embodiment in Fig. 46.

Although the BICM decoding block according to the fourth embodiment in Fig. 54 and the BICM decoding block according to the fourth embodiment in Fig. 53 operate the same, the MIMO decoder 632220 in the second BICM decoding block 632200 is located at the end of the first and the second cell deinterleaver 632210-1, 632210-2.

The memory complexity of the broadcast signal receiver will be reduced because MIMO/MISO decoding is performed after time deinterleaving and cell deinterleaving in symbol units.

The purpose of the present invention is to provide a broadcast transmitter/receiver or a broadcast signal transmitting/receiving method optimizing performance when applying a lower code rate of LDPC to a broadcasting or communicating system.

A demultiplexer in the BICM encoder as an embodiment is as follows.

The purpose of the demultiplexer is to demultiplexer data of the transmitter and the receiver to optimize performance when mapping the LDPC codeword of the lower code rate in symbol units.

The demultiplexer properly distributes reliability caused by LDPC encoding to optimize the error-correcting performance for LDPC. The LDPC coding is a linear error correcting code to transmit information by minimizing the probability of information loss. The LDPC blocks are expressed as parameters such as N and K. Here, N indicates a block length and K indicates a number of information bits encoded in one of the LDPC blocks. The amount of data to be transmitted in one LDPC block is based on the size of the LDPC parity and the code rate.

The code rates for the present invention are 1/4, 2/5, 3/5, 1/2, 4/5, 1/3, 2/3, 3/4, and 5/6. And the LDPC block length is 16200 bits or 16k bits, and 64800 bits or 64k bits.

That is, a LDPC codeword bit from a FEC encoder will be inputted into a bit-interleaver, and the bit-interleaver performs interleaving in the LDPC codeword bits in the LDPC block and transmits them to a demultiplexer. The demultiplexer divides the bit-interleaved LDPC codeword bit stream into a number of bit streams. For example, if the LDPC block length is 16800 and a modulation format used for symbol mapping is QPSK, 16QAM, 64QAM, and 256 QAM, it will divide it into 2, 8, 12, and 8 bit streams respectively. That is, if the LDPC block length is 16800 and the modulation format is QPSK, the number of the sub-streams is 2, if the modulation format is 16QAM, the number of the sub-streams is 8, if the modulation format is 64QAM, the number of the sub-streams is 12, and if the modulation format is 256QAM, the number of the sub-streams is 8.

An output order in the demultiplexer can be varied based on predetermined conditions or the distribution of reliability. That is, when the corresponding bit group is mapped in QAM symbols, the bit order transmitted from the demultiplexer varies based on the distribution of reliability.

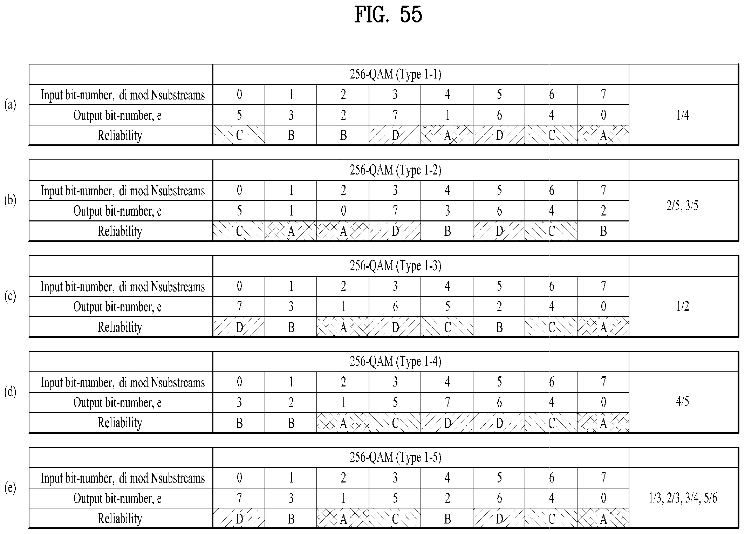

Fig. 55 (a) and (e) show an output order of a demultiplexer based on each code rate when the LDPC block length is 16800 and the modulation format is 256QAM. If the modulation format is 256QAM, 8 bit units are mapped in one symbol.

When Fig. 55 (a) shows an output order of a demultiplexer when the code rate is 1/4. The demultiplexer method in Fig. 55 (a) is called Type 1-1 of 256QAM. That is, for the type 1-1, when the bit-interleaved input bits are entered in the order of 0, 1, 2, 3, 4, 5, 6, 7, the demultiplexer will output 5, 3, 2, 7, 1, 6, 4, 0. It will be symbol-mapped as is in the demultiplexer. In that case, the distribution of reliability will be C, B, B, D, A, D, C, A from the first bit to the last bit of the LDPC codeword. A, B, C, and D indicate reliability when bits in the corresponding group are mapped in QAM symbols. Here, the hierarchy of reliability is from A to D, A being the highest and D being the lowest.

Fig. 55 (b) shows an output order of a demultiplexer when the code rate is 2/5 and 3/5. The demultiplexer method in Fig. 2(b) is called Type 1-2 of 256QAM. That is, for the type 1-2, when the bit-interleaved input bits are entered in the order of 0, 1, 2, 3, 4, 5, 6, 7, the demultiplexer will output 5, 1, 0, 7, 3, 6, 4, 2. It will be symbol-mapped as is in the demultiplexer. In that case, the distribution of reliability will be C, A, A, D, B, D, C, B from the first bit to the last bit of the LDPC codeword.

Fig. 55 (c) shows an output order of a demultiplexer when the code rate is 1/2. The demultiplexer method in Fig. 2(c) is called Type 1-3 of 256QAM. That is, for the type 1-3, when the bit-interleaved input bits are entered in the order of 0, 1, 2, 3, 4, 5, 6, 7, the demultiplexer will output 7, 3, 1, 6, 5, 2, 4, 0. It will be symbol-mapped as is in the demultiplexer. In that case, the distribution of reliability will be D, B, A, D, C, B, C, A from the first bit to the last bit of the LDPC codeword.

Fig. 55 (d) shows an output order of a demultiplexer when the code rate is 4/5. The demultiplexer method in Fig. 2(d) is called Type 1-4 of 256QAM. That is, for the type 1-4, when the bit-interleaved input bits are entered in the order of 0, 1, 2, 3, 4, 5, 6, 7, the demultiplexer will output 3, 2, 1, 5, 7, 6, 4, 0. It will be symbol-mapped as is in the demultiplexer. In that case, the distribution of reliability will be B, B, A, C, D, D, C, A from the first bit to the last bit of the LDPC codeword.

Fig. 55 (e) shows an output order of a demultiplexer when the code rate is 1/3, 2/3, 3/4 and 5/6. The demultiplexer method in Fig. 2(e) is called Type 1-5 of 256QAM. That is, for the type 1-5, when the bit-interleaved input bits are entered in the order of 0, 1, 2, 3, 4, 5, 6, 7, the demultiplexer will output 7, 3, 1, 5, 2, 6, 4, 0. It will be symbol-mapped as is in the demultiplexer. In that case, the distribution of reliability will be D, B, A, C, B, D, C, A from the first bit to the last bit of the LDPC codeword.

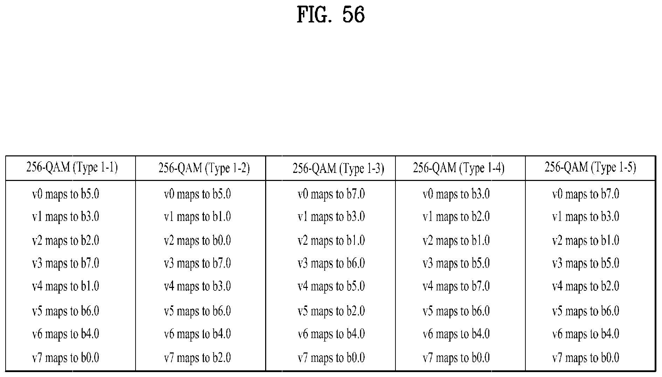

Fig. 56 shows a mapping relationship of input bits and output bits of a demultiplexer based on the demultiplexer type in Fig. 55.

As for 256QAM, 8 bits are mapped in one QAM symbol. b0, b2, b4, and b6 determine a sign and size of a real number part and b1, b3, b5, and b7 determine a sign and size of an imaginary part. That is, b0 and b1 determine a sign of the real and imaginary number part, and b2, b3, b4, b5, b6, and b7 determine a size of the real and imaginary number part. Since it is easier to determine the sign of the converted symbols than the size of them, b0 and b1 located in MSB have the highest reliability and b6 and b7 located in LSB have the lowest reliablity.

If the demultiplexer operates with type 1-1 of 256QAM, by the bit-redistribution of the demultiplexer, the last bit (V7) of one sub-stream in the symbol mapper will be allocated in the sign bit (b0, 0) of the real number, the fifth bit (v4) in the sign bit (b1, 0) of the imaginary number. And the third, seventh, and sixth bit (v2, v6, v5) will be allocated in the size bits (b1, 0, b4, 0, b6, 0) respectively, and the second, first, fourth bit (v1, v0, v3) in the size bits (b3, 0, b5, 0, b7, 0) of the imaginary number part.

As for the last type, that is, type 1-2 and type 1-5 have the same mapping method as type 1-1. Thus, further description is omitted.

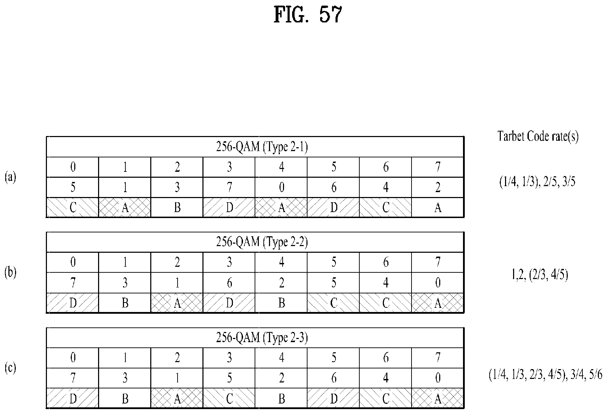

Fig. 57 (a) and (c) shows an output order of a demultiplexer based on the code rate when the LDPC block length is 16800 and the modulation format is 256QAM.

Fig. 57 (a) shows an output order of a demultiplexer when the code rate is 1/4, 1/3, and 3/5. The demultiplexer method in Fig. 57 (a) is called Type 2-1 of 256QAM. That is, for the type 2-1, when the bit-interleaved input bits are entered in the order of 0, 1, 2, 3, 4, 5, 6, 7, the demultiplexer will output 5, 1, 3, 7, 0, 6, 4, 2. It will be symbol-mapped as is in the demultiplexer. In that case, the distribution of reliability will be C, A, B, D, A, D, C, B from the first bit to the last bit of the LDPC codeword.

Fig. 57 (b) shows an output order of a demultiplexer when the code rate is 1/2, 2/3, and 4/5. The demultiplexer method in Fig. 57 (b) is called Type 2-2 of 256QAM. That is, for the type 2-2, when the bit-interleaved input bits are entered in the order of 0, 1, 2, 3, 4, 5, 6, 7, the demultiplexer will output 7, 3, 1, 6, 2, 5, 4, 0. It will be symbol-mapped as is in the demultiplexer. In that case, the distribution of reliability will be D, B, A, D, B, C, C, A from the first bit to the last bit of the LDPC codeword.

Fig. 57 (c) shows an output order of a demultiplexer when the code rate is 1/4, 1/3, 2/3, 4/5, 3/4, and 5/6. The demultiplexer method in Fig. 57 (c) is called Type 2-3 of 256QAM. That is, for the type 2-3, when the bit-interleaved input bits are entered in the order of 0, 1, 2, 3, 4, 5, 6, 7, the demultiplexer will output 7, 3, 1, 5, 2, 6, 4, 0. It will be symbol-mapped as is in the demultiplexer. In that case, the distribution of reliability will be D, B, A, C, B, D, C, A from the first bit to the last bit of the LDPC codeword.

In Fig. 57, when the code rate is 1/4 or 1/3, type 2-1 or type 2-3 of the multiplexer may be used. Also, when the code rate is 2/3 or 4/5, type 2-2 or 2-3 of the demultiplexer may be used.

If as shown in Fig. 57 the reliability distribution is performed, the complexity of the system will be reduced because the number of multiplexers can be reduced compared to Fig. 55.

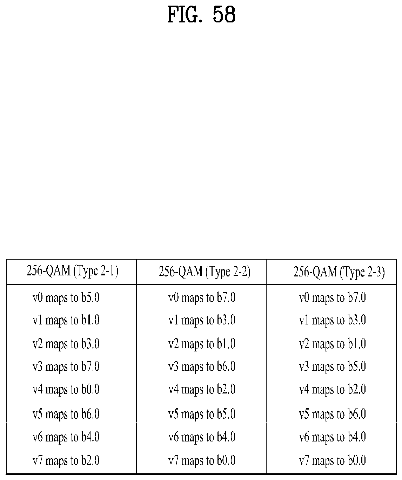

Fig. 58 shows a mapping relationship of input and output bits of the demultiplexer.

If the demultiplexer operates with type 2-1 of 256QAM, by the bit-redistribution of the demultiplexer, the fifth bit (v4) of one sub-stream in the symbol mapper will be allocated in the sign bit (b0, 0) of the real number part, the second bit (v1) in the sign bit (b1, 0) of the imaginary number. And the eighth, seventh, and sixth bit (v7, v6, v5) will be allocated in the size bits (b2, 0, b4, 0, b6, 0) respectively, and the third, first, fourth bit (v2, v0, v3) in the size bits (b3, 0, b5, 0, b7, 0) of the imaginary number part.

As for the last type, that is, type 2-2 and type 2-3 have the same mapping method as type 2-1. Thus, further description is omitted.

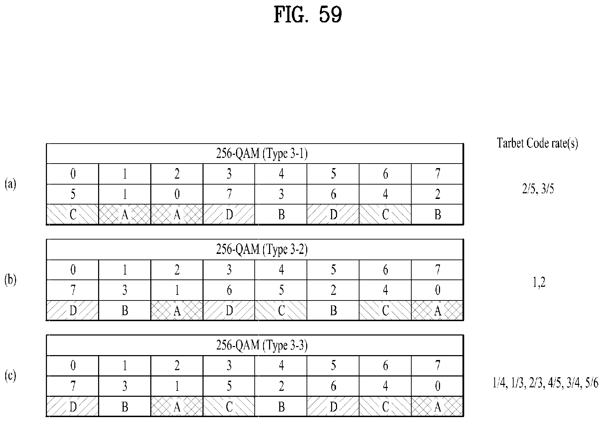

Fig. 59 (a) and (c) shows an output order of a demultiplexer based on the code rate when the LDPC block length is 16800 and the modulation format is 256QAM.

Fig. 59 (a) shows an output order of a demultiplexer when the code rate is 2/5, and 3/5. The demultiplexer method in Fig. 59 (a) is called Type 3-1 of 256QAM. That is, for the type 3-1, when the bit-interleaved input bits are entered in the order of 0, 1, 2, 3, 4, 5, 6, 7, the demultiplexer will output 5, 1, 0, 7, 3, 6, 4, 2. It will be symbol-mapped as is in the demultiplexer. In that case, the distribution of reliability will be C, A, A, D, B, D, C, B from the first bit to the last bit of the LDPC codeword.

Fig. 59 (b) shows an output order of a demultiplexer when the code rate is 1/2. The demultiplexer method in Fig. 59 (b) is called Type 3-2 of 256QAM. That is, for the type 3-2, when the bit-interleaved input bits are entered in the order of 0, 1, 2, 3, 4, 5, 6, 7, the demultiplexer will output 7, 3, 1, 6, 5, 2, 4, 0. It will be symbol-mapped as is in the demultiplexer. In that case, the distribution of reliability will be D, B, A, D, C, B, C, A from the first bit to the last bit of the LDPC codeword.

Fig. 59 (c) shows an output order of a demultiplexer when the code rate is 1/4, 1/3, 2/3, 4/5, 3/4 and 5/6. The demultiplexer method in Fig. 59 (c) is called Type 3-3 of 256QAM. Type 3-3 operates the same as type 2-3. Thus, type 3-3 is also called type 2-3.

If as shown in Fig. 59 the reliability distribution is performed, the complexity of the system will be reduced because the number of multiplexers can be reduced compared to Fig. 2.

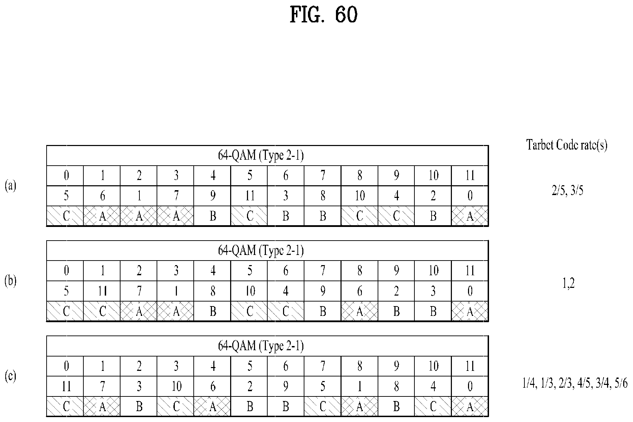

Fig. 60 (a) and (c) show an output order of a demultiplexer based on each code rate when the LDPC block length is 16800 and the modulation format is 256QAM. If the modulation format is 256QAM, 6 bit units are mapped in one symbol.

When Fig. 60 (a) shows an output order of a demultiplexer when the code rate is 2/5 and 3/5. The demultiplexer method in Fig. 60 (a) is called Type 2-1 of 64QAM. That is, for the type 2-1, when the bit-interleaved input bits are entered in the order of 0, 1, 2, 3, 4, 5, 6, 7, 8, 9, 10, 11, the demultiplexer will output 5, 6, 1, 7, 9, 11, 3, 8, 10, 4, 2, 0. It will be symbol-mapped as is in the demultiplexer. In that case, the distribution of reliability will be C, A, A, A, B, C, B, B, C, C, B, A from the first bit to the last bit of the LDPC codeword. Here, the hierarchy of reliability is from A to D, A being the highest and D being the lowest.

When Fig. 60 (b) shows an output order of a demultiplexer when the code rate is 1/2. The demultiplexer method in Fig. 60 (b) is called Type 2-2 of 64QAM. That is, for the type 2-2, when the bit-interleaved input bits are entered in the order of 0, 1, 2, 3, 4, 5, 6, 7, 8, 9, 10, 11, the demultiplexer will output 5, 11, 7, 1, 8, 10, 4, 9, 6, 2, 3, 0. It will be symbol-mapped as is in the demultiplexer. In that case, the distribution of reliability will be C, C, A, A, B, C, C, B, A, B, B, A From the first bit to the last bit of the LDPC codeword.

When Fig. 60 (c) shows an output order of a demultiplexer when the code rate is 1/4, 1/3, 2/3, 4/5, 3/4, and 5/6. The demultiplexer method in Fig. 60 (c) is called Type 2-3 of 64QAM. That is, for the type 2-3, when the bit-interleaved input bits are entered in the order of 0, 1, 2, 3, 4, 5, 6, 7, 8, 9, 10, 11, the demultiplexer will output 11, 7, 3, 10, 6, 2, 9, 5, 1, 8, 4, 0. It will be symbol-mapped as is in the demultiplexer. In that case, the distribution of reliability will be C, A, B, C, A, B, B, C, A, B, C, A From the first bit to the last bit of the LDPC codeword.

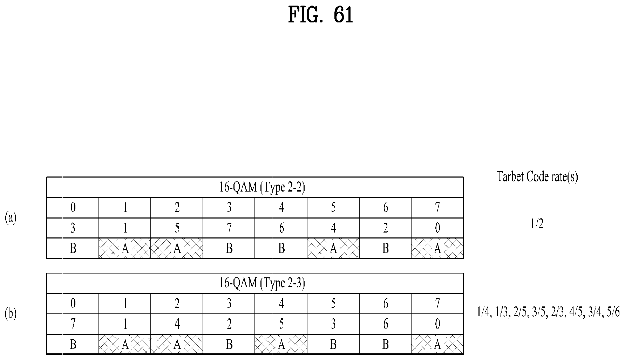

Fig. 61 (a) and (b) shows an output order of a demultiplexer based on the code rate when the LDPC block length is 16800 and the modulation format is 16QAM.

When Fig. 61 (a) shows an output order of a demultiplexer when the code rate is 1/2. The demultiplexer method in Fig. 61 (a) is called Type 2-2 of 16QAM. That is, for the type 2-2, when the bit-interleaved input bits are entered in the order of 0, 1, 2, 3, 4, 5, 6, 7,the demultiplexer will output 3, 1, 5, 7, 6, 4, 2, 0. It will be symbol-mapped as is in the demultiplexer. In that case, the distribution of reliability will be B, A, A, B, B, A, B, A from the first bit to the last bit of the LDPC codeword.

When Fig. 61 (b) shows an output order of a demultiplexer when the code rate is 1/4, 1/3, 2/5, 3/5, 2/3, 4/5, 3/4, 5/6. The demultiplexer method in Fig. 61 (b) is called Type 2-3 of 16QAM. That is, for the type 2-3, when the bit-interleaved input bits are entered in the order of 0, 1, 2, 3, 4, 5, 6, 7, the demultiplexer will output 7, 1, 4, 2, 5, 3, 6, 0. It will be symbol-mapped as is in the demultiplexer. In that case, the distribution of reliability will be B, A, A, B, A, B, B, A from the first bit to the last bit of the LDPC codeword.

As shown above, the demultiplexer type can be varied based on the symbol mapping method and the code rate of error correction codes. In other words, a different type of demultiplexer can be used based on the symbol mapping method, code rate, and the reliability distribution.

And the same effect will be obtained by switching the bit positions of the same reliability. Thus, if the distribution of reliability in Fig. 55 and Fig. 61 is satisfied, it will be included in the demultiplexer of the present invention regardless of the type of bits.

The bit rearrangement is performed based on the modulation format and code rate of the demultiplexer and the symbol mapping is performed based on the modulation format in the symbol mapper. Then, the transmitted signal will obtain the original arrangement of the LDPC codeword from the multiplexer of the receiver and transmitted to the LDPC decoder.

By doing so, new services under lower code rate such as mobile service and a indoor service where reception is weak will have the optimized error correction performance of LDPC. That is, as shown in Fig. 55 and Fig, 61, by distributing reliability, bit-redistirbuting, and symbol mapping, the commonality of the existing broadcast/communications system is secured and improved robustness is obtained.

In the following, when pair-wise cell mappers 605120, 605220 according to a first and a second embodiments shown in Fig. 33 pairs up PLP data and L1-signaling data and performs cell mapping into OFDM symbols, a cell mapping structure in a frame is described. Also, according to the first and the second embodiments in Fig. 37, the performance of a pair-wise cell demappers 611120, 611220 corresponding to the cell mappers is described. As mentioned, when a broadcast signal transmitting/receiving system using such a frame structure restores MISO signals, coherence between channels received from different antennas will be maximized.

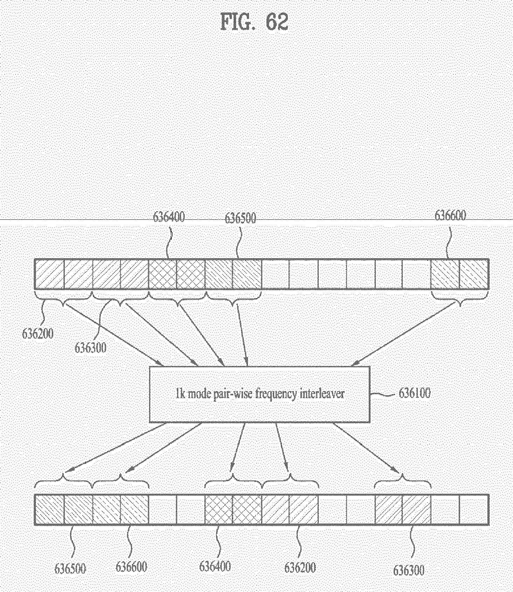

Fig. 62 shows a process of interleaving by a pair-wise frequency interleaver.

In the following, when pair-wise cell mappers 605120, 605220 according to a first and a second embodiments shown in Fig. 33 pairs up PLP data and L1-signaling data and performs cell mapping into OFDM symbols, a cell mapping structure in a frame is described. Also, according to the first and the second embodiments in Fig. 37, the performance of a pair-wise cell demappers 611120, 611220 corresponding to the cell mappers is described. As mentioned, when a broadcast signal transmitting/receiving system using such a frame structure restores MISO signals, coherence between channels received from different antennas will be maximized.

As shown in Fig. 62, the pair-wise frequency interleaver 636100 is another embodiment of the pair-wise frequency interleaver 605130, 605230 according to the first and the second embodiments in Fig. 33.

The pair-wise frequency interleaver 636100 performs frequency interleaving in the mapped data in the frame into cell units and transmits the data to an OFDM generator. The horizontal axis of the frame in Fig. 62 indicates a frequency domain, and the pair-wise frequency interleaver 636100 has a 1K FFT mode size.

In that case, the pair-wise frequency interleaver 636100 performs frequency interleaving in two consecutive cells into one interleaving unit. In that case, the pair-wise frequency interleaver 636100 performs frequency interleaving in a even number, equal to or greater than two, of consecutive cells into one interleaving unit, and transmits the related signaling information.

The interleaving process is further illustrated.

As shown in Fig. 62, if the two consecutive cells 636200 mapped in a frame by the pair-wise cell mapper are transmitted to the pair-wise frequency interleaver 636100, the pair-wise frequency interleaver 636100 can perform interleaving in the two consecutive cells 636200 into interleaving units. Thus, the two consecutive cells 636200 may switch positions only in pairs in the frame.

If other two consecutive cells 636300, 636400, 636500, 636600 are inputted and interleaved by the pair-wise frequency interleaver 636100, they may also switch positions only in pairs.

Thus, as two consecutive cells in one interleaving unit transmit the same PLP data, coherence between channels of the receiving unit can be maximized. However, the two consecutive cells 636200, 636300, 636400, 636500, 636600 in pairs shown in Fig. 62

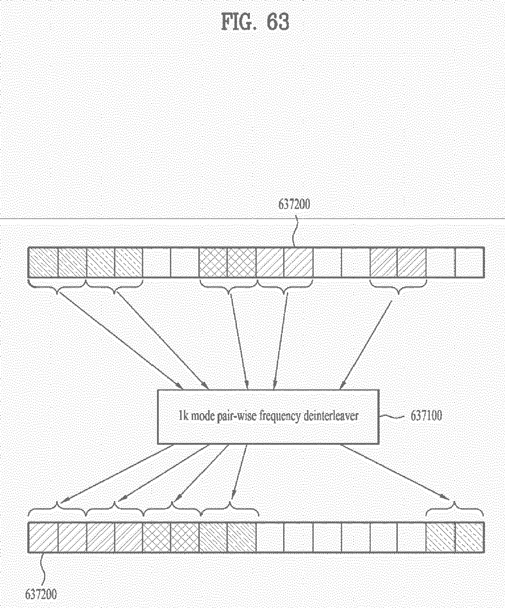

Fig. 63 shows a process of deinterleaving by the pair-wise frequency deinterleaver according to the present invention.

The pair-wise frequency deinterleaver 637100 in Fig. 63 is an embodiment of the pair-wise frequency deinterleaver 61110, 611210 according to the first and the second embodiments.

The pair-wise frequency deinterleaver 637100 performs frequency deinterleaving in the mapped data in the frame into cell units and transmits the data to a cell demapper. The horizontal axis of the frame in Fig. 63 indicates a frequency domain, and the pair-wise frequency deinterleaver 637100 has a 1K FFT mode size.

The pair-wise frequency deinterleaver 637100 in Fig. 63 performs the reverse process of the pair-wise frequency interleaver 636100 in Fig. 62.

Thus, if the two consecutive cells 637200 mapped in a frame by the pair-wise cell mapper are transmitted to the pair-wise frequency deinterleaver 637100, the pair-wise frequency deinterleaver 637100 can perform deinterleaving in the two consecutive cells 637200 into deinterleaving units. Thus, the two consecutive cells 636200 may switch back to the original positions only in pairs in the frame.

In that case, the pair-wise frequency deinterleaver 637100 performs frequency deinterleaving in a even number, equal to or greater than two, of consecutive cells into one deinterleaving unit by using the signaling information.

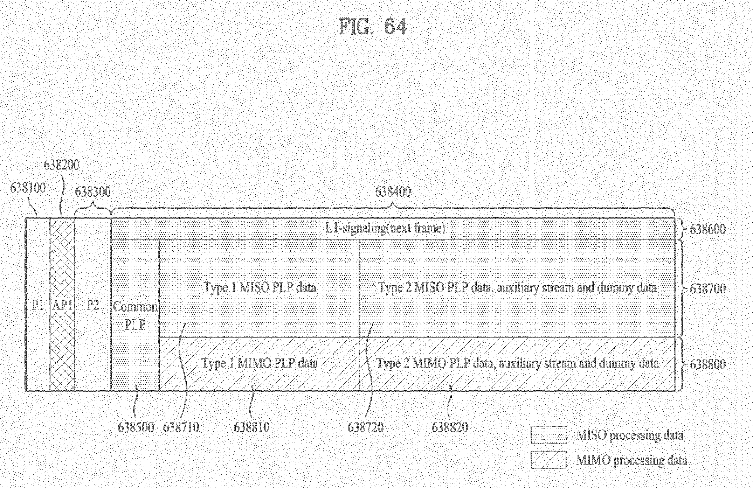

Fig. 64 shows a cell mapping structure in a frame according to the first and the second embodiments.

As shown in Fig. 32 and Fig. 35, the BICM encoder according to the first and the second embodiments independently performs MISO/MIMO encoding in PLP data. As shown in Fig. 33, the cell mapper according to the first and the second embodiments performs mapping in a sub-carrier of the OFDM symbols into cell units in the MISO/MIMO encoded MISO PLP data, L1-signaling data, and MIMO encoded MOMO PLP data. In that case, the two consecutive cells in pairs can be mapped as the designer intends.

A cell mapping structure in a frame is described.

The frame includes a P1 symbol area 638100, an AP1 symbol area 638200, a P2 symbol area 638300 and a data symbol area 638400. The vertical axis of the frame indicates a frequency domain and the horizontal axis indicates a time domain.

The P1 symbol area 638100 is located in the beginning of the frame and transmits P1 signaling information.

The AP1 symbol area 638200 is located right next to the P1 symbol 638100 and transmits AP1 signaling information. That is, the P1 symbol and the AP1 symbol can be continuously transmitted in the frame and may not be continuously transmitted in one frame.

The P2 symbol area 638300 can be located next to the AP1 symbol area 638200 in the frame and transmits the MISO encoded L1-signaling data.

The L1-signaling information includes L1-pre signaling information and L1-post signaling information. The L1-pre signaling information includes parameters necessary for decoding the L1-post signaling information, and the L1-post signaling information includes information necessary for restoring data transmitted from the transmitting unit on the receiving unit. The P2 symbol area 638200 includes a plurality of the P2 symbols and a plurality of the P2 symbols have the same FFT size and guard interval as the data symbol. Also, the number of the P2 symbols is determined by the FFT size.

According to the present invention, the P1 symbol area 638100 and the AP1 symbol area 638200 and P2 symbol area 638300 are called preamble. Also, according to the present invention, the P1 symbol area 638100, AP1 symbol area 638200, P2 symbol area 638300 and common PLP data area are called preamble.

The data symbol area 638400 can transmit PLP data and L1-post signaling data and can be located next to the P2 symbol area 638300. Also, the data symbol area 638400 includes a common PLP area 638500, a L1-signaling area 638600, a MISO PLP area 638700, and a MIMO PLP area 638800. Each area is further illustrated below.

The common PLP area 638500 transmits the MISO encoded common PLP data. The common PLP data is the same as that in Fig. 3. Thus, further description is omiited.

The L1-signaling area 638600 transmits MISO encoded L1-signaling data. In that case, the L1-signaling data can include information for the current frame and the next frame and can be spread, mapped in the OFDM symbols in the data area 638400. Thus, full time diversity may be gained in the time domain.

The MISO PLP area 638700 transmits MISO encoded MISO PLP data. The MISO PLP area 638700 includes a first MISO PLP area 638710 transmitting type 1 MISO PLP data into one sub-slice per frame, a second MISO PLP area 638720 transmitting type 2 MISO PLP data, sub-stream and dummy data into a plurality of sub slices.

The MIMO PLP area 638800 transmits MIMO encoded MIMO PLP data. The MIMO PLP area 638800 includes a first MIMO PLP area 638810 transmitting type 1 MIMO PLP data into one sub-slice per frame and a second MIMO PLP area 638820 transmitting type 2 MIMO PLP data, sub-stream, and dummy data to a plurality of sub slices.

Thus, in the time domain of the frame in the present invention, as the MISO PLP data and MIMO PLP data are all spread in the OFDM symbols in the data symbol area 638400 and transmitted, a time diversity gain with respect to the entire frame may be received.

However, in the frequency domain of the frame in the present invention, as the MISO PLP data and MIMO PLP data are transmitted through MIMO PLP area 638700 and MIMO PLP area 63800 in the one OFDM symbol, a limited frequency diversity gain may be gained in the frequency domain.

The performance of the broadcast signal receiver in the frame is illustrated below.

As shown in Fig. 37, the cell demapper detects L1-signaling information about the current frame from the P2 symbol area 638300, L1-signaling information about the next frame that will be received from the L1-siganling area 638600 of the data symbol area 638400, and transmit it to the BICM decoder.

Also, the cell demapper detects PLP data having the user selected service data and transmits it to the BICM decoder. In that case, if necessary, the common PLP data can be extracted from the common PLP area 638500 and transmitted to the BICM decoder.

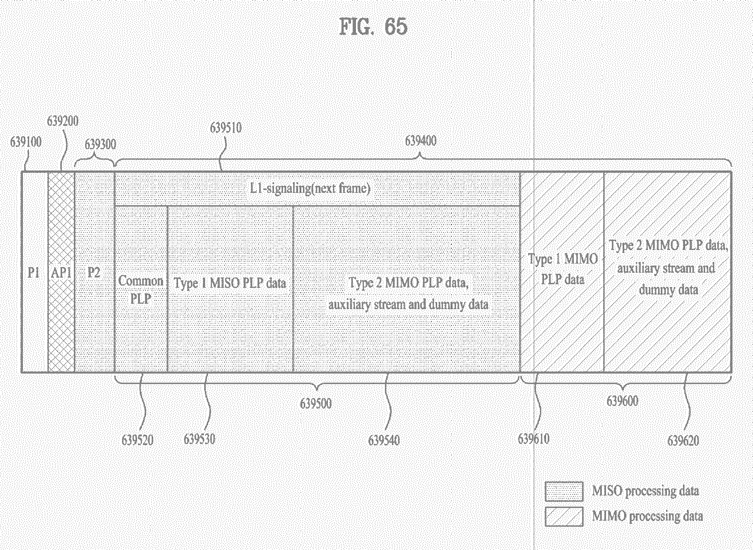

Fig. 65 shows an embodiment of a cell mapping structure in a frame according to the third and the fourth embodiments.

As shown in Fig. 44, the OFDM generator according to the third embodiment performs MISO encoding in MISO PLP data and L1-signaling data and MIMO encoding in MIMO PLP data.

As shown in Fig. 45 and 46, the BICM encoder according to the fourth embodiment performs MIMO encoding in the MIMO PLP data and as shown in Fig. 47, the OFDM generator performs MISO encoding in MISO PLP data and L1-signaling data.

Thus, the cell mapper performs mapping into a sub-carrier of the OFDM symbols in cell units in MISO PLP data, signaling data for MISO encoding according to the third embodiment, and MISO PLP data and L1-signaling data, MIMO PLP data for MIMO encoding. Also, as the OFDM generator performs MISO/MIMO encoding in OFDM symbol units, the cell mapper does not map MISO PLP data and MIMO PLP data into one OFMD symbol.

A cell mapping structure in a frame is illustrated.

As shown in Fig. 64, the frame of the present invention includes the P1 symbol area 639100, the AP1 symbol area 639200, the P2 symbol area 639300 and the data symbol area 639400. The vertical axis of the frame indicates a frequency domain and the horizontal axis indicates a time domain. The same areas in Fig. 67 are omitted.

The data symbol area 639400 can transmit PLP data and signaling data and can be located next to the P2 symbol area 639300. Also, the data symbol area 639400 includes a MISO PLP area 639500, and a MIMO PLP area 639600. Each area is further illustrate below.

The MISO PLP area 639500 transmits data for MISO processing. That is L1-signaling data, common PLP data, and MISO PLP data can be transmitted. The MISO PLP area 639600 includes a L1-signaling area 639510 transmitting L1-signaling data for MISO encoding, a common PLP data area 639820 transmitting common PLP data for MISO encoding, a first MISO PLP area 639530 transmitting type 1 MISO PLP data by a sub-slice, and a second MISO PLP area 639540 transmitting sub-stream and dumy data transmitted by a plurality of sub slices.

In that case, the L1-signaling data includes information about the current frame and the next frame and can be mapped spread in the MISO PLP area 639500.

The MIMO PLP area 639600 transmits MIMO PLP data for MIMO processing according to the third embodiment and the MIMO PLP data for MIMO processing according to the fourth embodiment. The MIMO PLP area 638800 includes a first MIMO PLP area 639610 transmitting type 1 MIMO PLP data by one sub-slice per frame and a second MIMO PLP area 639620 transmitting type 2 MIMO PLP data, sub-stream, and dummy data to a plurality of sub slices.

Thus, in the time domain of the frame in the present invention, as the data for MISO processing and data for MISO processing are all transmitted to the MISO PLP area 639500 or the MIMO PLP area 639600, a full frequency diversity gain in the frequency domain can be obtained.

Thus, in the time domain of the frame in the present invention, as the MISO PLP data and MIMO PLP data are transmitted to the MISO PLP area 639500 and the MIMO PLP area 639600, a time diversity gain with respect to the entire frame may be received.

In the following, the performance of receiving frames by a broadcast signal receiver is illustrated.

As shown in Fig. 51, according to the third and the fourth embodiments, the cell demapper detects L1-signaling information about the current frame from the P2 symbol area 639300, L1-signaling information about the next frame that will be received from the L1-siganling area 639510 of the MISO PLP area 639500, and transmit it to the BICM decoder.

Also, the cell demapper detects PLP data having the user selected service data from the data symbol area 639400 and transmits it to the BICM decoder. In that case, if necessary, the common PLP data can be extracted from the common PLP area 639520 and transmitted to the BICM decoder.

In the following, a method of receiving by a broadcast signal receiver is re-illustrated. In other words, the performance of the broadcast signal transmitter in Fig. 2, Figs. 49-51.

In the following, PLP data includes PLP data for MIMO process and PLP data for MISO process. And signaling information includes information illustrated in Fig. 6, Fig. 8, Fig. 25, and Fig. 28. Also, the following broadcast signals include frames of the structures.

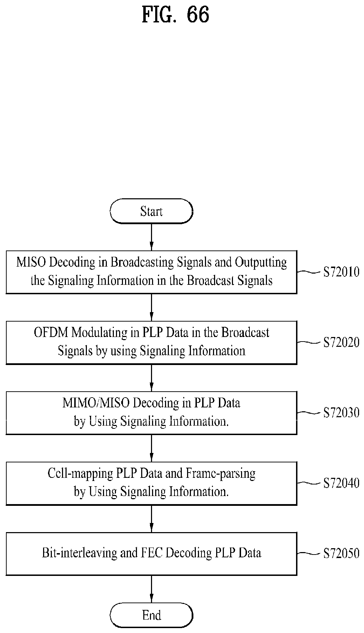

Fig. 66 shows a method of broadcast signal receiving according to an embodiment of the present invention.

The BSR performs MISO decoding in the received broadcast signals and transmits signaling information included in the broadcast signals. (S72010)

The signaling information in the broadcast signals includes information described in Fig. 6, Fig. 8, Fig. 25, and Fig. 28.

Broadcast signals received by the BSR according to an embodiment of the present invention can include a plurality of frames. As shown in Fig. 3, according to an embodiment of the present invention, the frame can have a preamble area and a data area. The preamble area can have a P1 symbol and a P2 symbol, and the data area can have a plurality of the data symbol. In that case, the present invention can allocate an Additional Preamble symbol (AP1). As the designer intends, there can be a plurality of AP1 symbol.

Accordingly, the preamble area of the frame can have a P1 symbol, more than one AP1 symbol, and more than one P2 symbol. In addition, the data area can have a plurality of the data symbol, also known as data OFDM symbol. P2 symbol is optional and whether the P2 symbol is to be inserted is determined by AP1 signaling information in the transmitted AP1 symbol.

The P1 symbol can carry a type of transmission and basic transmission parameters and the receiver can detect a frame by using the P1 symbol. There can be more than one P2 symbol and the P2 symbol can carry L1 signaling information and common PLP signaling information. The L1 signaling information can have L1-pre signaling information and L1-post signaling information and the common PLP signaling information can have Network Information Table (NIT), PLP information, Service Description Table (SDT), and Event Information Table (EIT). A plurality of the data symbols located at the end of the P2 symbol can have a plurality of the PLP data.

According to an embodiment of the present invention, the BSR obtains signaling information in a frame by performing OFDM demodulating, MISO decoding, frame-parsing, and BICM decoding. L1-pre signaling information includes information necessary for receiving and decoding L1-post signaling information and L1-post signaling information include parameters necessary for encoding PLP data. As PLP data indicates data that can be perceived in a physical layer, the BSR selectively performs PLP data having only desired services by using the L1-pre signaling information and L1-post signaling information.

The BSR performs OFDM demodulating in PLP data by using signaling information. (S72020)

The BSR demodulates the PLP data by utilizing the OFDM modulator as shown in Fig. 49. If PLP data is performed by MIMO/MISO process, the BSR can receive the data through a plurality of antennas. The BSR utilizes a first OFDM demodulating block to perform demodulating in data through a first antenna, and a second OFDM demodulating block to perform demodulating in data through a second antenna.

The BSR performs MISO/MIMO decoding in PLP data by using signaling information. (S72030)

The BSR, as shown in Fig. 49, performs MIMO/MISO decoding in the PLP data by using a MIMO/MISO decoder. The BSR determines by using signaling information whether PLP data is MISO type or MIMO type and performs MISO/MIMO decoding accordingly. If the BSR performs MIMO decoding, MIMO matrix as shown in Fig. 12 and Fig. 21 can be used.

The BSR performs frame-parsing by cell demapping the PLP data and the signaling information. (S72040)

The BSR performs frame-parsing by cell demapping the PLP data by using a frame demapper as shown in Fig. 50. The BSR performs frame-parsing in PLP data in a first OFDM demodulating block through a first route by using a first frame demapping block and in PLP data in a second OFDM demodulating block through a second route by using a second frame demapping block. And, the frame demapper determines whether the data is MIMO/MISO type data and transmits the data accordingly.

The BSR performs Bit-deinterleaving and FEC decoding in PLP data by using signaling information. (S72050)

The BSR, as shown in Fig. 51, performs bit-interleaving and FEC decoding in PLP data by using a BICM decoder. That is, the BSR uses a first BICM decoding block to perform BICM decoding in the MISO-type PLP data and a second BICM decoding block to perform BICM decoding in the MIMO-type PLP data.

[Modes for Invention]

Details about modes for the present invention have been described in the above best mode.

[Industrial Applicability]

As described above, the present invention can be wholly or partially applied to digital broadcast systems.

**Claims**

1. A method for receiving broadcast signals, the method comprising;

   receiving at least two broadcast signals data and demodulating the received broadcast signals by an Orthogonal Frequency Division Multiplexing, OFDM, method;
   frequency de-interleaving the demodulated broadcast signals by a pair of consecutive cells;
   parsing at least two signal frames from the frequency de-interleaved broadcast signals, wherein at least one signal frame includes preamble symbols and data symbols; and
   decoding Physical Layer Pipe, PLP, data in the data symbols and signaling information in the preamble symbols of the parsed at least two signal frames wherein the decoding further comprises
Multi-Input Single-Output, MISO decoding first PLP data, Multi-Input Multi-Output, MIMO, decoding second PLP data and MISO decoding the signaling information, wherein the MIMO decoding second PLP data further includes:

time de-interleaving the second PLP data;
Multi-Input Multi-Output, MIMO, processing the time de-interleaved second PLP data;
Quadrature Amplitude Modulation, QAM, de-mapping the MIMO processed second PLP data;
Low Density Parity Check, LDPC, decoding the QAM de-mapped second PLP data; and
Bose-Chadhuri-Hocquenghem, BCH, decoding the LDPC decoded second PLP data.

2. The method of claim 1, wherein the signaling information includes information indicating time de-interleaving type.

3. The method of claim 1, wherein MISO decoding first PLP data further includes:

QAM de-mapping the MISO decoded first PLP data; and
multiplexing the QAM de-mapped first PLP data.

4. The method of claim 1, wherein the PLP data are mapped by a pair of consecutive cells.

5. An apparatus for receiving broadcast signals, the apparatus comprising;

a demodulator (107100) for receiving at least two broadcast signals and demodulating the received broadcast signals by an Orthogonal Frequency Division Multiplexing, OFDM, method;
a frequency de-interleaver (611110, 611210) for frequency de-interleaving the demodulated broadcast signals by a pair of consecutive cells;
a de-mapper (611120, 611220) for demapping Physical Layer Pipe, PLP, data and signaling information from at least two signal frames in the frequency de-interleaved broadcast signals, wherein at least one signal frame includes preamble symbols having the signaling information and data symbols having the PLP data; and
a BICM decoder (107300) for decoding the demapped PLP data and the demapped signaling information, wherein the BICM decoder further comprises

a first BICM decoding block (615100) for Multi-Input Single-Output, MISO decoding first PLP data,
a second BICM decoding block (615200) for Multi-Input Multi-Output, MIMO decoding second PLP data and
a third BICM decoding block (615300) for MISO decoding signaling information, wherein the second BICM decoding block further includes

a time de-interleaver (612220-0, 612220-1) for time de-interleaving data the second PLP data;
a MIMO processor (615210) for Multi-Input Multi-Output, MIMO, processing the time de-interleaved second PLP data;
a Quadrature Amplitude Modulation, QAM, de-mapper (612240-0,612240-1) for QAM de-mapping the MIMO processed second PLP data; and
a decoder (612270) for Low Density Parity Check, LDPC, decoding the QAM de-mapped second PLP data and Bose-Chadhuri-Hocquenghem, BCH, decoding the LDPC decoded second PLP data,

6. The apparatus of claim 5, wherein the signaling information includes information indicating time de-interleaving type.

7. The apparatus of claim 5, wherein the first BICM decoding block further includes:

a second QAM, de-mapper (612140) for de-mapping the MISO decoded first PLP data; and
a demultiplexer (612150) for multiplexing the de-mapped the first PLP data.

8. The apparatus of claim 5, wherein the PLP data are mapped by a pair of consecutive cells.

**Patentansprüche**

1. Verfahren zum Empfang von Rundfunksignalen, wobei das Verfahren Folgendes umfasst;

Empfangen von mindestens zwei Rundfunksignaldaten und Demodulieren der empfangenen Rundfunksignale durch ein Orthogonales Frequenzmultiplex(Orthogonal Frequency Division Multiplexing, OFDM)-Verfahren;
Frequenzentschachteln der demodulierten Rundfunksignale durch ein Paar aufeinanderfolgende Zellen;
Parsen von mindestens zwei Signalrahmen von den frequenzentschachtelten Rundfunksignalen, wobei wenigstens ein Signalrahmen Präambelsymbole und Datensymbole enthält; und
Decodieren von PLP(Physical Layer Pipe, PLP)-Daten in den Datensymbolen und von Signalisierungsdaten in den Präambelsymbolen der mindestens zwei geparsten Signalrahmen, wobei das Decodieren ferner umfasst:

Mehrfacheingang-Einzelausgang(Multi-Input Single-Output, MISO)-Decodieren erster PLP-Daten, Mehrfacheingang-Mehrfachausgang(Multi-Input Multi-Output, MIMO)-Decodieren zweiter PLP-Daten und MISO-Decodieren der Signalisierungsdaten, wobei das MIMO-Decodieren zweiter PLP-Daten des weiteren aufweist:

Zeitentschachteln der zweiten PLP-Daten;
Mehrfacheingang-Mehrfachausgang(Multi-Input Multi-Output, MIMO)-Verarbeiten der zeitentschachtelten zweiten PLP-Daten;
Quadraturamplitudenmodulation(Quadrature Amplitude Modulation, QAM)-Rückabbilden der MIMO-verarbeiteten zweiten PLP-Daten;
Low-Density-Parity-Check(LDPC)-Decodieren der dem QAM-Rückabbilden unterzogenen zweiten PLP-Daten; und
Bose-Chadhuri-Hocquenghem(BCH)-Decodieren der LDPC-decodierten zweiten PLP-Daten.

2. Verfahren nach Anspruch 1, wobei die Signalisierungsdaten Informationen enthalten, die einen Zeitentschachtelungstyp angeben.

3. Verfahren nach Anspruch 1, wobei das MISO-Decodieren erster PLP-Daten des weiteren aufweist:

QAM-Rückabbilden der MISO-decodierten ersten PLP-Daten; und
Multiplexen der dem QAM-Rückabbilden unterzogenen ersten PLP-Daten.

4. Verfahren nach Anspruch 1, wobei die PLP-Daten durch ein Paar aufeinanderfolgende Zellen abgebildet werden.

5. Vorrichtung zum Empfang von Rundfunksignalen, wobei die Einrichtung enthält:

einen Demodulator (107100) zum Empfangen von mindestens zwei Rundfunksignalen und zum Demodulieren der empfangenen Rundfunksignale durch ein Orthogonales Frequenzmultiplex(Orthogonal Frequency Division Multiplexing, OFDM)-Verfahren;
einen Frequenz-Deinterleaver (611110, 611210) zum Frequenzentschachteln der demodulierten Rundfunksignale durch ein Paar aufeinanderfolgende Zellen;
einen Rückabbilder (611120, 611220) zum Rückabbilden von PLP(Physical Layer Pipe, PLP)-Daten und von Signalisierungsdaten von mindestens zwei Signalrahmen in den frequenzentschachtelten Rundfunksignalen, wobei wenigstens ein Signalrahmen Präambelsymbole enthält, die die Signalisierungsdaten und Datensymbole aufweisen, die die PLP-Daten enthalten; und
einen BICM-Decoder (107300) zum Decodieren der dem Rückabbilden unterzogenen PLP-Daten und der dem Rückabbilden unterzogenen Signalisierungsdaten, wobei der BICM-Decoder ferner aufweist:

einen ersten BICM-Decodierblock (615100) zum Mehrfacheingang-Einzelausgang(Multi-Input Single-Output, MISO)-Decodieren erster PLP-Daten,
einen zweiten BICM-Decodierblock (615200) zum Mehrfacheingang-Mehrfachausgang(Multi-Input Multi-Output, MIMO)-Decodieren zweiter PLP-Daten, und
einen dritten BICM-Decodierblock (615300) zum MISO-Decodieren von Signalisierungsdaten, wobei der zweite BICM-Decodierblock des weiteren aufweist:

einen Zeit-Deinterleaver (612220-0, 612220-1) zum Zeitentschachteln der zweiten PLP-Daten;
einen MIMO-Prozessor (615210) zum Mehrfacheingang-Mehrfachausgang(Multi-Input Multi-Output, MIMO)-Verarbeiten der zeitentschachtelten zweiten PLP-Daten;
einen Quadraturamplitudenmodulation (Quadrature Amplitude Modulation, QAM)-Rückabbilder (612240-0,612240-1) zum QAM-Rückabbilden der MIMO-verarbeiteten zweiten PLP-Daten; und
einen Decoder (612270) zum Low-Density-Parity-Check(LDPC)-Decodieren der dem QAM-Rückabbilden unterzogenen zweiten PLP-Daten und zum Bose-Chadhuri-Hocquenghem(BCH)-Decodieren der LDPC-decodierten zweiten PLP-Daten.

6. Vorrichtung nach Anspruch 5, wobei die Signalisierungsdaten Informationen enthalten, die einen Zeitentschachtelungstyp angeben.

7. Vorrichtung nach Anspruch 5, wobei der erste BICM-Decodierblock des weiteren aufweist:

einen zweiten QAM-Rückabbilder (612140) zum Rückabbilden der MISO-decodierten ersten PLP-Daten; und einen Demultiplexer (612150) zum Multiplexen der dem Rückabbilden unterzogenen ersten PLP-Daten.

8. Vorrichtung nach Anspruch 5, wobei die PLP-Daten durch ein Paar aufeinanderfolgende Zellen abgebildet werden.

**Revendications**

1. Procédé pour recevoir des signaux de diffusion, le procédé comprenant :

la réception de données d'au moins deux signaux de diffusion et la démodulation des signaux de diffusion reçus par un procédé de multiplexage par répartition orthogonale de la fréquence, OFDM ; le désentrelacement en fréquence des signaux de diffusion démodulés par l'intermédiaire d'une paire de cellules consécutives ; l'analyse d'au moins deux trames de signal à partir des signaux de diffusion désentrelacés en fréquence, dans lequel au moins une trame de signal inclut des symboles de préambule et des symboles de données ; et le décodage de données de tuyau de couche physique, PLP, dans les symboles de données et d'informations de signalisation dans les symboles de préambule des au moins deux trames de signal analysées, dans lequel le décodage comprend en outre le décodage à entrées multiples-sortie unique, MISO, de premières données de PLP, le décodage à entrées multiples-sorties multiples, MIMO, de secondes données de PLP et le décodage MISO des informations de signalisation, dans lequel le décodage MIMO de secondes données de PLP inclut en outre :

le désentrelacement en temps des secondes données de PLP ; le traitement à entrées multiples-sorties multiples, MIMO, des secondes données de PLP désentrelacées en temps ; le démappage à modulation d'amplitude en quadrature, QAM, des secondes données de PLP traitées MIMO ; le décodage à contrôle de parité à faible densité, LDPC, des secondes données de PLP démappées QAM ; et le décodage Bose-Chadhuri-Hocquenghem, BCH, des secondes données de PLP décodées LDPC.

2. Procédé selon la revendication 1, dans lequel les informations de signalisation incluent des informations indiquant le type de désentrelacement en temps.

3. Procédé selon la revendication 1, dans lequel le décodage MISO de premières données de PLP inclut en outre :

le démappage QAM des premières données de PLP décodées MISO ; et le multiplexage des premières données de PLP démappées QAM.

4. Procédé selon la revendication 1, dans lequel les données de PLP sont mappées par une paire de cellules consécutives.

5. Appareil pour recevoir des signaux de diffusion, l'appareil comprenant :

un démodulateur (107100) pour la réception d'au moins deux signaux de diffusion et la démodulation des signaux de diffusion reçus par l'intermédiaire d'un procédé de multiplexage par répartition orthogonale de la fréquence, OFDM ; un désentrelaceur en fréquence (611110, 611210) pour le désentrelacement en fréquence des signaux de diffusion démodulés par l'intermédiaire d'une paire de cellules consécutives ; un démappeur (611120, 611220) pour le démappage de données de tuyau de couche physique, PLP, et d'informations de signalisation à partir d'au moins deux trames de signal dans les signaux de diffusion désentrelacés en fréquence, dans lequel au moins une trame de signal inclut des symboles de préambule possédant les informations de signalisation et des symboles de données possédant les données de PLP ; et

un décodeur BICM (107300) pour le décodage des données de PLP démappées et des informations de signalisation démappées, dans lequel le décodeur BICM comprend en outre

un premier bloc de décodage BICM (615100) pour le décodage à entrées multiples-sortie unique, MISO, de premières données de PLP,

un deuxième bloc de décodage BICM (615200) pour le décodage à entrées multiples-sorties multiples, MIMO, de secondes données de PLP et

un troisième bloc de décodage BICM (615300) pour le décodage MISO d'informations de signalisation, dans lequel le deuxième bloc de décodage BICM inclut en outre

un désentrelaceur en temps (612220-0, 612220-1) pour le désentrelacement en temps de données des secondes données de PLP ;

un processeur MIMO (615210) pour le traitement à entrées multiples-sorties multiples, MIMO, des secondes données de PLP désentrelacées en temps ;

un démappeur à modulation d'amplitude en quadrature, QAM, (6122400, 612240-1) pour le démappage QAM des secondes données de PLP traitées MIMO ; et

un décodeur (612270) pour le décodage à contrôle de parité à faible densité, LDPC, des secondes données de PLP démappées QAM et le décodage Bose-Chadhuri-Hocquenghem, BCH, des secondes données de PLP décodées LDPC.

6. Appareil selon la revendication 5, dans lequel les informations de signalisation incluent des informations indiquant un type de désentrelacement en temps.

7. Appareil selon la revendication 5, dans lequel le premier bloc de décodage BICM inclut en outre :

un second QAM, démappeur (612140) pour le démappage des premières données de PLP décodées MISO ; et
un démultiplexeur (612150) pour le multiplexage des premières données de PLP démappées.

8. Appareil selon la revendication 5, dans lequel les données de PLP sont mappées par une paire de cellules consécutives.

EP 2 541 916 B1

FIG. 1

FIG. 2

```
                107100        107200        107300        107400

Antennas having  ┌──────────┐  ┌─────────┐  ┌─────────┐  ┌──────────┐  TS or
  polarities  →  │   OFDM   │→ │  Frame  │→ │  BICM   │→ │  Output  │→   GS
    (RX)      →  │demodulator│  │ parser  │→ │ decoder │→ │processor │→  Outputs
                └──────────┘  └─────────┘  └─────────┘  └──────────┘
```

# FIG. 3

Full transmission frame

Legend:
- L1-pre signaling information
- L1-post signaling information
- Type-1 PLPs (1...M1)
- type-2 PLPs (M1+1....M1+M2)
- multiple common PLPs
- Auxiliary stream
- Dummy cell

Labels: Time, Cell index, P1, P2 0, ···, P2 $N_{py-1}$, D 0, D 1, D 2, ···, Type-1 or type-2 PLP, OFDM symbols, D $L_{data}-1$

# FIG. 4

(A)

113110-1  113110-2      113110-n-1  113110-n  113120-1

| Basic frame | Basic frame | ..... | Basic frame | Basic frame | NEW frame (FEF) | ..... | Basic frame | Basic frame | Basic frame | NEW frame (FEF) |

FEF interval (N basic frames)

113100

113120-2

(B)

113210-1        113210-2

| Basic frame | NEW frame (FEF) | Basic frame | NEW frame (FEF) | Basic frame | NEW frame (FEF) | ..... | Basic frame | NEW frame (FEF) | Basic frame | NEW frame (FEF) |

FEF interval (one basic frame)

113220

113200

# FIG. 5

| BODY | P1 | P2 | BODY |

1K Symbol

| C | A | B |

$f_{SH}$      $f_{SH}$

$T_{P1C} = 59\mu s$    $T_{P1A} = 112\mu s$    $T_{P1B} = 53\mu s$

Both P1 structure and P1 generator
can be modified to generate
new system P1 symbol

(A) P1 symbol structure

114110

CDS
table
module

114120

| DBPSK mapping module | Scrambling module | Padding module | IFFT module | C-A-B structure module |

114130

S1 → MSS module
S2 →

P1

(B) P1 symbol generator

# FIG. 6

| L1-pre signaling information | L1-post signaling information |
|---|---|

| | |
|---|---|
| TYPE | (8 bits) |
| BWT_EXT | (1 bit) |
| S1 | (3 bit) |
| S2 | (4 bit) |
| L1_REPETITION_FLAG | (1 bit) |
| GUARD_INTERVAL | (3 bit) |
| PAPR | (4 bit) |
| L1_MOD | (4 bit) |
| L1_COD | (2 bit) |
| L1_FEC_TYPE | (2 bit) |
| L1_POST_SIZE | (18 bit) |
| L1_POST_INFO_SIZE | (18 bit) |
| PILOT_PATTERN | (4 bit) |
| TX_ID_AVAILABILITY | (8 bits) |
| CELL_ID | (16 bit) |
| NETWORK_ID | (16 bit) |
| SYSTEM_ID | (16 bit) |
| NUM_FRAMES | (8 bits) |
| NUM_DATA_SYMBOLS | (12 bit) |
| REGEN_FLAG | (3 bit) |
| L1_POST_EXTENSION | (1 bit) |
| NUM_RF | (3 bit) |
| CURRENT_RF_IDX | (3 bit) |
| RESERVED | (10 bit) |
| CRC_32 | (32 bit) |

# FIG. 7

| L1-pre signaling information | L1-post signaling information |
|---|---|

L1-padding

| Configurable | Dynamic | Extension | CRC | |
|---|---|---|---|---|

| | |
|---|---|
| SUB_SLICES_PER_FRAME | (15 bits) |
| NUM_PLP | (8 bits) |
| NUM_AUX | (4 bits) |
| AUX_CONFIG_RFU | (8 bits) |
| | |
| for i=0..NUM_RF-1 { | |
| RF_IDX | (3 bits) |
| FREQUENCY | (32 bits) |
| } | |
| | |
| IF S2 =='xxx1' { | |
| FEF_TYPE | (4 bits) |
| FEF_LENGTH | (22 bits) |
| FEF_INTERVAL | (8 bits) |
| } | |
| | |
| for i = 0..NUM_PLP-1 { | |
| PLP_ID | (8 bits) |
| PLP_TYPE | (3 bits) |
| PLP_PATLOAD_TYPE | (5 bits) |
| FR_FLAG | (1 bits) |
| FIRST_RF_IDX | (3 bits) |
| FIRST_FRAME_IDX | (8 bits) |
| PLP_GROUP_ID | (8 bits) |
| PLP_COD | (3 bits) |
| PLP_MOD | (3 bits) |
| PLP_ROTATION | (1 bits) |
| PLP_FEC_TYPE | (2 bits) |
| PLP_NUM_BLOCKS_MAX | (10 bits) |
| FRAME_INTERVAL | (8 bits) |
| TIME_IL_LENGTH | (8 bits) |
| TIME_IL_TYPE | (1 bits) |
| IN_BAND_FLAG | (1 bits) |
| RESERVED_1 | (16 bits) |
| } | |
| | |
| RESERVED_2 | (32 bits) |
| | |
| for i=0..NUM_AUX-1 { | |
| AUX_RFU | (32 bits) |
| } | |

# FIG. 8

| L1-pre signaling information | L1-post signaling information |
|---|---|

| Configurable | Dynamic | Extension | CRC | ⌐ |
|---|---|---|---|---|

L1-padding

| | |
|---|---|
| FRAME_IDX | (8 bits) |
| SUB_SLICE_INTERVAL | (22 bits) |
| TYPE_2_START | (22 bits) |
| L1_CHANGE_COUNTER | (8 bits) |
| START_RF_IDX | (3 bits) |
| RESERVED_1 | (8 bits) |
| | |
| for i = 0..NUM_PLP-1 { | |
| PLP_ID | (8 bits) |
| PLP_START | (22 bits) |
| PLP_NUM_BLOCKS | (10 bits) |
| RESERVED_2 | (8 bits) |
| } | |
| | |
| RESERVED_3 | (8 bits) |
| | |
| for i=0..NUM_AUX-1 { | |
| AUX_RFU | (48 bits) |
| } | |

## FIG. 9

| FEF interval | FEF length | FEF interval | FEF length | FEF interval | FEF 길이 |
|---|---|---|---|---|---|

Errestrial broadcast frame ··· Errestrial broadcast frame | FEF | Errestrial broadcast frame ··· Errestrial broadcast frame | FEF | Errestrial broadcast frame ··· Errestrial broadcast frame | FEF

A

B

C

$A + B + C = N_{T2}$

$A = B = C = FEF\ interval$

FEF for MIMO broadcast data

# FIG. 10

## FIG. 11

(A)

SISO
Base layer

MIMO
enhancement layer

(B)

SISO
Base layer

MIMO
enhancement layer

(C)

SISO.MISO carrier for base layer and
MIMO carrier for enhancement layer

FIG. 12

201010           201020          201030

| S1 | | St1 | First transmit antenna |

Input signal generator → MIMO encoder

| S2 | | St2 | Second transmit antenna |

201040

# FIG. 13

Transmit antenna 1   Transmit antenna 1

$h_{11}=1$

$h_{12}=1$

$h_{21}=1$

$h_{22}=1$

Transmit antenna 2   Transmit antenna 2

S1

S2

S1 + S2

S1 + S2

FIG. 14

205010
Signal of Stream 1

205020
Signal of Stream 2

205050
Combined Signal when spatial channel is fully correlated

205030
Signal of Tx 1

205040
Signal of Tx 2

EP 2 541 916 B1

FIG. 15

Combined Signal when spatial channels are fully correlated

Combined Signal when spatial channels are fully correlated

$(\alpha+i\bar{\alpha})S1-(\alpha\theta+i\bar{\alpha}\bar{\theta})S2$

$(\alpha-1)S1+(\alpha-1)S2$

EP 2 541 916 B1

# FIG. 16

Hamming distance of combined signal usgin Sub-set of GC

Hamming distance of combined signal usgin OPT1

—— $D_H = 1$ ········· $D_H = 2$ ------ $D_H = 3$ —— $D_H = 4$

# FIG. 17

Signal of Stream 1

Signal of Stream 2

Combined Signal when spatial channels are fully correlated

Signal of Tx 1

Signal of Tx 2

$D_H = 1$    $D_H = 2$

# FIG. 18

EP 2 541 916 B1

FIG. 19

69

FIG. 20

FIG. 21

## FIG. 22

P1 symbol

AP1 symbol

FIG. 23

# FIG. 24

# FIG. 25

25-A

| Field | Bits |
|---|---|
| S1 | 3 |
| S2 field 1 | 3 |
| S2 field 2 | 1 |

25-B

| Field | Bits |
|---|---|
| PIOT_PATTERN * | 4 |
| L1_PRE_SPREAD_LENGTH * | 3 |

# FIG. 26

| Field | Bits |
|---|---|
| TYPE | 8 |
| BWT_EXT | 1 |
| S1 | 3 |
| S2 | 4 |
| L1_REPETITION_FLAG | 3 |
| GUARD_INTERVAL | 3 |
| PAPR | 4 |
| L1_MOD | 4 |
| L1_COD | 2 |
| L1_FEC | 2 |
| L1_POST_SIZE | 18 |
| L1_POST_INFO_SIZE | 18 |
| PILOT_PATTERN | 4 |
| TX_ID_AVAILABILITY | 8 |
| CELL_ID | 16 |
| NETWORK_ID | 16 |
| NGH_SYSTEM_ID | 16 |
| NUM_NGH_FRAMES | 8 |
| NUM_T2_FRAMES | 8 |
| L1_POST_SPREAD_LENGH * | 12 |
| NUM_DATA_SYMBOLS | 12 |
| NUM_MISO_SYMBOLS | 12 |
| MIMO_SYMBOL_INTERVAL | 12 |
| MIMO_SYMBOL_LENGTH | 12 |
| REGEN_FLAG | 3 |
| L1_POST_EXTENSION | 1 |
| NUM_RF | 3 |
| CURRENT_RF_IDX | 3 |
| RESERVED | 10 |
| CRC_32 | 32 |

## FIG. 27

| Field | Bits |
|---|---|
| SUB_SLICES_PER_FRAME | 15 |
| NUM_PLP | 8 |
| NUM_AUX | 4 |
| AUX_CONFIG_RFU | 8 |
| | |
| for i = 0..NUM_RF-1 { | |
| RF_IDX | 3 |
| FREQEUNCY | 32 |
| } | |
| | |
| if S2 == 'xxx1' { | |
| FEF_TYPE | 4 |
| FEF_LENGTH | 22 |
| FEF_INTERVAL | 8 |
| NEXT_NGH_SUPERFRAME | 8 |
| } | |
| | |
| RESERVED_2 | 32 |
| | |
| for i = 0..NUM_AUX-1 { | |
| AUX_RFU | 32 |
| } | |
| for i = 0..NUM_PLP-1 { | |
| PLP_ID | 8 |
| PLP_TYPE | 3 |
| PLP_PAYLOAD_TYPE | 5 |
| PLP_PROFILE | 2 |
| FF_FLAG | 1 |
| FIRST_RF_IDX | 3 |
| FIRST_FRAME_IDX | 8 |
| PLP_GROUP_ID | 8 |
| PLP_COD | 3 |
| PLP_MOD | 3 |
| PLP_MIMO_TYPE | 2 |
| PLP_ROTATION | 1 |
| PLP_FEC_TYPE | 2 |
| PLP_NUM_BLOCKS_MAX | 10 |
| FRAME_INTERVAL | 8 |
| TIME_IL_LENGTH | 8 |
| TIME_IL_TYPE | 1 |
| IN_BAND_FLAG | 1 |
| RESERVED_1 | 16 |
| } | |

# FIG. 28

| Field | Bits |
|---|---|
| FRAME_IDX | 8 |
| SUB_SLICE_INTERVAL | 22 |
| TYPE_2_START | 22 |
| L1_CHANGE_COUNTER | 8 |
| START_RF_IDX | 3 |
| RESERVED_1 | 8 |
| | |
| if S2 == 'xxx1' { | |
| NEXT_NGH_FRAME | 8 |
| } | |
| | |
| for i = 0..NUM_PLP-1 { | |
| PLP_ID | 8 |
| PLP_START | 22 |
| PLP_NUM_BLOCKS | 10 |
| RESERVED_2 | 8 |
| } | |
| | |
| RESERVED_3 | 8 |
| | |
| for i = 0..NUM_AUX-1 { | |
| AUX_RFU | 48 |
| } | |

FIG. 29

FIG. 30

| PLP-0 | Input interface module | Input stream sync module | Delay compensator | Null packet canceller | CRC encoder | BB header insertion unit |
|---|---|---|---|---|---|---|

| PLP-1 | Input interface module | Input stream sync module | Delay compensator | Null packet canceller | CRC encoder | BB header insertion unit |
|---|---|---|---|---|---|---|

|  | 602100 | 602200 | 602300 | 602400 | 602500 | 602600 |
|---|---|---|---|---|---|---|
| PLP-p | Input interface module | Input stream sync module | Delay compensator | Null packet canceller | CRC encoder | BB header insertion unit |

# FIG. 31

FIG. 32

EP 2 541 916 B1

FIG. 33

EP 2 541 916 B1

## FIG. 34

## FIG. 35

FIG. 36

# FIG. 37

611100

First pair-wise cell demapper

611110

First pair-wise frequency deinterleaver

611120

| Extracting common PLP cells | Extracting data PLP cells |
| Extracting L1 cells | Sub slice processor |

→ SRx_0
→ SRx_k
→ SRx_m
→ SRx_pre
→ SRx_post

611200

Second pair-wise cell demappre

611210

Second pair-wise frequency deinterleaver

611220

| Extracting common PLP cells | Extracting data PLP cells |
| Extracting L1 cells | Sub slice processor |

→ SRx_0+1
→ SRx_k+1
→ SRx_m+1
→ SRx_pre+1
→ SRx_post+1

## FIG. 38

## FIG. 39

# FIG. 40

```
        616100          616200          616300          616400
          |               |               |               |

BICM  →  ┌────────┐  →  ┌────────┐  →  ┌────────┐  →  ┌────────┐  →  TS or
decoder  │   BB   │     │Padding │     │ CRC-8  │     │BB frame│       GS
         │descram-│     │removal │     │decoder │     │proces- │
         │ bler   │     │module  │     │        │     │ sor    │
         └────────┘     └────────┘     └────────┘     └────────┘
```

FIG. 41

## FIG. 42

# FIG. 43

EP 2 541 916 B1

# FIG. 44

FIG. 45

EP 2 541 916 B1

# FIG. 46

**622100**

PLPk (MISO) → FEC encoder (LDPC/BCH) → Bit interleaver → First demultiplexer → Constellation mapper → Cell interleaver → Time interleaver → STx_k

**622200**

PLPm (MIMO) → FEC encoder (LDPC/BCH) → Bit interleaver → Second demultiplexer → First constellation mapper (622210-1) / Second constellation mapper (622210-2) → MIMO encoder (622220) → First cell interleaver → First time interleaver → STx_m ; Second cell interleaver → Second time interleaver → STx_m+1

**622300**

L1-pre signaling information → FEC encoder (LDPC/BCH) → Constellation mapper → Cell interleaver → 타임 interleaver → STx_pre

L1-post signaling information → FEC encoder (LDPC/BCH) → Bit interleaver → Demultiplexer → Constellation mapper → Cell interleaver → 타임 interleaver → STx_post

FIG. 47

# FIG. 48

EP 2 541 916 B1

## FIG. 49

FIG. 50

EP 2 541 916 B1

EP 2 541 916 B1

## FIG. 51

FIG. 52

# FIG. 53

# FIG. 54

# FIG. 55

(a)

| | 256-QAM (Type 1-1) | | | | | | | | |
|---|---|---|---|---|---|---|---|---|---|
| Input bit-number, di mod Nsubstreams | 0 | 1 | 2 | 3 | 4 | 5 | 6 | 7 | |
| Output bit-number, e | 5 | 3 | 2 | 7 | 1 | 6 | 4 | 0 | 1/4 |
| Reliability | C | B | B | D | A | D | C | A | |

(b)

| | 256-QAM (Type 1-2) | | | | | | | | |
|---|---|---|---|---|---|---|---|---|---|
| Input bit-number, di mod Nsubstreams | 0 | 1 | 2 | 3 | 4 | 5 | 6 | 7 | |
| Output bit-number, e | 5 | 1 | 0 | 7 | 3 | 6 | 4 | 2 | 2/5, 3/5 |
| Reliability | C | A | A | D | B | D | C | B | |

(c)

| | 256-QAM (Type 1-3) | | | | | | | | |
|---|---|---|---|---|---|---|---|---|---|
| Input bit-number, di mod Nsubstreams | 0 | 1 | 2 | 3 | 4 | 5 | 6 | 7 | |
| Output bit-number, e | 7 | 3 | 1 | 6 | 5 | 2 | 4 | 0 | 1/2 |
| Reliability | D | B | A | D | C | B | C | A | |

(d)

| | 256-QAM (Type 1-4) | | | | | | | | |
|---|---|---|---|---|---|---|---|---|---|
| Input bit-number, di mod Nsubstreams | 0 | 1 | 2 | 3 | 4 | 5 | 6 | 7 | |
| Output bit-number, e | 3 | 2 | 1 | 5 | 7 | 6 | 4 | 0 | 4/5 |
| Reliability | B | B | A | C | D | D | C | A | |

(e)

| | 256-QAM (Type 1-5) | | | | | | | | |
|---|---|---|---|---|---|---|---|---|---|
| Input bit-number, di mod Nsubstreams | 0 | 1 | 2 | 3 | 4 | 5 | 6 | 7 | |
| Output bit-number, e | 7 | 3 | 1 | 5 | 2 | 6 | 4 | 0 | 1/3, 2/3, 3/4, 5/6 |
| Reliability | D | B | A | C | B | D | C | A | |

EP 2 541 916 B1

## FIG. 56

| 256-QAM (Type 1-1) | 256-QAM (Type 1-2) | 256-QAM (Type 1-3) | 256-QAM (Type 1-4) | 256-QAM (Type 1-5) |
|---|---|---|---|---|
| v0 maps to b5.0 | v0 maps to b5.0 | v0 maps to b7.0 | v0 maps to b3.0 | v0 maps to b7.0 |
| v1 maps to b3.0 | v1 maps to b1.0 | v1 maps to b3.0 | v1 maps to b2.0 | v1 maps to b3.0 |
| v2 maps to b2.0 | v2 maps to b0.0 | v2 maps to b1.0 | v2 maps to b1.0 | v2 maps to b1.0 |
| v3 maps to b7.0 | v3 maps to b7.0 | v3 maps to b6.0 | v3 maps to b5.0 | v3 maps to b5.0 |
| v4 maps to b1.0 | v4 maps to b3.0 | v4 maps to b5.0 | v4 maps to b7.0 | v4 maps to b2.0 |
| v5 maps to b6.0 | v5 maps to b6.0 | v5 maps to b2.0 | v5 maps to b6.0 | v5 maps to b6.0 |
| v6 maps to b4.0 | v6 maps to b4.0 | v6 maps to b4.0 | v6 maps to b4.0 | v6 maps to b4.0 |
| v7 maps to b0.0 | v7 maps to b2.0 | v7 maps to b0.0 | v7 maps to b0.0 | v7 maps to b0.0 |

FIG. 57

Tarbet Code rate(s)

256-QAM (Type 2-1)

(a)

| 0 | 1 | 2 | 3 | 4 | 5 | 6 | 7 |
|---|---|---|---|---|---|---|---|
| 5 | 1 | 3 | 7 | 0 | 6 | 4 | 2 |
| C | A | B | D | A | D | C | A |

(1/4, 1/3), 2/5, 3/5

256-QAM (Type 2-2)

(b)

| 0 | 1 | 2 | 3 | 4 | 5 | 6 | 7 |
|---|---|---|---|---|---|---|---|
| 7 | 3 | 1 | 6 | 2 | 5 | 4 | 0 |
| D | B | A | D | B | C | C | A |

1,2, (2/3, 4/5)

256-QAM (Type 2-3)

(c)

| 0 | 1 | 2 | 3 | 4 | 5 | 6 | 7 |
|---|---|---|---|---|---|---|---|
| 7 | 3 | 1 | 5 | 2 | 6 | 4 | 0 |
| D | B | A | C | B | D | C | A |

(1/4, 1/3, 2/3, 4/5), 3/4, 5/6

FIG. 58

| 256-QAM (Type 2-1) | 256-QAM (Type 2-2) | 256-QAM (Type 2-3) |
|---|---|---|
| v0 maps to b5.0 | v0 maps to b7.0 | v0 maps to b7.0 |
| v1 maps to b1.0 | v1 maps to b3.0 | v1 maps to b3.0 |
| v2 maps to b3.0 | v2 maps to b1.0 | v2 maps to b1.0 |
| v3 maps to b7.0 | v3 maps to b6.0 | v3 maps to b5.0 |
| v4 maps to b0.0 | v4 maps to b2.0 | v4 maps to b2.0 |
| v5 maps to b6.0 | v5 maps to b5.0 | v5 maps to b6.0 |
| v6 maps to b4.0 | v6 maps to b4.0 | v6 maps to b4.0 |
| v7 maps to b2.0 | v7 maps to b0.0 | v7 maps to b0.0 |

# FIG. 59

EP 2 541 916 B1

Tarbet Code rate(s)

(a)

| 256-QAM (Type 3-1) | | | | | | | |
|---|---|---|---|---|---|---|---|
| 0 | 1 | 2 | 3 | 4 | 5 | 6 | 7 |
| 5 | 1 | 0 | 7 | 3 | 6 | 4 | 2 |
| C | A | A | D | B | D | C | B |

2/5, 3/5

(b)

| 256-QAM (Type 3-2) | | | | | | | |
|---|---|---|---|---|---|---|---|
| 0 | 1 | 2 | 3 | 4 | 5 | 6 | 7 |
| 7 | 3 | 1 | 6 | 5 | 2 | 4 | 0 |
| D | B | A | D | C | B | C | A |

1,2

(c)

| 256-QAM (Type 3-3) | | | | | | | |
|---|---|---|---|---|---|---|---|
| 0 | 1 | 2 | 3 | 4 | 5 | 6 | 7 |
| 7 | 3 | 1 | 5 | 2 | 6 | 4 | 0 |
| D | B | A | C | B | D | C | A |

1/4, 1/3, 2/3, 4/5, 3/4, 5/6

# FIG. 60

EP 2 541 916 B1

(a)

| 64-QAM (Type 2-1) | | | | | | | | | | | |
|---|---|---|---|---|---|---|---|---|---|---|---|
| 0 | 1 | 2 | 3 | 4 | 5 | 6 | 7 | 8 | 9 | 10 | 11 |
| 5 | 6 | 1 | 7 | 9 | 11 | 3 | 8 | 10 | 4 | 2 | 0 |
| C | A | A | A | B | C | B | B | C | C | B | A |

Target Code rate(s): 2/5, 3/5

(b)

| 64-QAM (Type 2-1) | | | | | | | | | | | |
|---|---|---|---|---|---|---|---|---|---|---|---|
| 0 | 1 | 2 | 3 | 4 | 5 | 6 | 7 | 8 | 9 | 10 | 11 |
| 5 | 11 | 7 | 1 | 8 | 10 | 4 | 9 | 6 | 2 | 3 | 0 |
| C | C | A | A | B | C | C | B | A | B | B | A |

1,2

(c)

| 64-QAM (Type 2-1) | | | | | | | | | | | |
|---|---|---|---|---|---|---|---|---|---|---|---|
| 0 | 1 | 2 | 3 | 4 | 5 | 6 | 7 | 8 | 9 | 10 | 11 |
| 11 | 7 | 3 | 10 | 6 | 2 | 9 | 5 | 1 | 8 | 4 | 0 |
| C | A | B | C | A | B | B | C | A | B | C | A |

1/4, 1/3, 2/3, 4/5, 3/4, 5/6

# FIG. 61

Tarbet Code rate(s)

(a)

| 16-QAM (Type 2-2) | | | | | | | |
|---|---|---|---|---|---|---|---|
| 0 | 1 | 2 | 3 | 4 | 5 | 6 | 7 |
| 3 | 1 | 5 | 7 | 6 | 4 | 2 | 0 |
| B | A | A | B | B | A | B | A |

1/2

(b)

| 16-QAM (Type 2-3) | | | | | | | |
|---|---|---|---|---|---|---|---|
| 0 | 1 | 2 | 3 | 4 | 5 | 6 | 7 |
| 7 | 1 | 4 | 2 | 5 | 3 | 6 | 0 |
| B | A | A | B | A | B | B | A |

1/4, 1/3, 2/5, 3/5, 2/3, 4/5, 3/4, 5/6

## FIG. 62

636400    636500    636600

636200

636300

1k mode pair-wise frequency interleaver — 636100

636500    636600    636400    636200    636300

## FIG. 63

637200

1k mode pair-wise frequency deinterleaver — 637100

637200

EP 2 541 916 B1

## FIG. 64

638200

638100    638300                              638400

| P1 | AP1 | P2 | Common PLP | | |
|----|-----|----|-----------|--|--|

L1-signaling(next frame)    638600

Type 1 MISO PLP data    Type 2 MISO PLP data, auxiliary stream and dummy data    638700

Type 1 MIMO PLP data    Type 2 MIMO PLP data, auxiliary stream and dummy data    638800

638500  638710    638810        638720      638820

MISO processing data

MIMO processing data

EP 2 541 916 B1

## FIG. 65

## FIG. 66

```
                    ┌──────────┐
                    (   Start   )
                    └──────────┘
                          │
                          ▼
  ┌─────────────────────────────────────────────┐
  │ MISO Decoding in Broadcasting Signals and    │ ── S72010
  │ Outputting the Signaling Information in       │
  │ the Broadcast Signals                         │
  └─────────────────────────────────────────────┘
                          │
                          ▼
  ┌─────────────────────────────────────────────┐
  │ OFDM Modulating in PLP Data in the Broadcast  │ ── S72020
  │ Signals by using Signaling Information         │
  └─────────────────────────────────────────────┘
                          │
                          ▼
  ┌─────────────────────────────────────────────┐
  │ MIMO/MISO Decoding in PLP Data                │ ── S72030
  │ by Using Signaling Information.                │
  └─────────────────────────────────────────────┘
                          │
                          ▼
  ┌─────────────────────────────────────────────┐
  │ Cell-mapping PLP Data and Frame-parsing       │ ── S72040
  │ by Using Signaling Information.                │
  └─────────────────────────────────────────────┘
                          │
                          ▼
  ┌─────────────────────────────────────────────┐
  │ Bit-interleaving and FEC Decoding PLP Data    │ ── S72050
  └─────────────────────────────────────────────┘
                          │
                          ▼
                    ┌──────────┐
                    (    End    )
                    └──────────┘
```

**EP 2 541 916 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009093809 A